# EUROPEAN PATENT SPECIFICATION

(11) **EP 2 088 521 B1**
(45) Date of publication and mention of the grant of the patent: **15.12.2010**
(21) Application number: 08002479.7
(22) Date of filing: 11.02.2008
(51) Int. Cl.: G06F 17/50

(54) **Method for verifying**
Überprüfungsverfahren
Procédé de vérification

(43) Date of publication of application: 12.08.2009
(73) Proprietor: Onespin Solutions GmbH, 80339 München (DE)
(72) Inventor: Beyer, Sven, 80805 München (DE); Schönherr, Jens, 01097 Dresden (DE); Bormann, Jörg, 82049 Pullach (DE)
(74) Representative: Hofmann, Harald

(56) References cited:
- US-A1- 2007 226 663
- NOAH BAMFORD ET AL: "Challenges in System on Chip Verification" MICROPROCESSOR TEST AND VERIFICATION, 2006. MTV '06. SEVENTH INTE RNATIONAL WORKSHOP ON, IEEE, PI, 1 December 2006 (2006-12-01), pages 52-60, XP031086487 ISBN: 978-0-7695-2839-7
- BOUSSEBHA D ET AL: "Temporal verification of behavioral descriptions in VHDL" PROCEEDINGS OF THE EUROPEAN DESIGN AUTOMATION CONFERENCE (EURO-DAC). HAMBURG, SEPT. 7 - 10, 1992; [PROCEEDINGS OF THE EUROPEAN DESIGN AUTOMATION CONFERENCE (EURO-DAC)], LOS ALAMITOS, IEEE COMP. SOC. PRESS, US, vol. CONF. 1, 7 September 1992 (1992-09-07), pages 692-697, XP010028690 ISBN: 978-0-8186-2780-4

## Description

The present invention relates to verification of digital circuits.

Verification of digital circuits is used to verify that a digital circuit provides the desired or required functions and properties. For example, the design of a digital circuit is extensively verified prior to production of the digital circuit in order to avoid unwanted and costly malfunction of the manufactured digital circuit.

### Conventional Verification Approaches

Conventional methods for verification of digital circuits comprise simulation. In simulation based verification one tries to simulate the behaviour of the digital circuit in order to determine any possible state of the circuit. However, with large and mediums sized digital circuits, it is not possible to simulate all possible states of the digital circuit.

In simulation based verification, the design under verification is treated largely as a black box, i.e. no account is made to the implementation of the circuit. Verification engineers consider this a crucial aspect for the quality of the verification: since the verification code is derived only from the specification, it cannot be compromised by the potentially buggy RTL. Assertions encoded by the designers in the RTL may be verified with simulation as well. However, it lies in the very nature of simulation based verification that an exhaustive simulation is not feasible. Hence, a simulation test bench where all tests hold is only an indication that one was not *lucky* enough to find a bug in the RTL, not that the verification is actually finished. In summary, finding bugs with simulation is to some extent a matter of luck. What is more, there is no clean termination criterion for the verification. Instead, termination criteria are typically derived from a manually developed verification plan. In other words, the overall quality of the verification depends on the quality of the verification plan and one can never be sure that there is no more bug in the RTL. The role of the verification plan is discussed in more detail in the Section called *Verification Plan.*

With assertion based verification (ABV), assertions can be formally verified. There are two ways of verifying assertions formally, a bounded verification from reset and an exhaustive verification. A bounded verification from reset examines the assertion on all possible traces of a bounded length from reset. It is typically possible to carry out such a bounded check without a deeper knowledge of the design; on the other hand, if an assertion is not violated on a bounded trace from reset, this does not mean that the assertion really holds exhaustively. In order to actually perform an exhaustive verification and thus to be sure that an assertion always holds, the verification engineer typically needs to acquire some knowledge of the design in order to overcome reachability problems (see the Section called *Reachability* in Chapter 4 for a detailed discussion of reachability problems). In summary, even for the exhaustive verification of a single assertion, a partially white box approach needs to be taken, i.e. an approach that takes the implementation into account. What is more, there is no clear termination criterion in common assertion based verification. Hence, the most pressing question for assertion based verification remains whether the verification engineer has written enough assertions. This makes ABV with full proof of all assertions sill a matter of *luck:* you need to happen to write the right assertion that is actually able to observe a particular bug. In addition, assertions are typically used to examine specific implementation aspects, for example, that some signal is one-hot encoded. In general, it is not the goal of assertions to capture the specification of the design.

### Verification Plan

In conventional verification approaches, a verification plan is a list of verification goals. It is used for two different purposes: as a means of structuring and planning the overall verification effort and in order to provide a termination criterion. Therefore, the quality of the overall verification actually depends on the quality of the verification plan that was developed at the beginning of the verification. This makes the development of the verification plan a crucial part of the overall verification. In addition, a verification plan is typically quite detailed since it needs to list all the verification goals and scenarios that are supposed to be covered.

### Summary of the invention

The present invention provides a method for verifying at least one aspects, such as a behavioural aspect of a digital circuit, the method comprising: providing a set of operations to be performed by the digital circuit, each one of the set of operations having at least one functional element; identifying a first subset of a plurality of the at least one functional clement; describing in a description the plurality of the at least one functional element of the identified first subset in terms of properties, each one of the properties having an assumption component and a proof component; formally verifying each one of the properties; arranging the plurality of the at least one functional element of the identified first subset to be proven for the digital circuit in an arrangement with temporal relations satisfying at least said description; analysing completeness of the arrangement of the plurality of the at least one functional element to verify that the at least one aspects of the digital circuit are completely verified.

The at least one functional element is a component or the smallest entity of one or more of the properties. A functional element describes a small facet of the circuit behavior together with the conditions under which this small facet of circuit behavior will be executed in the circuit. As a non-limiting example a functional element could be understood to represent a signal together with a related portion of the behaviour of the circuit or in other words might represent a signal and the role or function of that signal in the circuit, in particular, but not exclusively as regards temporal relations. A plurality of functional elements, which may be of different kinds or types, may form a property and may describe an operation of the digital circuit. For example, a functional element may describe a control, such as a central control or a full control of the digital circuit. A functional element may also describe at least one of the group consisting of inputs, outputs, internal signals, registers and visible registers. A functional element may also describe a data path, a data path segment or branching of the data path. The data path may be described structurally or in terms of temporal relations.

The at least one aspect of the digital circuit may be a portion or a section of the digital circuit, or may relate to certain functions of the digital circuit. For example, the aspect may relate to core operations or to central controls of the certain operation of the digital circuits. However, the aspect may also contain other objects of the digital circuit.

At least one of the set of operations may have a temporal structure. In such a preferred embodiment the temporal relation of functional elements could comply with, match or correspond to the one of the set of operations.

At least one operation of the set of operations may be described in terms of properties, wherein each property has an assumption component and a proof component. Each of the operations may combine a plurality of the at least one functional elements.

The properties may further describe the temporal or timely relation of a plurality of operations. The properties may also describe the temporal or timely relation of a plurality of functional elements. In other words it is possible to describe the set of operations by properties that are a suitable collection of functional elements. A suitable collection of functional elements can be found by considering in the specification of the digital circuit operations and the timely relationship thereof and in an implememntation functional elements and their timely relationship. As non-limiting examples one could either draft conditions as regards the functional elements and their timely relation while creating the properties or use the proof component of the properties to ascertain that the functional elements and their timely relation in the properties match the operations.

The method of the invention may further comprise showing that at least one of the set of operations complies with at least one of the properties.

Analysing completeness of the arrangement may comprise determining whether the arrangement forms a model of the digital circuit. The model of the digital circuit may be a partial model describing only a portion or an aspect of the digital circuit. For example, the partial model may describe the behaviour, such as the timely behaviour or the structure of the digital circuit.

Analysing completeness of the arrangement may also comprise determining whether the arrangement, the set of operations and/or the properties determine(s) a unique value of each output for every input stimulus that initiates a sequence of properties. It is possible to check whether the timely relation of the properties corresponds or matches the timely relation of the set of operations. In a preferred embodiment the set of operations is described by properties regrouping the functional elements, thus the timely relation of the functional elements can correspond to the one of the operations.

A completeness checker may be used for the analysis of completeness. An example of a completeness checker is described in detail in the EP1764715 and US 2007/226663.

Noah Bamford et al: "Challenges in System on Chip Verification" ISBN: 978-0-7695-2839-7. MTV '06, 1 December 2006 , pages 52-60 presents a verification strategy for System on a Chip.

The method according to the invention may comprise subsequent to analysing completeness of the arrangement:
identifying a second subset of the plurality of the at least one functional elements; modifying the properties based on the second subset of the plurality of the at least one functional element; formally verifying each one of the modified properties; modifying the arrangement based on the second subset of the plurality of the at least one functional element;
analysing completeness of the modified arrangement to verify that further aspects of the digital circuit are completely verified. In this way, the further aspects can be additionally verified in order to increase the verified aspects of the digital circuit.

The above step may be repeated in one or more iterations to identify further subsets of the plurality of the at least one functional elements that will lead step by step (iteration by iteration) to a more complete verification of the hole digital circuit.

The present invention further comprises a method comprising: providing a description of the digital circuit describing functionalities of the digital circuit; identifying an aspect of the digital circuit as a set of operations and their timely relation in said description, for example a set of operations for performing a core portion of the functionalities;
verifying the aspect according to the method cited above.

The method may further comprise: determining a further set of operations; describing the further set of operations in terms of further or extended properties; formally verifying the extended properties; modifying the arrangement by adding the set of further operations to the arrangement with temporal relations satisfying at least said extended description; analysing completeness of the modified arrangement to determine whether the digital circuit is completely verified.

### Description of the Figures

The following detailed description of a purely illustrative embodiment is given with reference to the accompanying drawing, wherein:

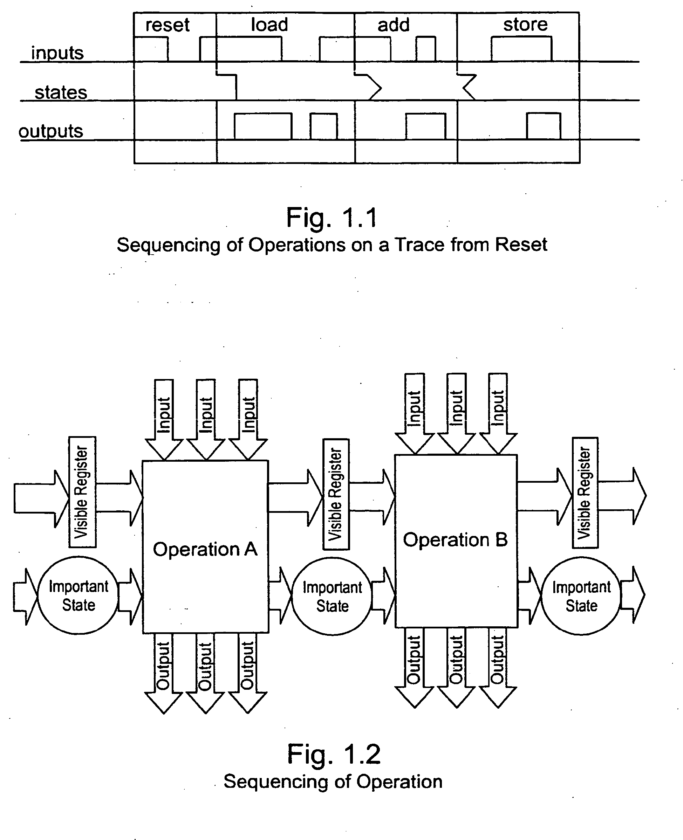

- Fig 1.1: shows the sequencing of operations on a trace from reset;
- Fig. 1.2.: shows the sequencing of operations

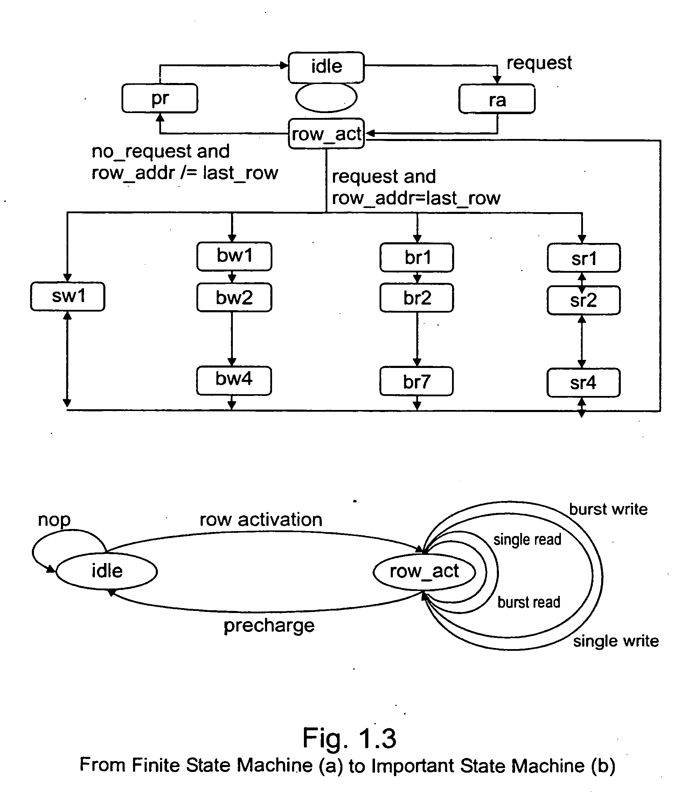

- Fig. 1.3.: shows transitions from finite state machine (a) to important state machine (b);

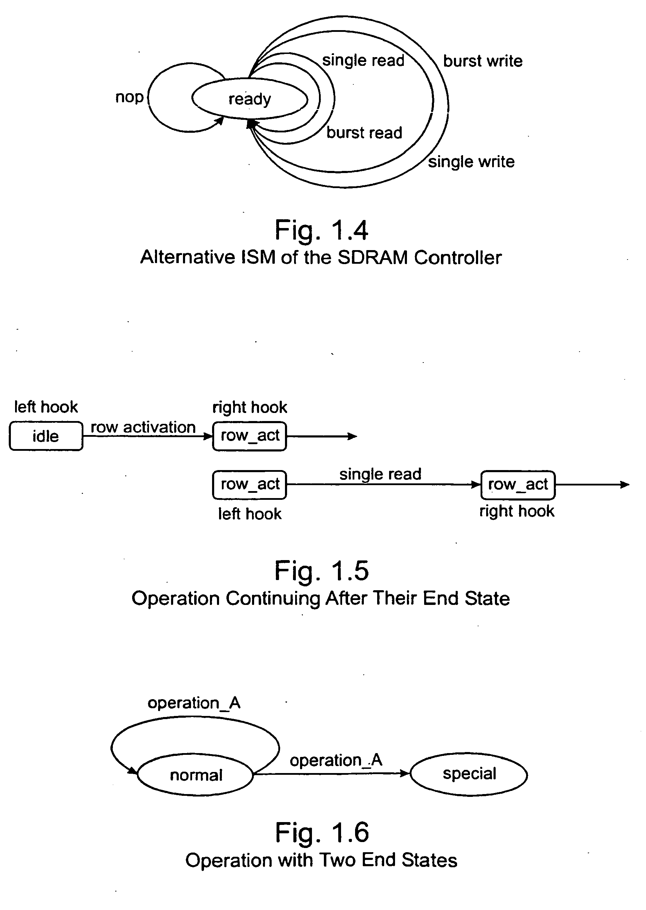

- Fig. 1.4.: shows an alternative ISM of the SDRAM controller;
- Fig. 1.5.: shows operations continuing after their end state;
- Fig. 1.6.: shows operations with two end states;

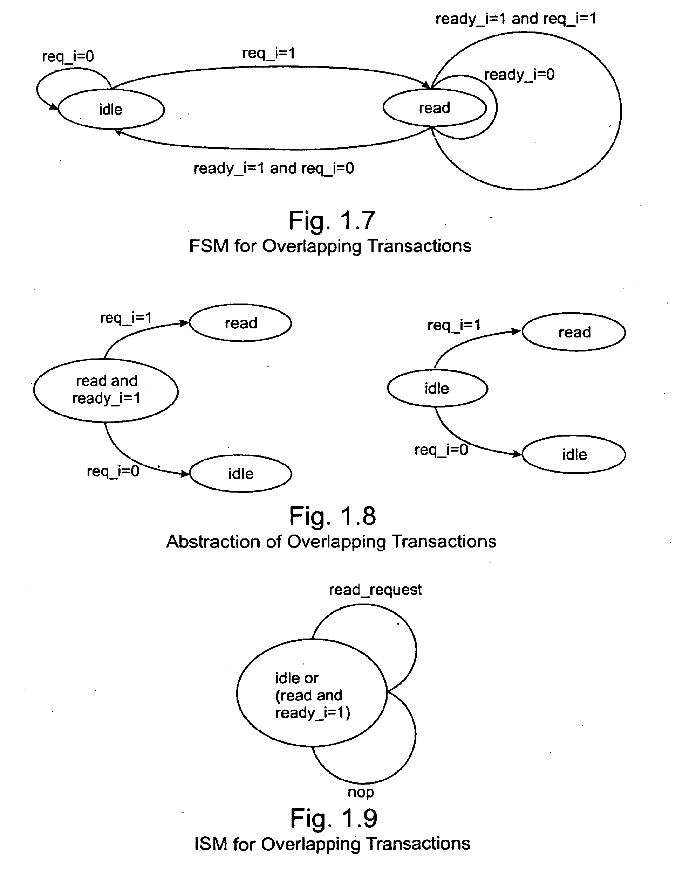

- Fig. 1.7.: shows FSM for overlapping transactions;
- Fig. 1.8.: shows an abstraction of overlapping transactions;
- Fig. 1.9.: shows ISM for overlapping transactions;
- Fig. 1.10.: shows overlapping operations in pipelines;
- Fig. 1.11.: shows the verification of operations in pipelines;
- Fig. 1.12.: shows ISM for a pipelined implementation;
- Fig. 1.13.: shows an operation property in ITL;
- Fig. 1.14.: shows sequencing of operations from the ISM;
- Fig. 1.15.: shows splitting of a single operation (a) into different operation properties (b);
- Fig. 1.16.: shows arbitrary waiting periods with a single operation (a) or split operations (b);
- Fig. 3.1.: shows an operation property after phase one;
- Fig. 3.2.: shows master and slave interfaces of a design;
- Fig. 3.3.: shows a reset sequence and constraints in the reset property;
- Fig. 3.4.: shows an initialization sequence in an FSM graph;
- Fig. 3.5.: shows an example illustrating a part of the FSM that implements an operation; the start and the end state is idle while the intermediate states are req_phasel and req_phase2;
- Fig. 3.6.: shows an example illustrating a part of the FSM that implements an operation; the operation has two triggers, one at the beginning (start_op = 1) and another trigger (wd < 10) one cycle later;
- Fig. 3.7.: shows a register depending on other registers as DAG;
- Fig. 3.8.: shows a register depending on other registers in a cluster;
- Fig. 3.9.: shows a simple pipeline structure without a feedback loop;

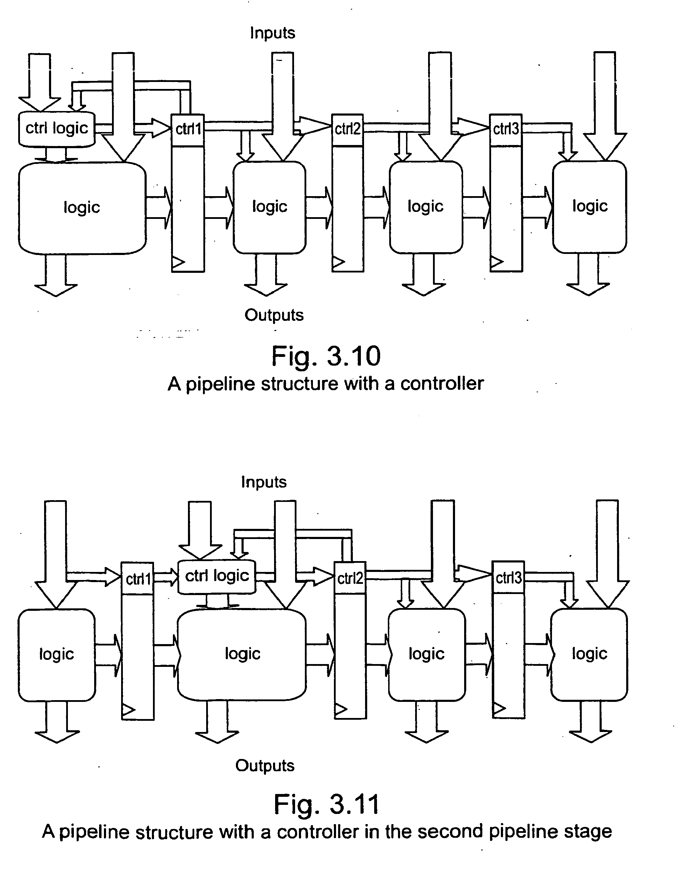

- Fig. 3.10.: shows a pipeline structure with a controller;
- Fig. 3.11.: shows a pipeline structure with a controller in the second pipeline stage;

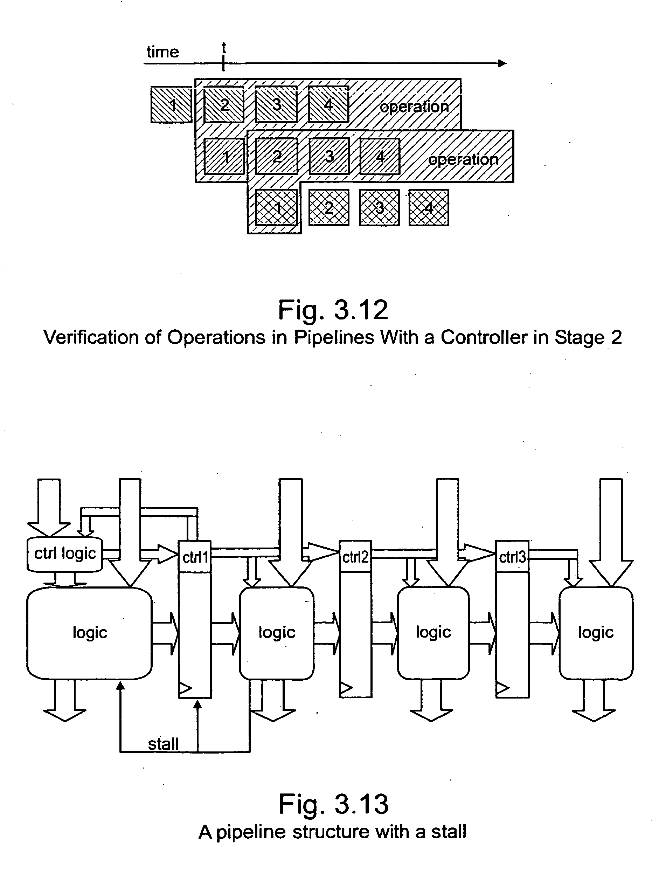

- Fig. 3.12.: shows verification of operations in pipelines with a controller in stage 2;
- Fig. 3.13.: shows a pipeline structure with a stall;

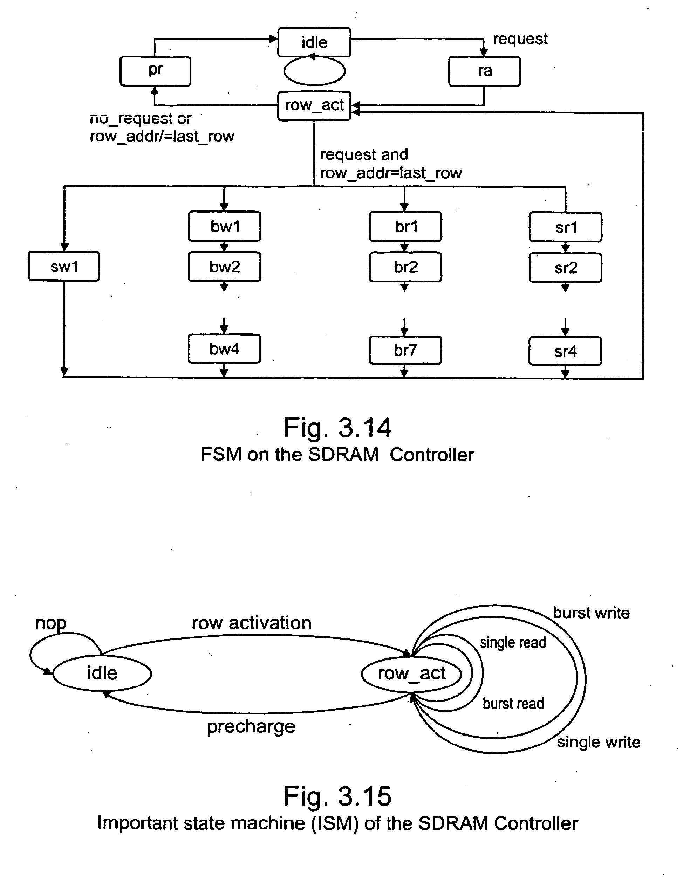

- Fig. 3.14.: shows FSM of the SDRAM Controller;
- Fig. 3.15.: shows an important state machine (ISM) of the SDRAM Controller;

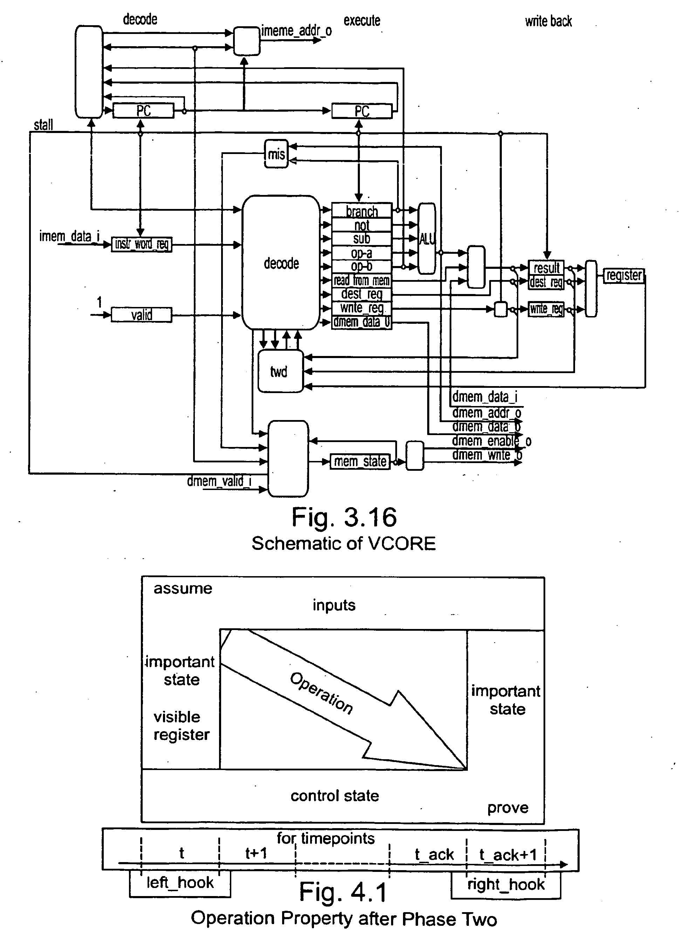

- Fig. 3.16.: shows a schematic of VCORE;
- Fig. 4.1.: shows an operation property after phase two;

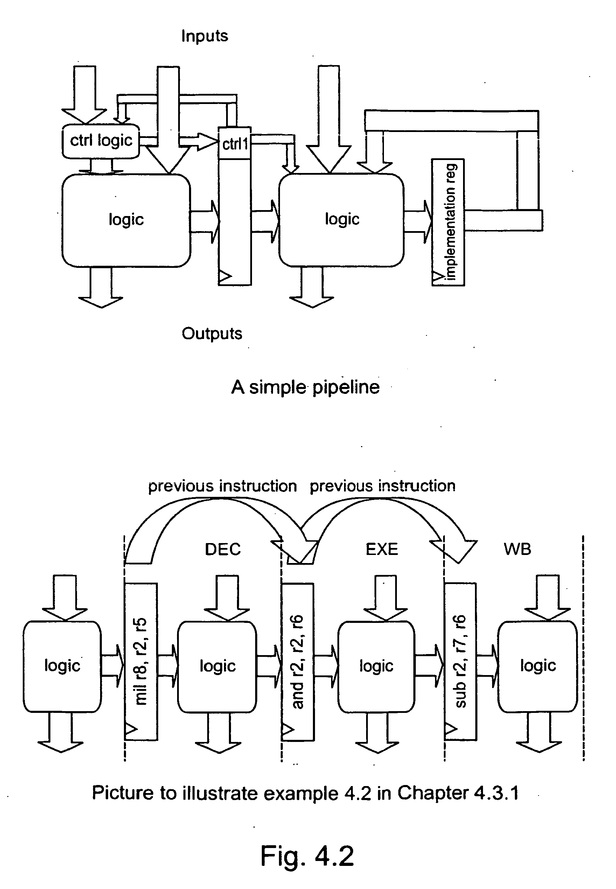

- Fig. 4.2.: shows a simple pipeline;
- Fig. 4.2a: illustrates example 4.2 in Chapter 4.3.1;

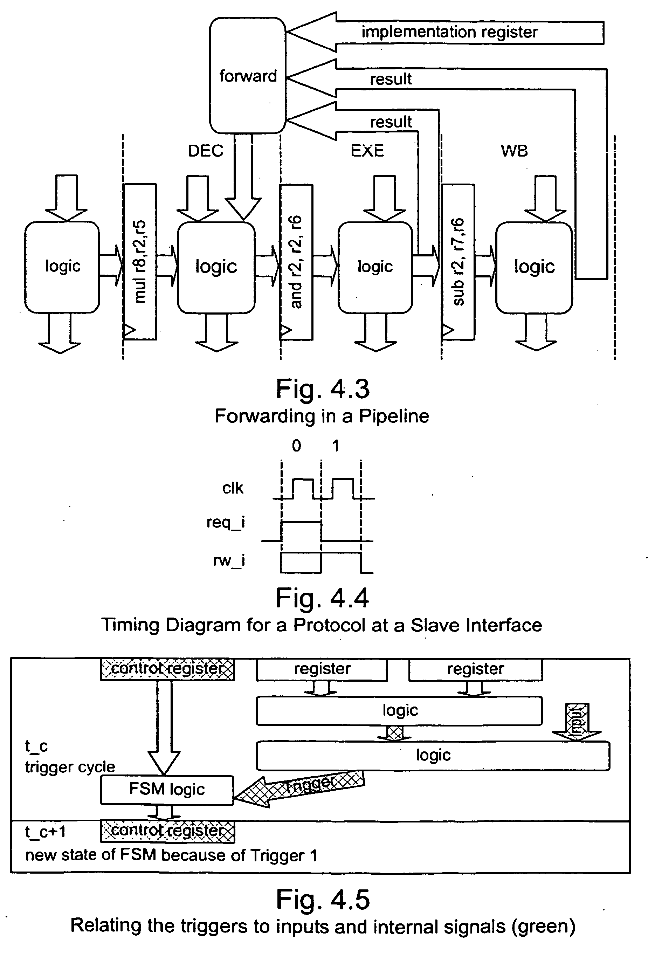

- Fig. 4.3.: shows forwarding in a pipeline;
- Fig. 4.4.: shows a timing diagram for a protocol at a slave interface;
- Fig. 4.5.: shows relating the trigger to inputs and internal signals;

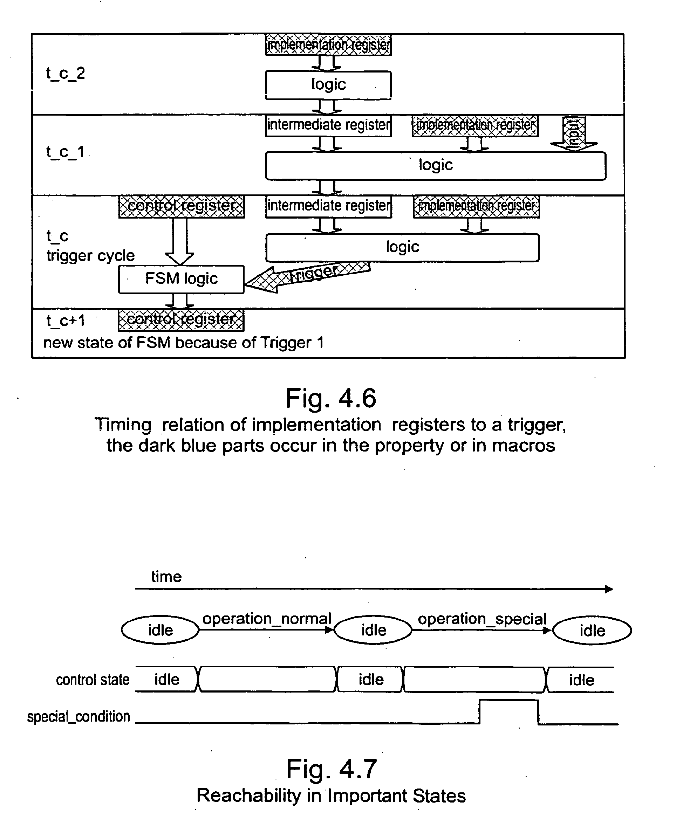

- Fig. 4.6.: shows a timing relation of implementation registers to a trigger, the dark parts occur in the property or in macros;
- Fig. 4.7.: shows the reachability in important states;

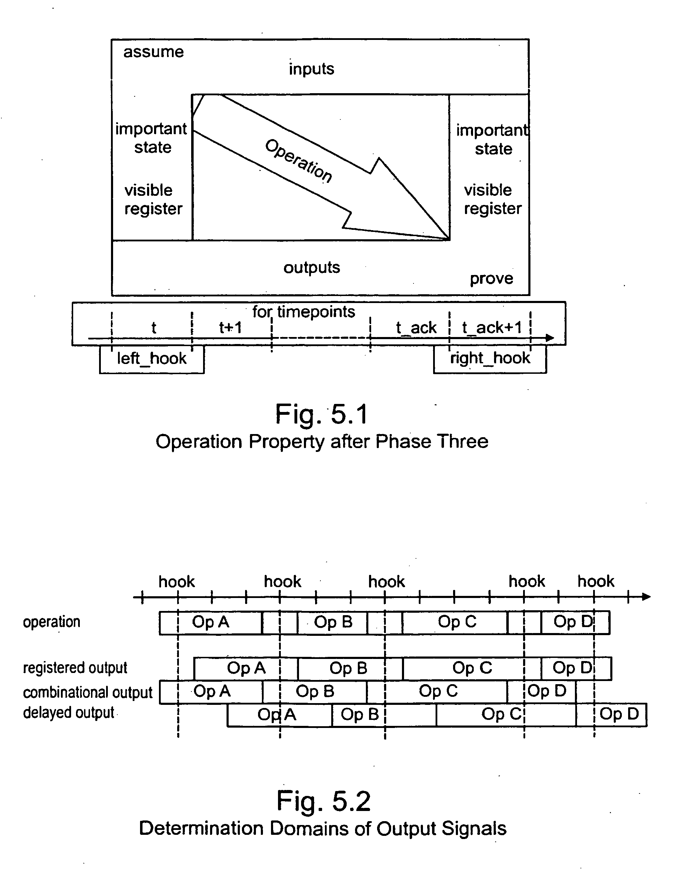

- Fig. 5.1.: shows an operation property after phase three;
- Fig. 5.2.: shows determination domains of output signals;

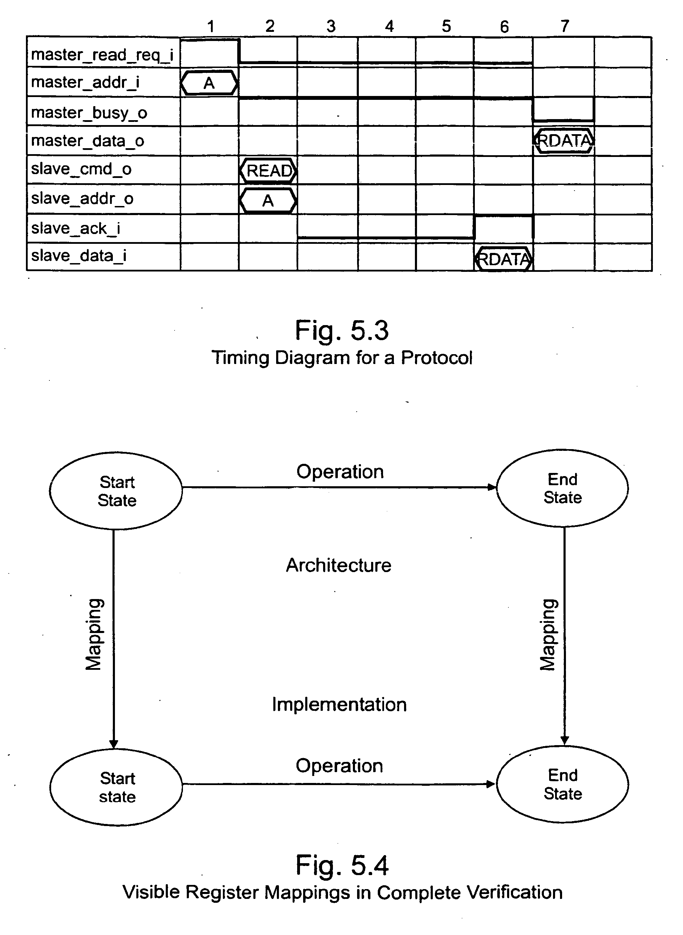

- Fig. 5.3.: shows a timing diagram for a protocol;
- Fig. 5.4.: shows visible register mappings in complete verification;

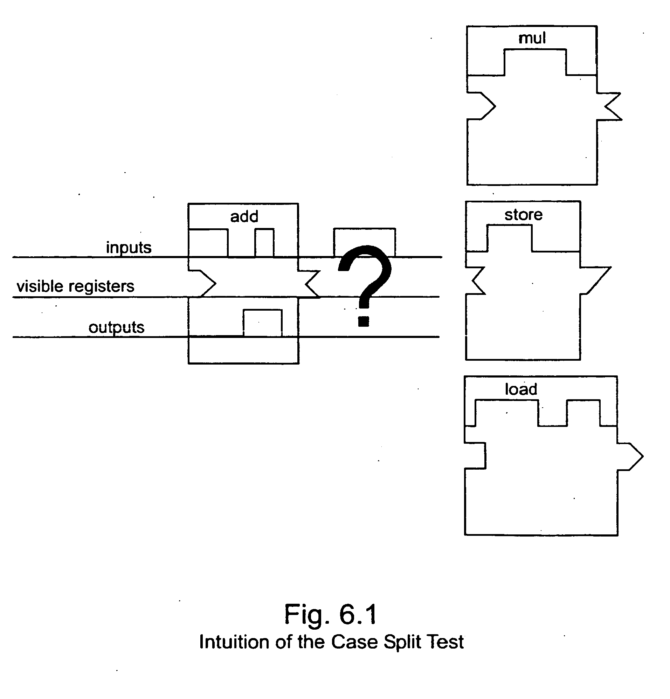

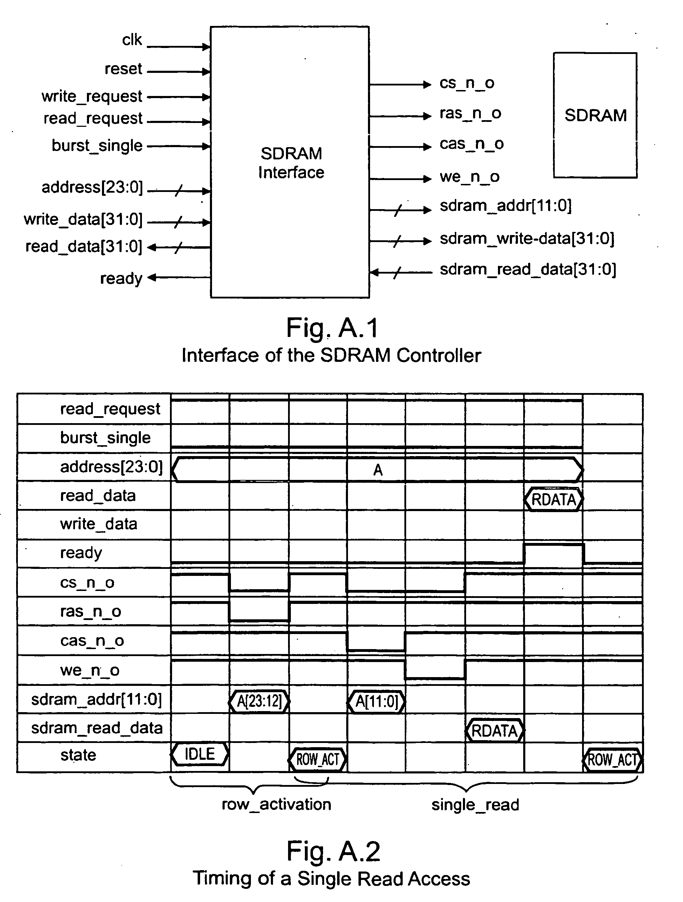

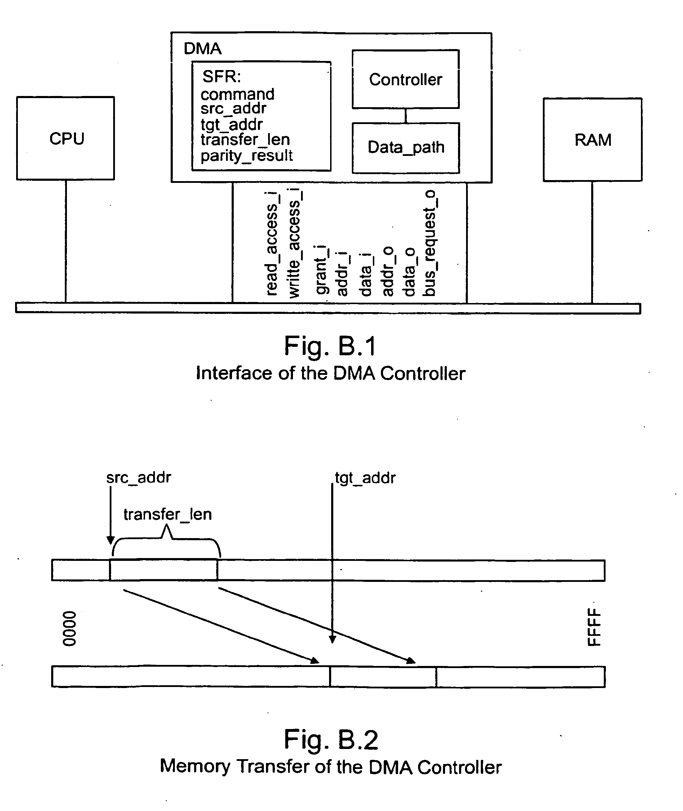

- Fig. 6.1.: shows an intuition of the case split test;
- Fig. A.1.: shows an interface of the SDRAM controller;
- Fig. A.2.: shows timing of a single read access;
- Fig. B.1.: shows an interface of the DMA controller;
- Fig. B.2.: shows memory transfer of the DMA Controller.

### Detailed Description

This document introduces as an example of the present invention the GapFreeVerification Process which is automated by the OneSpin 360 Module Verifier. The onespin module verifier application is documented separately in of the User Manual. It is recommended to be familiar with the content of of the user manual before reading this document.

This document consists of the following parts:
- Part I in *GapFreeVerification Process Manual* introduces the GapFreeVerification process. It is recommended reading for all users of 360 MV.
- Part II in *GapFreeVerification Process Manual* focuses on the application of the GapFreeVerification process for specific advanced design characteristics. It is expected that all users read Part I in *GapFreeVerification Process Manual* before proceeding to some specific chapter of this part.
- part III in *GapFreeVerification Process Manual* contains the specification and the implementation for the three tutorial examples used in Part I in *GapFreeVerification Process Manual,* the SDRAM controller, the DMA controller, and the VCORE processor

A PDF version of this document is available after OneSpin 360 installation at the following location:
$ONESPINROOT/doc/pdf/doc360_meth/Methodology_Manual.pdf (../../pdf/doc360_meth/Methodology_Manual.pdf).

### Typographic Conventions

This document uses the following typographic conventions to make information easier to access and understand:

### • text in italics

This indicates emphasized words and new terms, e.g.:
If the tool succeeds in constructing a counterexample from reset, this is called an *ascertained* failure.

### • fixed-width text

Examples, information displayed on the screen, command names, labels of GUI elements, menu names, and environment variables, e.g:
Alternatively, this command can be called from the GUI using the menu entry Setup -> Read Verilog....

### • italics in fixed-width text

Variable parts of examples or variable parts of commands that have to be provided individually.

### • quotes ('')

Quotes are used to indicate single characters in the text, e.g.:
Note that the display is interactive - the property can be expanded step by step by clicking on the small '+' signs.

### • double quotes (")

Double quotes are used to indicate strings in the text.

### • the Note symbol

**Note**: This symbol indicates important pieces of information you should read.

### • the Warning symbol

### I. The GapFreeVerification Process

### Contents and Structure

This part of the GapFreeVerification process manual introduces the basic GapFreeVerification process. It enables the reader to carry out a complete verification of a single language design of medium size. In addition, this part only focuses on the verification of single clock designs whose flip-flops are updated on *one* of the two clock edges (in contrast to a DDR RAM controllers where updates need to take place on both edges of the clock). Finally, this part only deals with designs whose verification does not require any split, neither a split of the overall verification into several complete verifications due to strong parallelism in the design nor a split of the verification of a single operation into several operations due to the excessive duration of an operation. All these restrictions for the basic GapFreeVerification Process will be addressed in Part II in *GapFreeVerification Process Manual.*

This part is structured as follows. This chapter motivates and introduces the usage of the GapFreeVerification Process. Chapter 2 then explains how to set up the verification in 360 MV and how to benefit from pushbutton consistency checking and design assertions. The four phases of the GapFreeVerification process are described in detail in four separate chapters: Chapter 3, Chapter 4, Chapter 5, and Chapter 6, respectively. Afterwards, Chapter 7 describes the final manual review of a complete verification.

Note that the GapFreeVerification process is applied to the examples from Part III in *GapFreeVerification Process Manual* as a tutorial in the four phases.

### Chapter 1. Introduction

### Overview

- operations
- important states
- visible registers
- important state machine (ISM)
- hooks
- operation properties

### Introduction

This chapter introduces and motivates the GapFreeVerification process and its four phases. It starts with a comparison to conventional verification approaches in the Section called *Conventional Verification Approaches* and then introduces the GapFreeVerification process and its automation in the Section called *The GapFreeVerification Process,* respectively, the Section called *Operations* introduces the key concepts of *operations* and *important states* and finally, the Section called *Operation Properties* explains how these concepts are captured in 360 MV. The example designs to which the GapFreeVerification process is applied in the subsequent chapters as a tutorial is introduced in the Section called *Example Designs Used For Tutorials.*

The different verification approaches cited in the introduction are compared to the GapFreeVerification process of the invention in Table 1-1. Note that in the GapFreeVerification process, luck as a paradigm for finding bugs has been replaced by a systematic process of eliminating all bugs in the design.

**Table 1-1. Different Verification Approaches**

| **Approach** | **Nature** | **Exhaustiveness** | **Termination** |
|---|---|---|---|
| Simulation | black-box | no | driven by verification plan; no clean criterion |
| ABV (bounded proof) | black-box | only bounded examination | driven by verification plan; no clean criterion |
| ABV (full proof) | black-box and white-box | yes | driven by verification plan; no clean criterion |
| GapFreeVerification process | black-box and white-box | yes | completeness (see the Section called *The GapFree Verification* *Process*) |

In the GapFreeVerification process, the termination criterion is based on the formal notion of completeness. This ensures that any gaps in the verification are spotted and closed before the verification can terminate. Therefore, a verification plan in the GapFreeVerification process is much leaner than in the conventional case;after all, it is only used to structure and plan the overall verification. Any gap in this initial verification plan will be spotted during the GapFreeVerification process. In summary, since the termination criterion in the GapFreeVerification process is independent of the initial verification plan, such an initial verification plan can be developed much more quickly than in conventional verification approaches and the quality of the overall verification is independent of the quality of this verification plan.

### The GapFreeVerification Process

With the GapFreeVerification process, the approach to verification is quite different from simulation or assertion based verification. The basic idea is to split the overall design functionality into small parts called *operations.* These operations capture the *specification* of the design and they are verified independently in turn. In addition, the sequencing of these operations is verified and all the gaps in a set of operations are identified; in this way, the GapFreeVerification process systematically leads to a complete verification of the design with 100% input scenario coverage and 100% output behavior coverage.

### Figure 1-1. Sequencing of Operations on a Trace from Reset

The basic idea behind operations is to split an arbitrarily long trace from reset into small portions each lasting only a finite number of clock cycles, but at least one cycle. Typical operations in controller-based designs are a reset operation that initializes the design, read and write operations lasting several clock cycles each, and an idle operation lasting a single cycle. In most cases, there is only a relatively small amount of different operations in a design, say 10 to 50 operations in a design of 10,000 lines of code, and these operations can be repeated any number of times during a trace from reset of arbitrary length. Figure Figure 1-1 illustrates how a sequence of operations covers an arbitrary trace from reset. With the GapFreeVerification process, these operations are systematically identified, captured, and verified (the operation itself is verified as well as its sequencing with succeeding operations); finally, any forgotten operations are identified. In this way, any arbitrarily long trace from reset is covered by the complete verification of a relatively small number of operations.

With other verification approaches, the progress of a verification is typically measured with some type of *coverage* like code coverage and functional coverage. Such coverage measures are based on the *design* under verification and give no clean termination criterion for the verification. In the GapFreeVerification process, the notion of *completeness* is introduced and it also serves as a termination criterion of the verification. Unlike coverage measures, completeness in the sense of the GapFreeVerification process is independent of the design; it only depends on the *set of operations* verified so far. A set of operations is called complete if it forms a *model* of the design under verification. In other words, the set of operations alone determines a unique value of each output for any arbitrarily long trace from reset. Since the operations additionally hold on the design, this unique output value is indeed the same output value that the design itself produces which makes the set of operations a model of the design. This notion of completeness is very strong since it ensures that there exists no design behavior that is not described explicitly in operations.

### Phases of the GapFreeVerification process

The overall verification in the GapFreeVerification process consists of the verification of all the operations of the design and their sequencing. This process is structured into four different phases; in each of these phases, some actual verification is carried out. After the termination of the last phase, a final manual review is carried out.

The central means of structuring a verification according to the GapFreeVerification process are the operations. In addition, it is quite natural to classify operations into *core* functionality and *extended* functionality. Typical candidates for extended functionality are error handling, complex operations made up of several operation such as bursts or read-modify-write operations, or mode changes in controllers supporting several modes. This classification further breaks down a verification according to the GapFreeVerification process into the verification of the core functionality as a first step and the verification of the extended functionality as the second step. The second step is carried out in phase four of the GapFreeVerification process and the first step is further subdivided into three phases as described below.

A single operation in the GapFreeVerification process is verified exhaustively against the RTL. This verification necessitates a partially white-box approach similar to ABV in order to overcome reachability problems as discussed in the Section called *Reachability* in Chapter 4. However, the GapFreeVerification process also offers a structured way of overcoming these reachability problems. Nevertheless, even the complete verification of a *single* operation is a non-trivial task, in particular if the verification engineer is not deeply familiar with the design. Therefore, the verification of a single operation is subdivided into three phases in the GapFreeVerification process. All the four phases of the GapFreeVerification process are summarized in Table 1-2.

**Table 1-2. Overview of the GapFreeVerification Process**

| **Phase** | **Objective** | **Termination Criterion** |
|---|---|---|
| Chapter 3 | capture and verify central control of core operations | internal control and sequencing of core operations fully verified |
| Chapter 4 | capture and verify full control of core operations | full control and sequencing of core operations fully verified |
| Chapter 5 | capture and verify full behavior of core operations | all outputs of basic operations verified to always have expected values |
| Chapter 6 | capture and verify extended | 100% input scenario coverage, |
| | functionality | 100% output behavior coverage |

1. The initial phase starts by identifying and verifying operations that only examine the control of the design. In this phase, it does not even matter how inputs or visible registers influence the control (the concept of visible registers is introduced properly in the Section called *Visible Registers*); it is therefore called the verification of the *central* control. Nevertheless, the operations developed in phase one serve as the skeleton for the real operations which will be derived in the subsequent phases. In addition, the sequencing of operation is examined as well in phase one. One major purpose of this phase is for the verification engineer to identify the operations from the specification in the implementation in a structured way; it is mainly white-box in nature.
2. The second phase also focuses on the control structure of the design, but it starts to examine the influence of inputs and visible registers on the control. This is called the verification of *the full* control.
3. The third phase finally focuses on the *data path.* All the outputs during the operation are verified; in addition, the visible registers are verified. Thus, it extends the verification of the full control to the verification of the full behavior. This third phase is mainly black-box in nature since the expected output values of the operation are derived from the specification.
4. While the first three phases verify the *core* functionality, phase four focuses on the *extended* functionality. Note that the verification of each operation of the extended functionality is again split according to the first three phases. In effect, all functionality of the design is verified after phase four.

**Table 1-3. The Four Phases of the GapFreeVerification Process**

| **Phase One** | **Phase Two** | **Phase Three** | **Phase Four** |
|---|---|---|---|
| basic functionality | | | extended functionality |
| control part | | data path | everything |
| only control | control derived from inputs and visible registers | outputs and visible registers | |

In summary, the GapFreeVerification process initially examines the control structure of the design and later on focuses on the data path. The main purpose of examining the control structure first is to quickly develop a skeleton for an operation. Based on design knowledge and this skeleton, the full behavior of the operation can be verified more efficiently in subsequent phases. A detailed overview over the phases is given in Table 1-3.

After a complete verification according to the GapFreeVerification process, it is certified that the set of properties completely describes the design. Hence, there is no need to check for code coverage, functional coverage, or explicit corner cases after a verification according to the GapFreeVerification process because all this is automated with the help of the completeness analysis. The only possibility that there is a bug left in the design is if some property explicitly contradicts the specification or if the verification is over-constrained. Therefore, the final review after a verification according to the GapFreeVerification process only needs to check whether all the properties correspond to the specification and whether all the constraints are indeed justified.

### Automation of the GapFreeVerification Process in 360 MV

360 MV with its completeness analysis automates the GapFreeVerification process to a high degree. Operations are encoded in so-called properties in 360 MV. These properties are automatically and exhaustively checked against the RTL. In case there exists any design behavior that violates the property, this check is sure to fail and advanced debug facilities allow to quickly identify the cause of this failure and fix the problem accordingly. There are different tests of the completeness analysis that serve as termination criteria for the different phases. These tests are sure to spot any gaps in the set of properties; there are also advanced debug facilities to quickly understand these gaps in the verification and guide their closure. Table 1-4 summarizes the working steps of the phases in the GapFreeVerification process and their automation in 360 MV.

**Table 1-4. The GapFreeVerification Process in 360 MV**

| **Phase** | **Working Steps** | **Automation** |
|---|---|---|
| Chapter 3 | capture central control of core operations in properties | guided by GapFreeVerification process |
| | exhaustively verify properties | full automation with |
| | capture sequencing of operations in completeness description | guided by GapFreeVerification process |
| | carry out minimality test of completeness analysis | full automation with |
| Chapter 4 | extend central control to full control in properties | guided by , GapFreeVerification process, and specification |
| | exhaustively verify properties | full automation with |
| | capture inputs of operations in completeness description | guided by , GapFreeVerification process, and specification |
| | carry out successor test of completeness analysis | full automation with |
| Chapter 5 | extend full control to full behavior in properties | guided by , GapFreeVerification process, and specification |
| | exhaustively verify properties | full automation with |
| | capture outputs of operations in completeness description | guided by , GapFreeVerification process, and specification |
| | carry out determination test of completeness analysis | full automation with |
| Chapter 6 | add or enhance properties for missing scenarios | guided by , GapFreeVerification process, and specification |
| | exhaustively verify properties | full automation with |
| | carry out full completeness analysis | full automation with |

### Operations

In the GapFreeVerification process, the functionality of a design is split into different operations. Examples of operations are
- a read or a write operation of a controller
- the execution of an instruction of a processor
- the reception or the transmission of a data word over a serial line
- wait for the next request (idle operation)

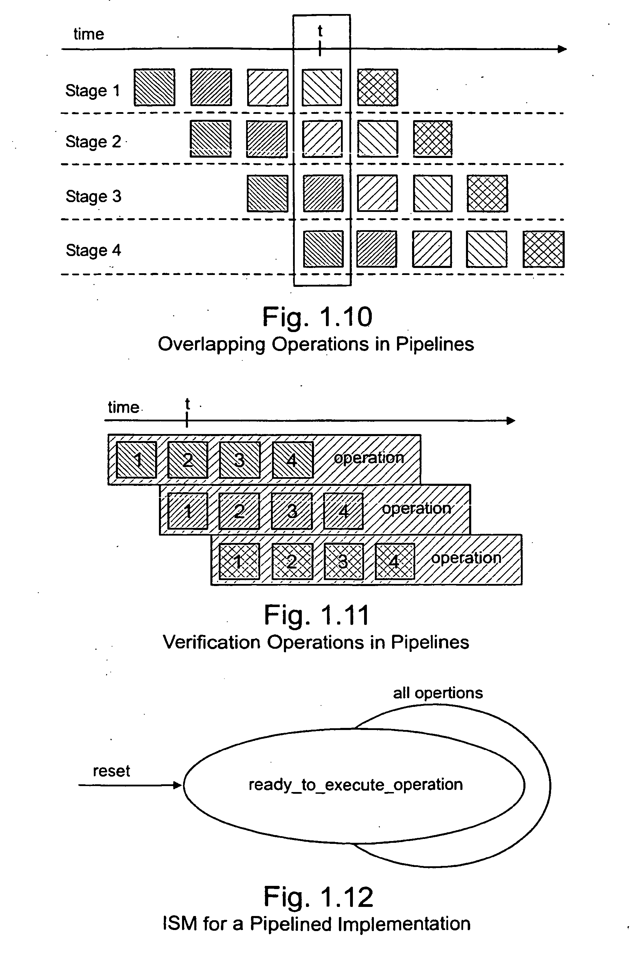

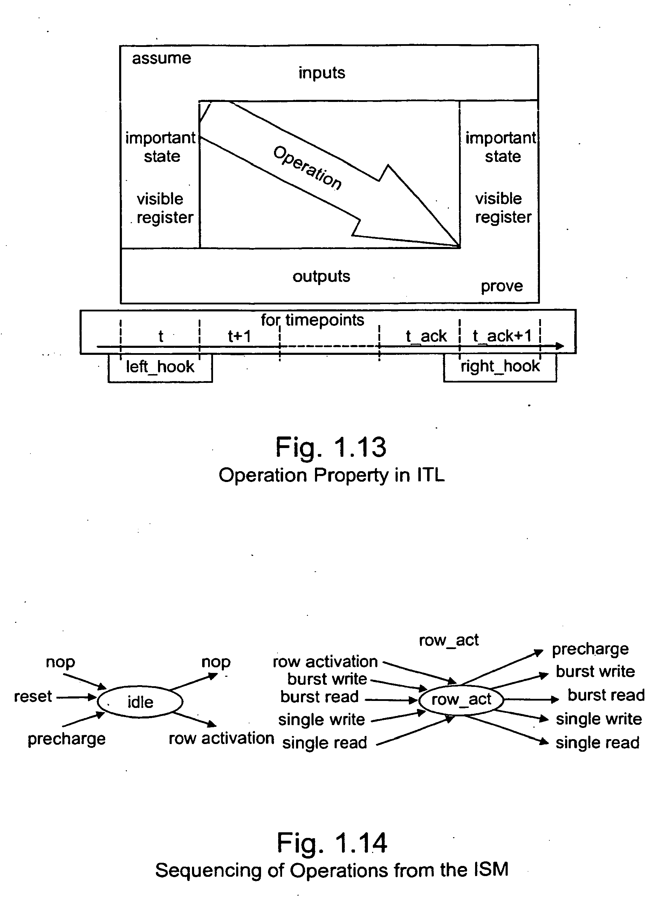

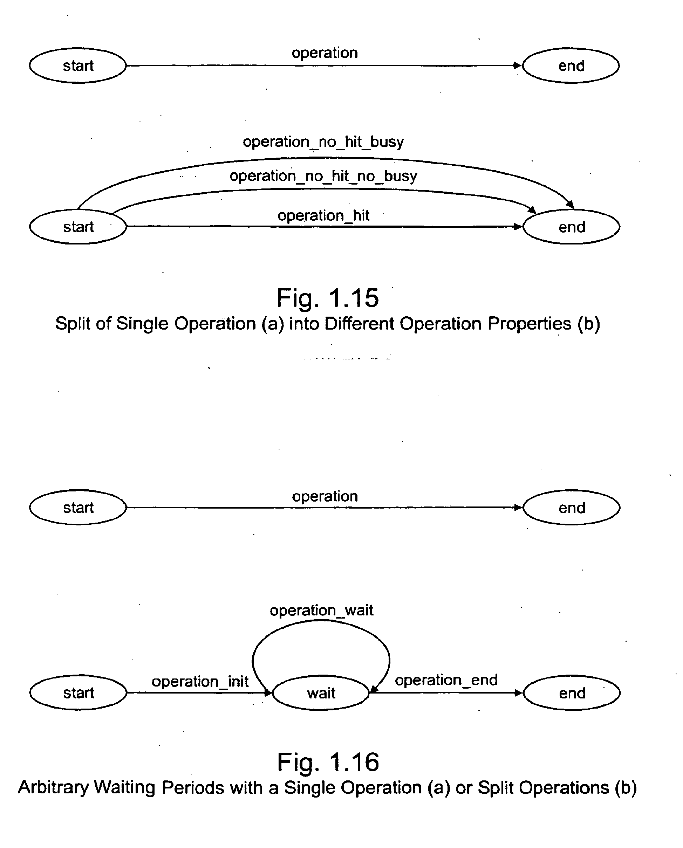

### Figure 1-2. Sequencing of Operations

The whole behavior of the design is considered as the consecutive execution of different operations. Each operation hands over control to the succeeding operation in a so-called *important state;* the succeeding operation then starts in this same important state. The values of input signals and so-called visible registers determine which operation is executed next; this is called the *trigger* of the operation. Visible registers are introduced in the Section called *Visible Registers* and important states in the Section called *Important States.* The operations themselves describe both the values of the outputs of the design as well as the values of the visible registers at the time control is handed over to the next operation. This is illustrated in Figure 1-2. Note that it is possible that the outputs of the operation are delayed such that they may appear after the important state at the end of the operation. Among other things, this is illustrated in Figure 1-5 where the operations continue for some time after handing over control to the succeeding operation.

In addition to the operations describing transitions between important states, one additional operation is required for initialization, i.e., a reset operation that starts in an arbitrary state and ends in an important state after the application of the reset sequence.

In order to achieve a complete verification with the GapFreeVerification process, all the operations of the design need to be captured and verified; in addition, the sequencing of the operations is verified as well. Based on Figure 1-2, this boils down to capturing all important states and visible registers and verifying all operations completely where the complete verification of a single operation comprises the verification of all outputs during the operation in addition to the important state and all the visible registers at the end of the operation.

### Visible Registers

A visible register is a register that can be observed at the level of the *specification.* In other words, the specification must refer to this register in order to define the behavior of the design. Visible registers are needed to store information generated or available in one operation, such that this information can be used in one of the subsequent operations. A typical example is a configuration register for a controller that determines the actual behavior of certain operations or a register file for a processor that supplies the data that an instruction reads in order to perform its computation. In some cases, not all the visible registers are obvious from studying the specification. Consider, for example, a FIFO buffer. It is quite clear that the *content* of the FIFO consists of visible registers, that is, each element that is actually in the FIFO is a visible register. Otherwise, the result of a read access to the FIFO could not be expressed in the specification. However, in addition, the *number* of elements in the FIFO is also crucial since a read access to an empty FIFO or a write access to a full FIFO typically needs to be denied. Hence, in addition to each of the data elements in the FIFO, the number of elements is also a visible register.

Since visible registers are observable on the specification, they are typically listed in the specification by some *name.* The specification then describes how the current value of this visible register influences the computation of outputs or other visible registers and how the visible register is updated by operations. As a simple example for a visible register in a specification, consider an 8-bit counter that can be incremented, decremented, or do nothing:
- increment, specified by cnt : =cnt+1
- decrement, specified by cnt :=cnt-1
- nop, no explicit specification

The value of the counter cnt is obviously a visible register in this specification. The operations specify the new value of cnt after the operation by the : = assignment. This new value is specified relative to the old value of the counter at the beginning of the operation given on the right-hand side of the assignment. As an illustration, consider that operation A in Figure 1-2 is actually the increment operation of the counter and operation B is the nop. In that case, the increment operation just takes the current value of the visible register cnt from the left-hand side of operation A, increments it, and hands it over to the visible register on the right-hand side of operation A (the next value of cnt from the point of view of the increment operation). This visible register between operation A and B is then taken by the nop, that is operation B, as current value of cnt and just passed without modification to the right-hand side visible register to serve as current value of cnt for the next operation.

Note that one of the typical characteristics of visible registers in a specification is that only the new value of those visible register that are actually updated by an operation are explicitly specified; any other visible register not mentioned in the specification of an operation is typically supposed to keep its old value. In other words, if a visible register reg_a is not modified by an operation, the trivial assignment reg_a: =reg_a is typically omitted in the specification. In the case of the above counter, the explicit specification for the nop would be cnt : =cnt. In addition, the specification of an operation often does not explicitly mention effects due to the limited size of a visible register. In the above example, the specification for the increment operation should actually read cnt: =cnt+1 mod 2⁸ since an 8-bit counter can only count modulo 2⁸, that is incrementing a counter value of 255 results in the wrapped-around value 0 and not the exact result 256. One of the goals of the GapFreeVerification process is to capture this explicit specification of the visible registers for all operations:
- increment: cnt := cnt + 1 mod 2⁸
- decrement: cnt : = cnt - 1 mod 2⁸
- nop: cnt := cnt

For a complete verification according to the GapFreeVerification process, all outputs need to be verified in the operations. As described above, the output behavior of operations is influenced by visible registers. Therefore, a complete verification of outputs can only be achieved if the visible registers of the design are verified completely as well. Nevertheless, for a reliable verification planning, it is better to be aware from the beginning that a complete verification of visible registers is part of the complete verification of any design.

In summary, there is no need to worry in advance whether one has captured exactly the visible registers from the specification in the operations. It lies in the very nature of the GapFreeVerification process that the verification can only terminate successfully once all visible registers from the specification are actually correctly captured and verified. Starting the verification with a good set of visible registers just saves time and makes verification planning more reliable.

### Important States

The important states that operations start and end in can be seen as an abstraction of actual FSM states. As an example, see Figure 1-3. This figure shows a finite state machine for a simple SDRAM controller with many states. On closer examination, most of these states just have a single successor state. Hence, when you consider abstract state transitions that may take several clock cycles, all these states can be abstracted away and only two of the states of the FSM remain as important ones, namely the idle state and the row_act state. Note that by abstracting in this way from a finite state machine, an important state machine (ISM) is created that specifies the important states and which operations can succeed each other. This ISM for the SDRAM controller is also illustrated in Figure 1-3. The ISM is a graph whose nodes are the important states and the directed edges are given by the operations. In the SDRAM example, only the nop and row activation operation can follow the precharge operation since only these two operations start in the idle state. Note that the creation of an ISM is also part of a verification according to the GapFreeVerification process since the sequencing of operations is verified as well.

### Figure 1-3. From Finite State Machine (a) to Important State Machine (b)

For the illustration of the ISM with the SDRAM controller, a bottom-up approach was used: based on the FSM in the design, the ISM was derived. In general, however, the process of creating an ISM is driven by the *specification.* In the specification, the operations of the design are defined and, at least implicitly, the sequencing of operations is specified as well. With this specification in mind, the actual FSM in the design is analyzed. It is then a creative process to actually develop the ISM. For example, most of the operations from the specification may behave very similar in the design, that is they share a common beginning for some clock cycles and only at the end, there is operation-specific behavior. In other words, the operations may be split into two sub-operations in such a way that all the similar operations have the first identical sub-operation in common and only the second sub-operation is specific. In that case, actually treating the operations as a whole would result in reverifying the common sub-operation with each operation. In such a scenario, it may be a good idea to actually split the operation into its sub-operations. This has the advantage of verifying the common sub-operation only once, but the disadvantage is that it lowers the level of abstraction in the verification. It introduces an additional important state in the ISM and one needs to review whether the sequence of the two sub-operations actually capture the desired overall operation. There is no general rule which is the right way to go in such a situation; one has to decide on a case-by-case basis.

As an example for a level of choice in creating the ISM, consider once again the SDRAM example from Figure 1-3. There, the major operations are actually the read and write operations, both in single and in burst mode. In a sense, the row activation is simply just part of a *longer* read or write operation. From the most abstract point of view, there exist only four abstract operations, namely read or write in single or burst mode, and the nop. An abstract single read operation may consist just of a single read from Figure 1-3, of a row activation followed by a single read, or even a precharge followed by a row activation and a single read. This approach would result in an ISM with one single, more abstract, important state, namely that the controller is ready to accept a new transaction, and the nop and the four abstract operations as state transitions. This is illustrated in Figure 1-4.

### Figure 1-4. Alternative ISM of the SDRAM Controller

In summary, there is some freedom in choosing important states in the GapFreeVerification process. One typically tries to capture the operations as abstractly as possible which also results in abstract important states. The reason for trying to be as abstract as possible is to achieve operations that are on the same abstraction level as the specification which allows for a very easy review whether an operation actually captures the specification. However, there are scenarios where operations are actually composed of sub-operations in such a way that many operations share a common sub-operation. In that case, going for the highest level of abstraction means verifying the common sub-operation over and over again. On the other hand, actually considering the sub-operations as proper operations has the advantage that the sub-operation only needs to be verified once and for all. There is no general answer which abstraction level is the best in such a scenario; instead, this has to be decided on a case-by-case basis. the Section called *SDRAM Controller Tutorial* in Chapter 3 addresses this question for a concrete example in detail.

As has been illustrated in Figure 1-2, an operation starts in its important state exactly at the time the previous operation reaches its important end state. We therefore introduce the concept of hooks, namely the left hook captures the time an operation is in its important start state and the right hook captures the time an operation reaches its important end state, that is when it hands over control to the *succeeding* operation. Note that operations can actually continue for some cycles after their right hook in order to verify delayed outputs. Therefore, the end of an operation is actually an ambiguous concept: is it the maximum time for which some behavior is captured in the operation or is it the time control is handed over to the next operation? Therefore, the concept of hooks is introduced; this is illustrated in Figure 1-5 where the row activation operation continues after reaching the end state at the right hook. In summary, the sequencing of operations can be expressed based on the hooks alone: an operation succeeds a previous operation in such a way that the right hook of the predecessor equals the left hook of the successor.

### Figure 1-5. Operations Continuing After Their End State

Typically, an operation describes one particular transition in the ISM: it starts in some important state s and ends in some important state Q. In other words, two transitions of the ISM either starting or ending in different important states constitute different operations. However, there are also scenarios where two different transitions in the ISM exactly behave alike apart from the end state. Consider the illustration in Figure 1-6. Operation A starts in state normal. Depending on some extra condition, it either ends in state normal again or in state special; this different end state is the *only* effect of this extra condition. As a concrete example, consider an arbiter with a dedicated configuration mode. While an arbitration operation is carried out in state normal, a mode change can be requested. In that case, the arbitration operation is carried out normally, but the state special is entered at the end of the operation in order to allow for writing the configuration registers.

### Figure 1-6. Operation with Two End States

In such a case, it actually makes sense to consider both transitions in the ISM as a single operation. As a rule of thumb, different transitions in the ISM should only be captured by a single operation if they just differ very slightly, that is only in the end state and perhaps one output signal. This is to ensure readability of the operations and save verification effort: by describing both transitions in a single operation, one makes clear that both transitions behave alike and one only needs to verify a single operation. As soon as the transitions are substantially different, readability suffers greatly from combining them into a single operation; hence, there is nothing to be gained by trying to combine them.

As has been described above, choosing operations and important states is a creative process. However, there is no need to worry about wrongly chosen or forgotten important states or operations. This is because a complete verification according to the GapFreeVerification process can only succeed if all operations and all important states are captured and verified. Similar to visible registers, a reasonably good initial choice of important states and operations just speeds up the verification while a bad choice automatically results in a refinement of the important state machine during the subsequent verification.

### Non-Trivial Abstraction of FSM

In controller based designs, the important state typically describes a state in which the design is ready to accept a new transaction. This abstract notion then needs to be mapped to FSM states. In many cases, this is a trivial mapping, i.e., there is just one FSM state, typically called idle, where the design accepts new transactions. However, more complex scenarios are also quite common.

### Figure 1-7. FSM for Overlapping Transactions

One typical scenario that requires non-trivial important states is an *overlapping* access. This means that in some protocols, the last cycle of one access may actually coincide with the first cycle of the next access. In other words, the FSM implementing such a protocol does not necessarily return to the idle state at the end of the transaction, but it checks for a new incoming access in this final state and takes a shortcut to the first FSM state of the new access instead of detouring over the idle state. The FSM in Figure 1-7 is from such a controller that can only perform a read transaction, but the last cycle of this transaction which is signaled by ready i='1' can overlap with the first cycle of a new access. From the specification, one would expect an ISM with just one important state, namely that the design is ready to accept a request. However, actually mapping this ISM from the specification to the FSM in the design is a non-trivial task.

### Figure 1-8. Abstraction of Overlapping Transactions

In general, the last cycle of such an overlapping transaction behaves very much like the idle state itself. This is illustrated in Figure 1-7. In the last cycle of a read access, that is in case the FSM is in state read and there is an incoming ready_i, an incoming request leads to a new access and no incoming request leads to the idle state. The same holds for the idle state itself. Hence, the important state for this controller is actually a merge of the idle state and the last cycle of the read access. This ISM is shown in Figure 1-7.

### Figure 1-9. ISM for Overlapping Transactions

As has been stated before, wrongly chosen important states are sure to be identified in the course of the GapFreeVerification process. This also means that one does not have to come up with the right important states for overlapping accesses in advance; instead, one can safely start with a simple important state just containing the FSM state idle. By examining the sequencing of operations in the GapFreeVerification process, all the scenarios that support overlapping accesses are identified automatically and in the end, one arrives at the right important state for overlapping accesses, anyway. This is illustrated on a concrete example in the Section called *VCORE Processor Tutorial* in Chapter 3. It just saves time to recognize overlapping accesses and act accordingly in advance.

The introduction of the scenario of overlapping accesses in this section is mainly intended as an illustration for the abstraction power of the important state approach. After a successful verification according to the GapFreeVerification process, the ISM is often so abstract that it quite naturally matches the specification, but the mapping of the ISM to the FSM in the implementation is non-trivial (just compare Figure 1-7 and Figure 1-7 and keep in mind that the FSM is much more complex in case there are more operations which, in turn, have several FSM states, each). It is often the case that the designer who wrote the central FSM no longer recognizes it in the ISM because the ISM is much closer to the specification than to the implementation.

### Operations in Pipelines

In contrast to controller based design, pipelines execute several operations simultaneously in such a way that the different operations may actually overlap by several cycles. This is illustrated in FFigure 1-7 with the help of a 4-stage pipeline. Note that the execution of one operation in the 4 stages is illustrated by using one color for the operation. Hence, the first operation is initially in stage 1 and moves to stage 2 in the next cycle where the succeeding operation is in state 1. At time t, there are 4 different operations in the pipeline.

### Figure 1-10. Overlapping Operations in Pipelines

Since there are typically several operations simultaneously being executed in a pipeline, the main conceptual question is how a pipeline should be verified with the GapFreeVerification process. One could think of describing the simultaneous execution of all the operations in the pipeline as an operation for the verification, thus overcoming the problem of overlapping operations. However, even with a 4-stage pipeline that can only execute 4 different operations, there are already 4⁴=256 different possible combinations of operations in the pipeline. It is clear that for a complete verification according to the GapFreeVerification process, all these combinations indeed have to be verified. However, due to the huge amount of possible combinations, it is definitely not feasible to capture each possible sequence of operations in a pipeline as a separate pipeline operation.

As a consequence, pipelines are verified very much like controllers from an abstract point of view: An operation in a pipeline just captures the execution of a *single* operation in the pipeline independent of all the older operations that were in the pipeline before and independent of the succeeding operations. Hence, a pipeline operation in the GapFreeVerification process describes how a single operation moves through the pipeline. This verification view of a pipeline is illustrated in Figure 1-7. The colored boxes represent pipeline stages; a concrete stage is identified by the number in the colored box. A pipeline operation captures all the 4 stages of one operation successively. Note that this figure matches Figure 1-7 in the sense that at time t, the same operation as indicated by the color starts execution in the first stage.

### Figure 1-11. Verification of Operations in Pipelines

In contrast to controllers, operations do actually overlap in pipelines. Therefore, it is not really obvious when pipeline operations are supposed to have their right hook. In controller based designs, the right hook is typically just at the *end* of the operation. From a more abstract point of view, this is also the time that control is *handed over* to the next operation. This notion of handing over control to the next operation also applies in pipelines: an operation hands over control to the next operation in the earliest cycle where the next operation could actually start execution.

Consider Figure 1-7 again for an illustration of hooks in pipelines. In cycle t, the green operation actually starts execution, that is it moves from stage 1 to 2. In the next cycle, the gray operation is in stage 1. Since the green operation moves from stage 2 to 3 in this next cycle, the gray operation can actually start execution, i.e., move from stage 1 to 2. Therefore, the right hook of the green operation is actually in this cycle. Figure 1-7 also illustrates this fact: while any single operation actually lasts four cycles due to the length of the pipeline, the throughput of the pipeline is one operation per cycle. Hence, control must be handed over to the next operation already after a single cycle even if the operation continues for three more cycles.

In the GapFreeVerification process for controller based designs, important states as an abstraction of FSM states play a crucial role. However, the notion of important states does not apply to pipelines in any obvious way. Nevertheless, the concept of operations and hooks can be applied to pipelines as outlined above: the right hook is the cycle when control is handed over to the next operation or, in other words, when the next operation could start its execution. In addition, the hooks are the exact cycles when operations are in their important start or end states, respectively. Therefore, the hooks can actually be identified with the important state in pipelines: the important state in a pipeline is that a pipeline operation could start its execution. Consequently, the important end state is the cycle where the next pipeline operation could start its execution. In summary, the important state in a pipeline is typically very abstract, namely that a pipeline operation could start its execution. In addition, the ISM in pipeline designs is normally trivial since there is only a single important state and each operation both starts and ends in this state. This is illustrated in Figure 1-12.

### Figure 1-12. ISM for a Pipelined Implementation

In summary, simple pipelines are handled in the GapFreeVerification process by
- verifying the passage of one operation through the whole pipeline as a single pipeline operation
- having a single important state that captures that the pipeline is ready to execute a new operation
- having operations continue past their important end state until they have left the pipeline
- having the trivial property graph where each operation can follow each operation

### Operation Properties

The expected functionality of an operation is captured in a *property.* These properties are therefore called *operation properties.* Such a property consists of several parts. The main parts are the *assume* part that describes the situation where the property applies at all and the *prove* part that contains everything that is supposed to be checked each time the assume part applies. In other words, properties describe an implication, that is the assume part implies the prove part. Hence, the different parts of an operation like important states and visible registers at the beginning and the end need to be mapped to the assume and prove part in an operation property. It is quite natural that the important state at the beginning as well as the trigger of the operation consisting of inputs and visible registers at the beginning is captured in the assume part while the prove part describes the end state, the outputs, and the visible registers at the end of the operation. For the timing of an operation, there exists a separate part in an operation property called *for timepoints.* Finally, the beginning and end of an operation are captured in an operation property with a left hook and right hook, respectively. Figure 1-7 illustrates how these different parts of operations are mapped to operation properties.

### Figure 1-13. Operation Property in ITL

In the GapFreeVerification process, the sequencing of operation is defined by the important state machine: an operation ending in some important state idle can only be succeeded by an operation starting in this same state idle. For the ISM of the SDRAM controller from Figure 1-3, the sequencing of operations is illustrated in Figure 1-7. As an example, the reset, nop, and precharge operations that end in the idle state in the ISM can only be succeeded by a nop or row activation operation since these are the only operations starting in the idle state.

### Figure 1-14. Sequencing of Operations from the ISM

In ITL, the sequencing of operations is described as a *property graph* similar to the specific view of the ISM shown in Figure 1-7. For each operation property, the property graph lists all the possible successor properties. For example, the possible successors of the precharge property are the nop and row activation properties. One specific operation property is a *reset* property that forms the start of each possible sequence of operation properties; the reset property is the only one without a predecessor property in the property graph. In this way, the property graph just captures the sequencing of the properties without explicitly capturing the important states as well; the important states are only captured in the operation properties themselves.

The property graph is defined in ITL as part of the *completeness description.* In addition, this completeness description also lists the inputs, outputs, and visible registers of the design in different section. A simple completeness description is illustrated below. Note that the partial description of the property graph naturally matches Figure 1-7, that is it summarizes the ISM transitions involving the idle state.

```
 completeness sdram is
 inputs: -- list of design inputs
  reset,
 ...
 determination_requirements: -- list of design outputs
  determined(ready_o);
 ...
 local_determination_requirements: -- list of visible registers
 at right_hook: determined(my_visible_register);
 ...
 reset_property: -- ISM: reset property
  reset;
 property_graph: --- ISM
  -- operations starting in idle
  from_idle_state := nop, row_activation;
  -- operations ending in idle
  to_idle_state := reset, nop, precharge;
  -- operation sequence via ISM state idle
  to_idle_state -> from_idle_state;
 ...
 end completeness;
```

Below, a simple operation property is shown. It starts and ends in the same important state, namely idle_state. It requires the input start_i to be active in order to trigger the operation. In addition to the important end state, it proves that the output ready_o is activated at the end of the operation, but not before, and that the visible register fill_level is just set to the value 2 at the end of the operation. Finally, the left and right hook identify the time the operation is in its important state at the beginning and the end, respectively.

```
property operation is
 dependencies: no_reset:
 assume:
  at t: idle_state;                 -- important state at the beginning
  at t: start_i = '1';              -- trigger over inputs and visible
 registers

 prove:
  at t+3: idle_state;               -- important state at the end
  at t+3: fill_level = 2;           -- visible register at the end
  during [t+1, t+2]: ready o = '0'; -- output
  at t+3: ready_o = '1';            -- output

 left_hook: t;                      -- start time
 right_hook: t+3;.                  -- end time
 end property;
```

Visible registers transport data from one operation to the next one in the specification (see Figure 1-2). In the GapFreeVerification process, an operation property hands over the control to the next operation at its right hook which equals the left hook of the next operation. Therefore, visible registers are actually verified at the right hook of an operation during phase three as discussed in the Section called *Verification of Visible Registers* in Chapter 5. Phase two and three can thus rely on the fact that the visible registers are determined at the left hook. Below, the example of the counter from the Section called *Visible Registers* is captured in ITL. For simplicity, the modulo computation of the new value of the counter is replaced by slicing.

```
property increment;
 freeze:
           curr_cnt = cnt @ t; -- current value of visible
 register
 assume:
 ...
 prove:
 at t+1: cnt=(curr_cnt+1)(7 downto 0); -- capture new value of visible
 register
 left_hook: t; -- start time
 right_hook: t+1; -- end time
 end property;
 property decrement;
 freeze:
           curr_cnt = cnt @ t; -- current value of visible
 register
 assume:
 ...
 prove:
 at t+1: cnt=(curr_cnt-1) (7 downto 0); -- capture new value of visible
 register
 left_hook: t; -- start time
 right_hook: t+1; -- end time
 end property;
 property nop;
 freeze:
           curr_cnt = cnt @ t; -- current value of visible
 register
 assume:
 ...
 prove:
 at t+1: cnt=curr_cnt; -- capture new value of visible
 register
 left_hook: t; -- start time
 right_hook: t+1; -- end time
 end property;
```

For each of the operation properties, the current value of the counter is read at the left hook. Based on this value, the new value at the right hook is computed. In this way, the visible register is completely verified: each operation determines the counter at the right hook based on the counter at the left hook which, in turn, is the counter at the right hook of the preceding operation. Note that the operation properties closely resemble the specification of the counter which is always a goal of a complete verification according to the GapFreeVerification process.

Using the exact hooks to hand over the value of visible registers is only a convention. It is also possible to use another timepoint with a fixed offset to left_hook and right_hook. However, it is recommended to just use the hooks in order to avoid confusion.

### From Operations to Operation Properties

While it is theoretically possible to capture more than one operation in a single operation property, this approach is not encouraged. Instead, if many operations are very similar, a *template* for an operation property is created and this template is instantiated with different parameters in order to capture the different operations. In this way, it is ensured that the various operation properties only differ in some aspect defined by the parameters, but behave identically otherwise. A typical example for such similar operations are all the arithmetic or logic instructions in a processor. The instructions only differ in the concrete result they compute; everything else is the same. An example for the application of operation property templates is given in the Section called *VCORE Processor Tutorial* in Chapter 3.

Normally, an operation is captured with a single operation property in the GapFreeVerification process. However, there are cases where an operation may have quite different timing depending on some additional condition. As an example, consider a memory controller that can access either an external memory or a cache. A read operation for this controller is handled quickly in case there is a cache hit; there is not even an access to the external memory in that case. However, if there is no cache hit, the external memory needs to be accessed and its protocol handled. There may be further conditions influencing the timing, such as whether the bus to the external memory is currently busy or not. In summary, there are several different scenarios for the read operation with different timing and different control paths through the FSM, although the important state at the beginning is the same in all these scenarios just like the important state at the end.

In such cases of different timing, it is recommended to use several operation properties to capture the overall operation. This is illustrated in Figure 1-7. A single operation is captured by three operation properties, one for the scenario that there is a hit, one if there is no hit and the bus is not busy, and finally one for the remaining case, that is not hit, but a busy bus. Note that the GapFreeVerification process makes sure that no case is forgotten in case an operation is represented with the help of several operation properties.

### Figure 1-15. Split of Single Operation (a) into Different Operation Properties (b)

It is theoretically possible to capture several operation properties with different timing in a single operation property. Hence, one could actually end up with a single operation property even if an operation may have different timing. However, the readability of operation properties suffers very much if different timing behavior is forced into a single property. Hence, reviewing the verification code at the end of the GapFreeVerification process would become much more difficult. It is therefore strongly recommended to use different operation properties in case an operation may have different timing.

### Operations with Unbounded Waiting Periods

In the GapFreeVerification process, operations may have dynamic timing, that is the actual timing may depend on events such as an input signaling availability of data. As an example, a read operation on an external memory can obviously only terminate once the external memory delivers valid data. Hence, the concrete timing depends on when exactly the external memory delivers valid data. In particular, there does not have to be an upper bound for the time the external memory takes to deliver data. Thus, an operation can in principle last for an arbitrary, but finite number of clock cycles. When capturing such an operation in a property, it is important to capture the timing of the operation. For this purpose, so-called time variables are introduced; these time variables may be bound to events in the design in order to capture the timing correctly. In the example below, a waits_for construct is used in the for timepoints section in oder to introduce the name t_valid for the first cycle that the external memory has valid data which is indicated by valid_i='1'.

```
property read_operation is
 ...
 for timepoint:
  t_valid = t+1..6 waits_for valid_i = '1'; -- timing
 assume:
  at t: idle_state; -- important state at beginning
  at t: start_i = '1'; -- trigger
 prove:
  at t: read_req_o='1'; -- output
 ...
  at t_valid+1: idle_state; -- important state at end
 ...
 left_hook: t; -- start time
 right_hook: t_valid+1; -- end time
 end property;
```

However, it is not possible to express in ITL that such a waiting period can last for an *arbitrarily* long time. Instead, one has to introduce an upper bound for the waiting period. In the example above, the waiting period for valid data is limited to 6 cycles with the help of the range in front of the waits_for construct. This obviously restricts the verification since the case that there is no valid data from the environment in the bounded interval of the property is not examined at all. In the concrete example, the case that valid data only arrives after 7 cycles might contain a bug that goes undetected because it does not occur with a maximum of six wait cycles. However, in most cases, such a restriction of the verification is acceptable since the whole design just waits for the event, that is nothing really happens.

The alternative to approximating the unbounded waiting period by a fixed maximum length is to actually split the operation into three separate parts as illustrated in Figure 1-7. The figure compares the overall operation with its start and end state to a version that is split into three operations. Note that this also means that an additional important state has to be introduced capturing that the design is actually waiting for the event. An initialization operation begins in the starting state of the overall operation and ends in the newly introduced waiting state. A waiting operation lasting a single cycle captures that nothing happens if the design is waiting and the expected event does not occur. In particular, this waiting operation starts and ends in the newly introduced waiting state. Finally, the ending operation starts in the waiting state, captures the behavior in case the expected event arrives, and ends in the same state the overall operation ends in.

### Figure 1-16. Arbitrary Waiting Periods with a Single Operation (a) or Split Operations (b)

With such a split of an overall operation, the waiting operation can be applied arbitrarily often and thus, there is no restriction of the verification regarding the maximum length of waiting periods. However, the abstraction level of the ISM has been decreased since an additional important state was introduced and a single operation from the specification has been split into three operations. In addition, splitting of an operation typically introduces additional reachability problems (see the Section called *Reachabi*/*ity* in Chapter 4 for a discussion on reachability problems); in other words, the verification of the split operations is definitely harder than the verification of the single operation.

In all scenarios with potentially unbounded waiting periods, it is recommended to start with the more abstract version of the operation, that is a single operation property using a bounded waiting period. If there is some doubt regarding this bound at the end of the verification, the operation should be replaced by the three sub-operations as illustrated in Figure 1-7. However, by having carried out the verification of the bounded version upfront, a lot of design knowledge has been gained which is crucial in the verification of the split version. Starting directly with the split version is typically very hard to do; hence, doing the verification with bounded operations first is actually more efficient than the direct route.

### Operation Properties and Phases of the GapFreeVerification Process

A single operation property is developed in the first three phases of the GapFreeVerification process and it may also undergo some refinements in the fourth phase. Naturally, the different parts of the operations are developed in different phases. For example, the visible registers at the beginning and the inputs that form the trigger condition belong to phase two while the outputs and the visible registers at the end of the operation are only examined in phase three. Table 1-5 illustrates which parts of an operation property are developed in which phases. In general, one can say that phase one is mainly focused on the hooks and the timing in the for timepoints section as well as the important state machine. Phase two then develops the proper assume part and phase three the proper prove part for the operation properties.

**Table 1-5. Operation properties in the GapFreeVerification process**

| **Property Part (ITL)** | **Operation Part (Methodology)** | **Description** | **Example** | **Phase** |
|---|---|---|---|---|
| for timepoints | Timing | Allows to relate the timing of the operation to events from the design. The timing is typically bound to the arrival of input events or it may be influenced by the value of a control register that defines the number of wait states. | t_end=t+3..5 waits_for event_i='1' | 1 and 4 |
| assume | Important State (at the beginning) | Mainly the state of the control register augmented by conditions over other design registers at the beginning of the operation. | (ctrls_reg=IDLE) AND (counter<=10) | control state: 1 conditions: 2 and 3 |
| | Trigger | The condition that lets this particular operation start instead of a different one. The condition refers typically to inputs and visible registers. | read_req='1' AND addr=last_addr | 1 (based on internal signals) and 2 (based on inputs and visible registers) |
| prove | Important State (at the end) | Mainly the state of the control register augmented by conditions over other design registers at the end of the operation. | (ctrls_reg=IDLE) AND (counter<=10) | control state: 1 conditions: 2 and 3 |
| | Visible registers | The state of the visible registers at the end of the operation when control is handed over to the next operation. | last_addr=10 | 3 |
| | Outputs | The values at the outputs of the design during the operation. | | 3 |
| left_hook | Start time | The time the operation is in its important state at the beginning | t | 1 |
| right_hook | End time | The time the operation is in its important state at the end, that is, when it hands over control to the next operation | t_end | 1 |

### Example Designs Used For Tutorials

In this manual, the GapFreeVerification process is applied to three different designs as a tutorial. Note that each tutorial is self-contained, that is, the tutorials can be studied independently. It is only required to read the description of one of the phases before carrying out one of the three tutorials for this phase. In the following, we highlight the characteristics of each of the designs.

### SDRAM controller

A simple controller that supports read and write accesses both as single accesses and as bursts. There are no configuration registers. The timing of the protocol is completely static. However, the ISM of the controller is non-trivial since it has two important states. The complete specification and implementation of the SDRAM controller are available in Appendix A.

### DMA controller

A simple controller that supports DMA, that is, copying of a whole memory region to a different address. In addition, the controller can perform parity computation. There are many configuration registers and the timing is dynamic, that is, it depends on incoming events. The ISM of the controller is actually trivial since there is only one important state. The complete specification and implementation of the DMA controller are available in Appendix B.

### VCORE processor

A simple 16 bit pipelined processor with four pipeline stages. Six different instructions operate on a eight general purpose registers and the program counter: two arithmetic instruction, one logical instruction, two memory instructions, and one conditional jump. For the memory interface, the timing is dynamic. The complete specification and implementation of the VCORE processor are available in Appendix C.

### Chapter 2. Setup and Consistency Checking

### Overview

- consistency checking
- model building assertions
- HDL assertions

### Introduction

TBD, see

### Chapter 3. Phase One: Verification of Central Control

### Overview

- master/slave interfaces
- completeness description

### Introduction

Phase one of the GapFreeVerification process aims at the verification of the central control of the core functionality. This means that the focus is on the core functionality, i.e., the extended functionality is ignored. In addition, only the central control is examined; this means that the data path is completely ignored and the verification is just focusing on internal signals without looking at inputs or visible registers. The main objectives of phase one are
- identifying the operations of the design and their sequencing (the Important State Machine)
- identifying a subset of all the operations of the design as core functionality, thus allowing to postpone the verification of more complex functionality to phase four
- capturing the central control of each operation of the core functionality as a skeleton for the
- operations of subsequent phases that will achieve a complete verification
- getting familiar with the design in case the design was not known prior to the verification

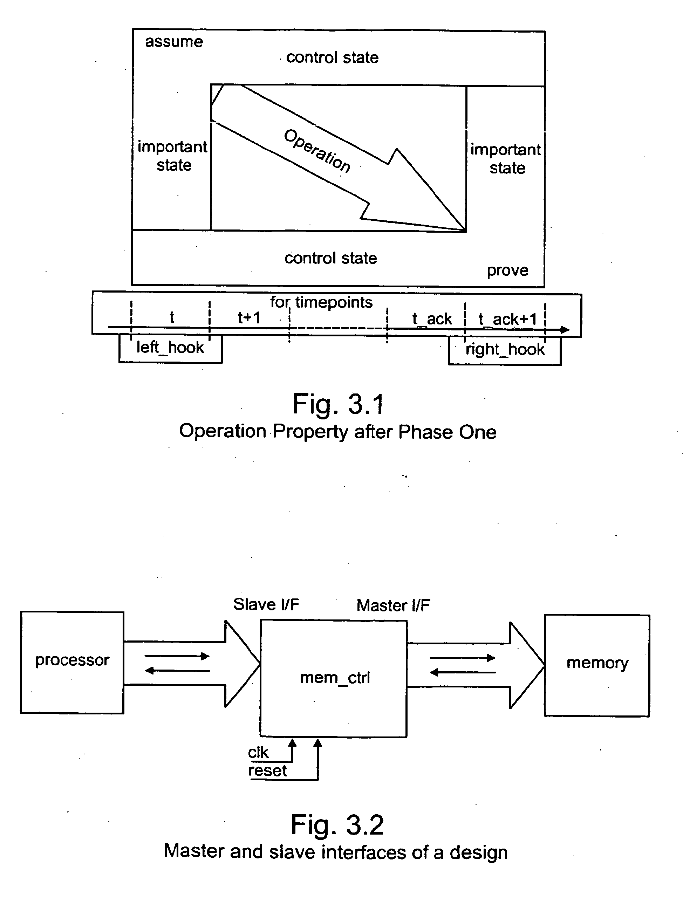

### Figure 3-1. Operation Property after Phase One

In phase one of the GapFreeVerification process, the central control of core operations is captured in properties and verified. As illustrated in Figure 3-1, this comprises capturing the timing of the operation, the important states at the beginning and the end, and the control states in between. Note that adding the control states between the important states to the operations does not really serve a verification purpose, it just simplifies debugging: with the expected intermediate control states in the operation, one can immediately spot the cycle where the control flow deviates from the expected one. Therefore, it is recommended to add the control states to the verification in phase one. In the subsequent phases, these control states will be replaced by a verification of the outputs. Note that the trigger of a phase one operation is just derived from internal signals. The influence of inputs and visible registers on the trigger will only be examined in Chapter 4.

There are mainly two ways of implementing a design, namely either with controllers or pipelines. The main difference is that a pipelined design executes several operation simultaneously, but in different phases. In other words, the execution of operations in a pipeline overlaps whereas a controller typically executes one operation at a time. In addition, there are many mixed implementations, including implementations with multiple controllers. In the following, we will first concentrate on a controller based design with one single controller and then on a simple pipelined design.

Executing phase one of the GapFreeVerification process is to a large extent a white box activity since it focuses just on the control part of the design. Nevertheless, this white box activity is driven by the specification since the operations and their sequencing are derived from the specification. Phase one consists of five steps:
1. analyze the specification and the design interfaces and identify the operations of the design
2. analyze the design and find the registers that store the control information
3. decide on the core functionality as a suitable subset of the operations of the design
4. create for each operation of the core functionality an operation property that describes the state transition of the control registers for this operation.
5. represent the important state machine (ISM) as property graph in the completeness description

It must be noted that this phase of the GapFreeVerification process consists mainly of the mapping of the specified control flow to the implemented one. It is therefore only possible to find conceptual bugs like unimplemented operations or wronly implemented control flow between operations.

Phase one terminates once the central control and the sequencing of the core functionality has been captured in operations and verified. The sequencing in phase one focuses on the question whether the important state machine (ISM) actually corresponds to the operations. In other words, it is examined whether the hooks and important states in the operation properties correspond to the ISM. This is achieved by the minimality test of the completeness analysis that examines each pair of successive operations that is possible according to the ISM. The termination of phase one is certified by 360 MV in case the following conditions are met:
- The operation properties all hold on the RTL.
- The ISM for the core functionality is represented in the property graph of the completeness description.
- All minimality tests hold.

The remainder of this chapter is structured as follows: the Section called *Design Interfaces* and the Section called *Identification of operations* focus on how to extract ISM and operations from the specification and the design. The actual development of phase one properties is then described in the Section called *Analysis of the design implementation.* Capturing the ISM and executing the minimality test in order to achieve termination of phase one is introduced in the Section called *Executing the Minimality Test.* This concludes the description of phase one of the GapFreeVerification process for designs with simple controllers.

Afterwards, the following three sections give insight into phase one for designs that are not just simple controllers. the Section called *Designs with additional control registers* describes how to deal with additional control registers that are separate from the central controller and the Section called *Designs without an explicit state machine* shows how to handle distributed control registers without a central controller. Finally, the Section called *Operations in Pipeline Designs* illustrates the application of phase one to pipelines.

The final three chapters are a tutorial for phase one for the three example designs for the GapFreeVerification process, the Section called *SDRAM Controller Tutorial,* the Section called *DMA Controller Tutorial,* and the Section called *VCORE Processor Tutorial.*

### Design Interfaces

The inputs and outputs of a design can usually be grouped into different interfaces. The signals of one interface are typically connected to the same module in the neighborhood of the design. Often, there are data and control signals of different directions in an interface. (cf. Interfaces in Transaction level modeling¹)

These interfaces can be classified into two classes: master and slave interfaces. Master interfaces initiate transactions while slave interfaces react on transactions that are initiated by the module connected to the interface. The nature of an interface cannot safely be derived from the direction of the signals of that interface. A master interface has at least one output that signalizes the start of an transaction, while a slave interface needs at least one input to know about the new transaction from the master. It is possible that during a transaction a slave interface requests some additional information from the master i.e. there might be additional control signals from the slave to the master interface.

### Figure 3-2. Master and slave interfaces of a design

The analysis of the design behavior focuses on the slave interfaces. If there is just one slave interface, the design behavior is a reaction on the transactions received at this slave interface i.e. each received transaction at the slave interface starts an operation in the design. Depending on the functionality the transaction can be served by one or more operations of the design.

In case of several slave interfaces in the design, there are two major scenarios: the interfaces may either be identical or different. A typical example for identical slave interfaces is an arbiter with several masters. The interface between each of these masters and the slave side of the arbiter is identical. In this case, the operations of the design are more or less independent of the actual number of masters; an operation captures an incoming request, no matter from which master or if several master indicate a request in parallel. The actual arbitration between the different identical slave interfaces is then a crucial part of the operation.

On the other hand, the slave interfaces of the design may be quite different. Consider one interface for the intrinsic functionality of a design (e.g. arbitration for an arbiter) and one for the configuration of that functionality. In this case, the operations of the design are determined by the transactions at the different slave interfaces *together.* If the change of the configuration is allowed only if the intrinsic operations do not run, then the reconfiguration and the normal operation cannot occur at the same time and the reconfiguration and the normal operations can be described in independent operation properties. Often, there is a dedicated configuration mode. In this case there is typically an important state that symbolizes the configuration mode and *each* normal mode operation must regard the mode change transaction at the configuration interface. Hence, the important state at the end of the operation is conditional and depends on the occurrence of a mode change.

```
 property grant_request is
 dependencies: no_reset;
 freeze:
  config_mode_change = (we_i = '1') AND (addr_i = MODE_REG) AND (data_i =
 1) @ t;
 assume:
  at t: idle_state;
  at t: req_i = '1';
 prove:
  at t+1: if (config_mode_change) then
               config_mode
            else
               idle_state
            end if;
  at t+1: grant_o = '1';
 left_hook: t;
 right_hook: t+1;
 end property;
```

There are designs like processors without slave interfaces. For those designs, the behavior follows a scheme that normally depends on values at some design inputs. E.g. for processors the operations are the instructions of the processor that are read from the instruction memory.

There are designs with a more complicated behavior where the operations are not determined by the slave interfaces only e.g. if the design generates timer events itself. Such designs are excluded from this part of this manual and will be discussed late in Part II in *GapFreeVerification Process Manual.*

### Identification of operations

At the beginning of the verification with the GapFreeVerification process, one starts to analyze the design interfaces. Based on the transactions on the slave interfaces, the operations of the design are identified. For each operation it must be clear, which trigger starts this operation and whether the operation lasts for a fixed number of clock cycles or the operation ends dynamically based on some external event. Moreover, an initial version of the ISM should be in place. In other words, it should be clear which sequences of operations are possible and which are not.

In case of complex designs, the ISM may also be quite intricate. Therefore, the initial three phases of the verification only focus on part of the functionality, namely the core functionality. The exact separation of core functionality from extended functionality depends on the concrete design under verification. Typical operations that are considered to be extended functionality are error handling, reconfiguration, and complex operations like read-modify-write or reads that are split into several accesses. As a general rule, everything that complicates the verification in the initial phases overmuch is best faced in phase four as extended functionality.

In some cases, one may even go one step further and initially introduce a constraint forbidding all extended functionality by saying that some control inputs are driven by constant values. When the verification under this constraint finishes successfully, one can be sure that the verification under the preliminary constraints is indeed complete. One can then remove the preliminary constraints one at a time and carry out the verification of the newly allowed operations.

In case of very short or incomplete specification documents and without access to the designers, it is nearly impossible to find the operations of a design. Then the transactions and operations of the design must be guessed. Some information about the operations can be derived from the design implementation. However, the quality of a verification without a decent specification is limited. The result one can expect is a check for plausibility and the creation of the design documentation as a set of operations. However, this result can be very helpful for instance when dealing with legacy IP.

### Analysis of the design implementation

### Finding the control register

In phase one of the GapFreeVerification process, operation properties are created for core operation of the design. Each of these operation properties contains the important state at the beginning of the operation, trigger conditions, and the important state at the end of the operation.

The first version of the important states will just describe that the control register has a certain value. Therefore, the first task in writing operation properties is to identify the control register. The control register has typically an enumeration type or, often in Verilog, a small array where each value of the array is defined in constant declarations (parameters or define). To ease the explanation of the methodology, it is assumed now that the design contains just one control register. More complicated designs are discussed later.

### Analysis of the reset behavior

The state transitions of the control register are now analyzed. The first property that should be created is the reset property i.e. the property that describes the reset behavior. The assume-part of the reset property contains no important state and no trigger but the reset_sequence i.e. nothing else than the reset sequence is assumed. This ensures that the reset behavior is investigated for every possible state of the design. The reset sequence is declared by set_reset_sequence at the OneSpin shell. The control state that is reached after the application of the reset sequence can be derived easily from the state transition of the control register.

```
 property reset is
 assume:
  reset_sequence;
 prove:
  at t: ctrl_reg = idle; -- state immediately after reset
 end property;
```

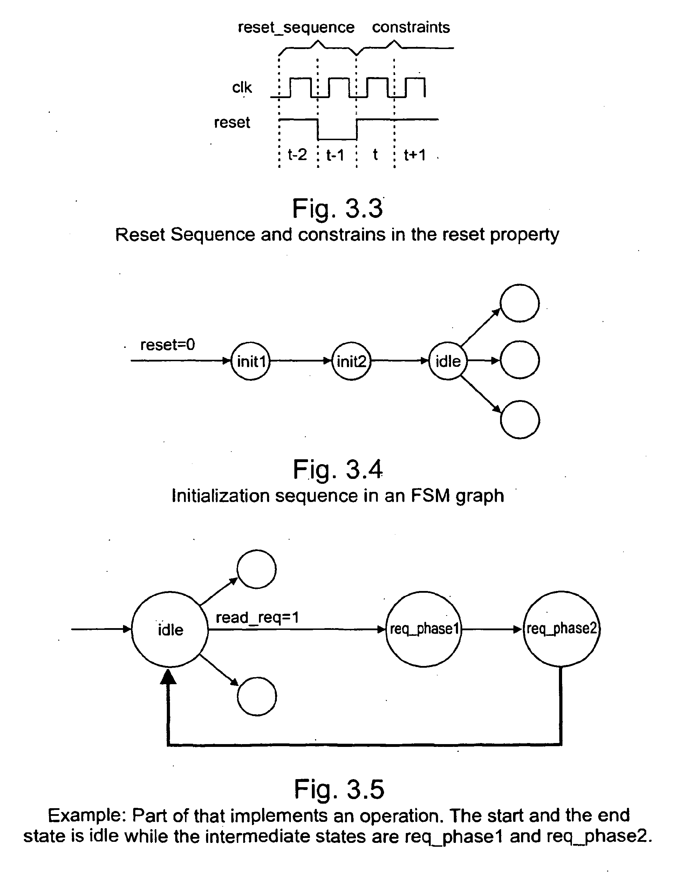

The behavior of the design after reset normally excludes the occurrence of reset. Therefore, a constraint must be defined, that describes this condition. This constraint that is typically named no_reset must be specified as dependency of all properties even for the reset property. This constraint does not contradict the assumption of reset_sequence because the constraint no_reset is assumed after the application of the reset sequence only. (Figure 3-3)

```
 constraint no_reset :=
  reset_input = '1'; -- value for inactive reset
 end constraint;

 property reset is
 dependencies: no_reset;
 assume:
 ...
```

### Figure 3-3. Reset sequence and constraints in the reset property

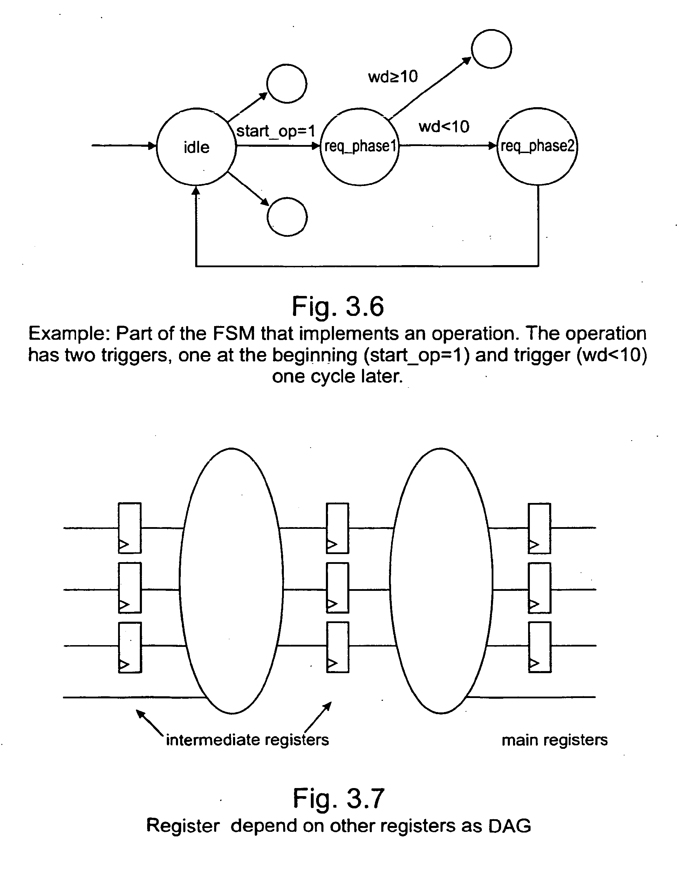

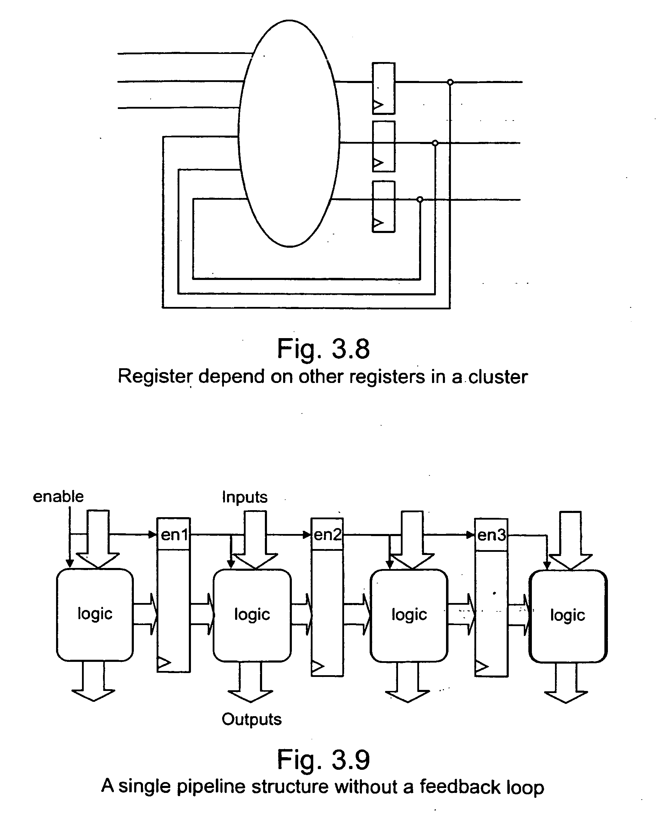

The state transition of the control register must be analyzed if the design runs an initialization sequence before normal operations are executed. This case can be recognized by the fact that there is a chain of control states after the reset state and it is not possible to deviate from this chain i.e. each control state of that chain has exactly one successor control state. (Figure 3-4) The end of the chain is likely to be the control state at the end of the reset property. Since the end state of the initialization sequence cannot be identified for sure in this stage of the verification, it is better to choose a state that seems to fit instead of investigating a long time.

### Figure 3-4. Initialization sequence in an FSM graph

The prove part of a reset property describes the control states that are reached in each cycle until the end of the initialization phase. If the design has no initialization sequence the prove part describes just the control state after application of the reset_sequence, i.e. at t. The state of the control register at the end of the reset operation is the initial version of the first important state. The right hook must be set to the time point where the reset property ends i.e. where the important state is reached.

```
 property simple_reset is
 dependencies: no_reset;
 assume:
  reset_sequence;
 prove:
  at t: ctrl_reg = idle; -- end state, important state
 right_hook: t;
 end property;
 
 property reset_with_init is
 dependencies: no_reset;
 assume:
  reset_sequence;
 prove:
  at t: ctrl_reg = init1; -- intermediate state
  at t+1: ctrl_reg = init2; -- intermediate state
  at t+2: ctrl_reg = idle; -- end state, important state
 right_hook: t+2;
 end property;
```

Before the development of the properties continues the reset property should be checked by if it really expresses the behavior of the design. Besides this final check it is very helpfull to check each intermediate version of a property. This ensures that a property really represents the design behavior. Moreover, experience has shown that debugging a property is much easier if the changes to the previous version of the property is not too wide. This mode approach is not only recommended for the reset property but for all properties that are created.

### Analysis of normal operations

In general, operations last several clock cycles, i.e. they are related to several consecutive state transitions of the control register. To write operation properties for these operations one needs to identify the start state, the end state, and the intermediate control states of the operation. The sequence of these states represent a path in the state transition of the control register.

The important state at the end of the reset property is a good starting point for the analysis of normal operations. From the analysis of the interfaces (the Section called *Design Interfaces*) and the specification (the Section called *Identification of operations*) it should be clear which operations can be started after reset and hence which operations can start in the important state at the end of the reset property. If one of these properties end in another important state, then the creation of properties should be continued with all operations that start in this important state. This procedure is repeated until the properties for all core operations are created.

Operations in general are started very often by a triggering event. This implies that there is a branch in the state transition graph at the start state of the operation that is related to the trigger. If the choice of the successor state of a control state depends on the value of a signal (often a control signal) then it is likely that this state is the starting state of an operation. If the design has an idle operation there is often a state named *idle* that is the start and end state of many operations including the idle operation. If the operation should end in the same state where it was started *loops* in the state transition are good hints to identify state sequences of the operation.

The names of the control state help to identify the sequence of the control state (the intermediate states) that are executed in each operation. For instance, states like *read* or *read_phase* often mark an intermediate state of the read operation. (Figure 3-5)

### Figure 3-5. Example: Part of the FSM that implements an operation. The start and the end state is idle while the intermediate states are req_phase1 and req_phase2.

In some designs there is no extra chain of states for each operation. Instead, there might be a branch to main groups of operations in e.g. the idle state and during the course of the read operation there is another branch in the state graph (see Figure 3-6). In this case it is necessary to collect not just the chain of control states and the condition at the beginning but also all conditions that occur during the operation. Even these extra conditions belong to the trigger condition of an operation. Note, that trigger conditions can be assumed at every timepoint in a property.

### Figure 3-6. Example: Part of the FSM that implements an operation. The operation has two triggers, one at the beginning (start_op = 1) and another trigger (wd < 10) one cycle later.

In phase one of the GapFreeVerification process the trigger expressions are derived directly from the conditions at the path of the state transitions of the control register. Whatever signal of the design (input, internal, register) is used to describe the state transition of the control state machine the trigger condition in the property uses the same signal. In phase two the root cause (design input or state of a register) of the condition is investigated.

For each identified operation an operation property is created, left_hook is set to the time point of the start state which is normally t. The right_hook is set to the time point of the end state. The start state is assumed at left_hook. All intermediate states and the end state are described in the prove part where the assigned time points depend on the order in which the states are traversed. The conditions that are necessary to run along the path are described in the assume part at the appropriate time point. In the state machine shown in Figure 3-6 for example, wd < 10 must hold one cycle after left hook i.e. at t+1.

```
 property operation is
 dependencies: no_reset:
 assume:
  at t: ctrl_reg = idle; -- start important state
  at t: start_op = '1'; -- trigger
  at t+1: wd < 10; -- trigger
 prove:
  at t+1: ctrl_reg = req_phase1; -- intermediate state
  at t+2: ctrl_reg = req_phase2; -- intermediate state
  at t+3: ctrl_reg = idle; -- end important state
 left_hook: t;
 right_hook: t+3:
 end property;
```

The initial instance of the important state contains just the assignment of the control register. In most cases, the important state becomes more complex in subsequent phases of GapFreeVerification process. It is therefore highly recommended to use Boolean macros to describe important states in all properties.

```
 macro idle_state: boolean :=
  ctrl_reg = idle;
 end macro;
 property operation is
 dependencies: no_reset;
 assume:
  at t: idle_state; -- start important state
  at t: start_op = '1'; -- trigger
  at t+1: wd < 10; -- trigger
 prove:
  at t+1: ctrl_reg = req_phase1; -- intermediate state
  at t+2: ctrl_reg = req_phase2; -- intermediate state
  at t+3: idle_state; -- end important state
 left_hook: t;
 right_hook: t+3;
 end property;
```

### Executing the Minimality Test

In addition to verifying the central control with operations, phase one also examines the sequencing of operations. This means that the important state machine (ISM) is captured for the verification and it is checked whether the hooks and the important states in the existing operations match the ISM. This is done with the help of the minimality test.

In order to capture the ISM, a completeness description is created. In phase one, the completeness description only encodes the ISM in the form of a property graph. This means that a reset property is declared and a graph is defined whose edges describe all the possible sequences of properties. Note that the relation of ISM to property graph was illustrated in Figure 1-7. Below, a sample completeness description after phase one is shown.

```
 completeness my_design is
 reset_property:
  reset;
 property_graph:
  reset, idle, read, write -> idle, read, write;
 end completeness;
```

The minimality test of the completeness analysis is started with the command:
mv> check_completeness -minimality {* *}

A failing minimality test indicates that the ISM as encoded in the property graph does not correspond to the properties. However, it is not possible to debug a minimality test like a successor or determination test; instead, one needs to analyze the two involved properties manually. Fortunately, there are only three possible causes for a failing minimality test in phase one that can be easily identified.
1. The end state of the predecessor property does not equal the start state of the successor property. This indicates that there is a spurious edge in the property graph, for example, a property starting in state normal is listed as a successor of a property ending in state special which is obviously wrong. This issue is fixed by removing the spurious edge from the property graph.
2. The right hook of the predecessor property has been chosen wrongly. If the right hook indicates a time *before* the important end state is reached, the minimality test fails since the control state verified at the right hook of the predecessor property does not correspond to the important start state of the successor. This issue is fixed by adapting the right hook of the predecessor to the time the predecessor reaches its important end state.
3. The left hook of the successor property has been chosen wrongly. If the left hook indicates a time *after* the important start state, the minimality test fails since the control state verified at the left hook of the successor does not correspond to the important start at the right hook of the predecessor property. This issue is fixed by adapting the left hook of the successor to the time it is in its important start state. Note that this case should not occur when applying the GapFreeVerification process since left hook should always equal *t*, the cycle the start state is assumed.

Note that the minimality test does not find all cases of wrong hooks. This is only achieved after phase two when the successor test has been carried out as well. In other words, examining the sequencing of operations completely requires both phase one and two.

### Designs with additional control registers

It is a common design practice to amend the main control state machine with one or more auxiliary one-bit control registers. Depending on the implementation, these registers play different roles.

In the simplest case, the register is used only during operations i.e. the register does not hand over control information from one operation to the next one. In this case it is necessary to investigate if the value of the register at the beginning of an operation is important for the course of the operation. If the operations in the main FSM only start properly if the register has a certain value, then the important state must be amended accordingly, e.g.

```
 macro idle: boolean :=
  (ctrl_reg = idle) and (tmp = '0');
 end macro;
```

Note, that this definition of an important state assumes that all operations that end in this important state set the auxiliary control register tmp to the defined value. Otherwise it could not be assumed that the auxiliary control register contains this value at the beginning of the successor operation.

If the value of the auxiliary control register at the beginning of the operation does not influence the operation then this control register does not appear in an important state.

In other cases, e.g. if different values of the auxiliary control register forces the design to run different operations or versions of operations, such an extra control register need not be regarded in phase one but in phase three as implementation register.

However, if the design contains several auxiliary control registers or if the role of these control registers is not clear the approach described in the following sections should be used. This approach leads always to the right properties.

### Designs without an explicit state machine

### Introduction

In some implementation styles, there is no main FSM that controls the design. Instead, many single registers are used, each representing a special aspect of the global control state. One register may for instance represent that an interface is active, another one that the interface is used in write direction. In other cases the design contains a main FSM but just with a very few states (not many more than 2 or 3) and besides the main FSMs there are a lot of control registers that play a crucial role in the control of the design. In both cases, the methodology described for designs with a main FSM (the Section called *Analysis of the design implementation*) can therefore not applied directly. Instead, it is necessary to apply an analysis of the control structure as it is described here, first.

This analysis consists mainly of the following steps:
1. Identify the control registers
2. Describe the state transitions of the control registers as a set of properties

These steps are explained in more detail in the following sections. After the execution of these steps phase one should be continued as described in the Section called *Analysis of the reset behavior* and the following ones. In these sections it is assumed that the state transitions of the control register is described by constructs in the HDL code. After the following procedure for designs without an explicit state machine the state transitions are described by properties in ITL. However, this does not restrict the applicability of the GapFreeVerification process.

### Identify control registers

### Analysis of register dependencies

In this analysis, all registers of the design under verification are regarded. This includes the registers of all submodules and registers of arbitrary bit widths. The command

```
 > get_signals -filter "state==true"
```

returns *all* registers of the design under verification.

Basically, the value of each register of the design is computed by some combinatorial circuits based on the values of some inputs and some registers, i.e. the value of the register depends on some inputs and/or registers. There are two typical structures in the dependency between registers:
1. Trees or DAGs (directed acyclic graph): Some signals drive intermediate registers that drive main registers. (Figure 1-7)
2. Clusters: each register depends on many other registers of the cluster, i.e. there is an interdependence of the registers. This does not mean that *each* register depend on *each* register of the cluster. (Figure 1-7)

### Figure 3-7. Register depend on other registers as DAG

### Figure 3-8. Register depend on other registers in a cluster

### Selecting the control registers

The control registers of a design are typically contained in a cluster. Large counters (rule of thumb: > 4 Bits) and other data or address registers are typically not control registers even if they are in a cluster. If it is not clear if a register is a control register or not, it is better to leave out larger registers, but include smaller ones.

Besides this structural rule, the names of the registers are an additional valuable hint. Control registers determine typically the general mode or behavior of the design and are often named after these modes.

Based on the set of control registers it is possible to identify all signals that influence the values of the control registers. All these signals are the triggers of the control registers. Control registers and signals that depend only on control registers are not trigger signals. (cf. Figure 1-7: If the cluster represents a controller then the signals at the left are the triggers.)

### Finding the state transitions

### Constructing the control states

A *control state* is an assignment of values to the control registers. If for example there are three control registers in a design that are named by active, rw, and wait, then (active=1 and rw=1 and wait=0) is a control state and (active=1 and rw=0 and wait=1) is another one.

The state transitions of the control registers describe the transitions from one control states to the control state in the next clock cycle including the condition that is necessary to trigger the transition.

The single control states are described by ITL-macros with a boolean return value in the same way as important states. The macro returns true, if the design is in the respective control state. The name of the macro should reflect the nature of the state in the same way as the enumeration values does in case of circuits containing a main FSM. If the nature is not clear, generic names like state_0, state_1 etc. should be used temporarily. Later on the macros should be renamed by more meaningful names.

```
 macro boolean control_state :=
  (<control-reg-1> = <value-reg-1>) and
  (<control-reg-2> = <value-reg-2>) and
  ...
  (<control-reg-n> = <value-reg-n>);
 end macro;
```

The determination of the set of relevant control states requires an analysis of the design. In theory, there are 2ⁿ control states (if n is the number of bits in the control registers). However, in typical designs just a very small portion of these states are relevant because most of these states cannot be reached from the reset state of the design.

Therefore, it does not make sense to define at first a macro for each state that is theoretically possible. Instead, the states are determined iteratively starting from the reset state of.the circuit. In each iteration step, reachable control states can be found as successors of already known control states. This iteration terminates, if all successors of all control states have been found.

### Constructing the reset state

The first state that will be determined is the reset state of the design. The reset state has typically the form

```
 macro boolean reset_state :=
  (<control-reg-1> = <reset-value-reg-1>) and
  (<control-reg-2> = <reset-value-reg-2>) and
  ...
  (<control-reg-n> = <reset-value-reg-n>);
 end macro;
```

The reset values of the control registers can be derived from the initialization check of check_consistency.

To check, that reset_state really describes the reset state of the control part, the reset property

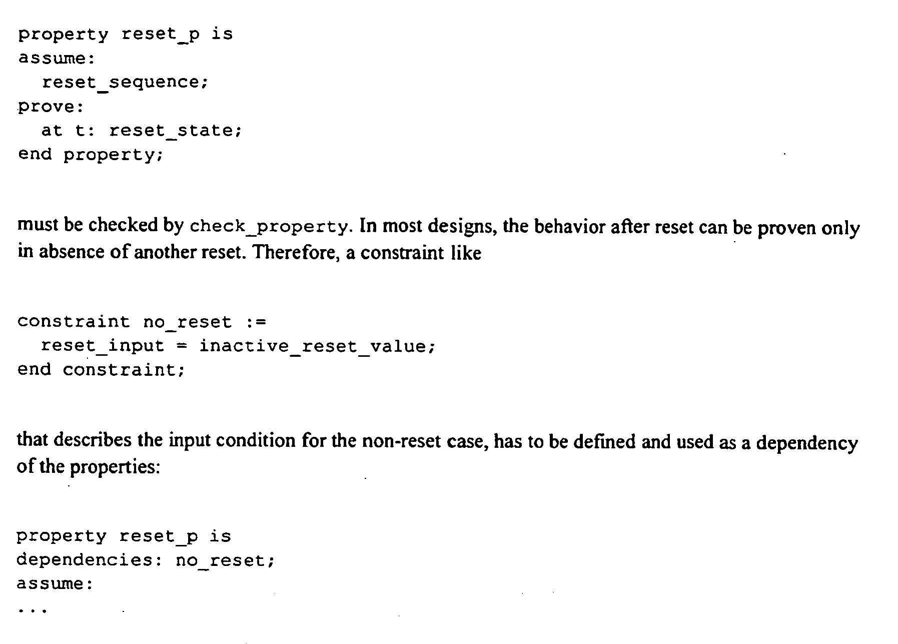

This ensures that after the application of the reset sequence the constraint no_reset is assumed when checking the property. (see also Figure 3-3)

### Constructing the successor states of the reset state

After the construction of the reset state the successor states of the reset state have to be constructed. These successor states are found by a manual analysis of the next-state functions of the control registers.

At first, it is analyzed which conditions over the trigger signals determine the state of the control registers one clock cycle after the reset state. Each control register is investigated separately for these conditions. The conditions for the whole control part is the union of the condition for the single control registers.

Let for example the design contain two control registers and the next state of <control-reg-1> depends on trigger condition cond_1 and the next state of <control-reg-2> depends on cond_2 in the reset state. Then cond_1 and cond_2 are the conditions of the whole control part. For each combination of these conditions a property is written, i.e. there are four properties having the following expression as start condition:
1. cond_1 and cond_2
2. cond_1 and not cond_2
3. not cond_1 and cond_2
4. not cond_1 and not cond_2

The properties have the shape

```
 property action_1_in_reset_state_p is
 dependencies: no_reset;
 assume:
  at t: reset_state;
  at t: cond_1 and cond_2; -- start condition 1
 prove:
  at t+1: end_state_1;
 end property;
 
 property action_2_in_reset_state_p is
 dependencies: no_reset;
 assume:
  at t: reset_state;
  at t: cond_1 and not cond_2; -- start condition 2
 prove:
  at t+1: end_state_2;
 end property;
 
 property action_3_in_reset_state_p is
 dependencies: no_reset;
 assume:
  at t: reset_state;
  at t: not cond_1 and cond_2; -- start condition 3
 ...
```

The end state is a control state and is to be described by a macro. The value of the control registers in this control state is determined by the behavior of the design. These values have to be derived manually from the design. The properties created this way should be checked by check-property to be sure that the transition of the control state is correctly derived from the design. If the values are derived wrongly, the debugging facilities of OneSpin help to determine the right values. If the end state of a transition is already defined as a macro, this macro should be used. Otherwise a new control state macro must be defined.

In some cases, there will be combinations of the conditions that are contradictory. For theses cases no property is to be created. If the start conditions are not obviously contradictory check_property will find it out even in complex situations. It generates a message that the assumptions are contradictory and sets the check result to hold_empty.

It may happen, that two properties have the same start state and the same end state but different start conditions. Then these properties can be merged into one property by a disjunction of the trigger conditions of the single properties. If possible, the trigger condition of the resulting property should be simplified.

### Constructing the remaining control states

The remaining control states are constructed in the same way as the successor states of the reset state, i.e. the algorithm described in the previous section is applied again with the only difference that end states of other properties (i.e. arbitrary control states) play the role of the reset state in this algorithm.

Each of the properties created in the process described in the recent section describes one state transition of the control part of the circuit. These properties together describe the control behavior similar to a case statement for a design with a main FSM and can be visualized in a diagram similar to Figure 1-3 (a). The verification can now be continued as described there, i.e. in the Section called *Analysis of the reset behavior.* It is not necessary to create new macros for the important states. Instead, the macros for the control states can be used as initial version of important states. However, typically only a few of the control states are needed as important states which is similar to the case of just one control register where there is an important state not for each state of the control register. The properties that are created to describe the state transitions of the control states are needed for the creation of the first operation properties in phase one, only. I.e. they are not needed in the later phases of the GapFreeVerification process.

### Operations in Pipeline Designs

The general idea of applying the concepts of important states and operations to pipeline verification has already been introduced in the Section called *Operations in Pipelines* in Chapter 1.

The operations in designs with a pipeline structure differs a little from pure controller based designs. In pure pipelined designs (Figure 1-7) the information moves only in one direction through the pipeline, i.e there is no feedback from a pipeline stage to a previous one. In the simplest case the pipeline is controlled by just one enable inputs that determines whether the pipeline should run its operation or not. Such pipelines have just one trivial important state true that can be omitted from the assume and the prove part. Beside the reset-property the pipeline has just two operations: run or idle.

### Figure 3-9. A simple pipeline structure without a feedback loop

```
 property run is
 dependencies: no_reset;
 assume:
   at t: enable = '1';
   ...
 prove:
   at t+1: en1 = '1';
   at t+2: en2 = '1';
   ...
 left_hook: t;
 right_hook: t+1;
 end property;
 
 property idle is
 dependencies: no_reset;
 assume:
   at t: enable = '0';
   ...
 prove:
   at t+1: en1 = '0';
   at t+2: en2 = '0';
   ...
 left_hook: t;
 right_hook: t+1;
 end property;
```

There is just one clock cycle between left and right hook because in each clock cycle a new pipeline operation can be started.

### Figure 3-10. A pipeline structure with a controller

More complex pipelines have a controller in the first stage that decides e.g. based on a protocol at the interface whether the pipeline operation starts or not. (Figure 1-7) The control register of the first stage together with its control logic represents a control state machine as described in the earlier sections (the Section called *Analysis of the design implementation*) of this phase of the GapFreeVerification process. Therefore, the operation properties of such a design are analyzed in the same way as the controller in non-pipelined designs. The only difference to non-pipeline designs consists in the occurrence of the output values of an operation after its right hook i.e. when the controller works already on one of the following operations. However, outputs are discussed in phase three (Chapter 5) of the GapFreeVerification process.

### Figure 3-11. A pipeline structure with a controller in the second pipeline stage

### Figure 3-12. Verification of Operations in Pipelines With a Controller in Stage 2

In other pipeline implementations the controller may be moved to the second pipeline stage. (Figure 1-7) However, the stage in which the controller is situated does not influence the analysis in the GapFreeVerification process, i.e. the controller is analyzed first, independent from the pipeline stage where it is situated. For the example shown in Figure 1-7, the controller would be analyzed first even if it is in the second pipeline stage. (see also the Section called *VCORE Processor Tutorial*)

### Figure 3-13. A pipeline structure with a stall

Especially in the area of processor designs it is common to use feedback loops in the design e.g. for stalling or register forwarding. Pipeline designs with feedback loops are discussed in Part II in *GapFreeVerification Process Manual.*

### SDRAM Controller Tutorial

### Interfaces

The SDRAM Controller has two interfaces (Figure A-1): one to the processor and one to the SDRAM. The processor initiates read or write requests. The processor interface of the SDRAM Controller is therefore a slave interface. At the interface to the SDRAM the SDRAM Controller initiates read and write actions on the SDRAM. This interface is therefore a master interface. The definition of the operation properties are based on the slave interface, i.e. the processor interface.

At the processor interface, there are read and write transactions possible. Both read and write can be run in two modes: single and burst. In addition, it is possible not to start any transaction.

### Finding the control register

The SDRAM controller contains just one register which has a range defined by an enumeration type: state of type state_t. The name of the register, the names of the values, and the implementation of the next state by a case construct suggests that state implements the main FSM of the SDRAM controller.

### Analysis of the reset behavior

After reset the control register state is in state idle. The reset property looks therefore like this:

```
 constraint no reset :=
          reset = '0';
 end constraint;
 macro idle_state : boolean :=
  (state = idle);
 end macro;
 property reset is
 dependencies: no_reset;
 assume:
  reset_sequence;
 prove:
  at t: idle_state;
 right_hook: t;
 end property;
```

The constraint no_reset describes that reset is not active. This constraint does not contradict the assumption of reset_sequence because the constraint no_reset is assumed after the application of the reset sequence only. (Figure 3-3)

The important state idle_state is described by a macro which looks cumbersomely at the first place. However, using macros for important states increases the maintainability of the important state during the further development of the operation properties.

It is recommended to check that the reset property holds for the SDRAM controller using command check_property. In this tutorial the reset property holds.

### Analysis of normal operations

To define the operations of the SDRAM controller the main FSM should be analyzed. Figure 1-7 shows the state transitions of this FSM as it can be extracted from the VHDL code.

### Figure 3-14. FSM of the SDRAM Controller

The state transition diagram shows that the service of a read or write request can be started either in the idle or in the row_act state. Moreover, this service can be divided into several elementary operations: precharge (state transition from row_act to idle), row activation (state transition from idle to row_act), and the actual read or write access (state transition from row_act back to row_act). In this tutorial each elementary operation is assumed as an operation in the sense of GapFreeVerification process. This leads to the operations of Table 3-1 which can be considered as the state transitions of the important state machine of Figure 1-7.

**Table 3-1. Operation properties of the SDRAM Controller**

| **Operation** | **Start State** | **End State** |
|---|---|---|
| reset | - | idle |
| nop | idle | idle |
| nop_ract | row_act | idle |
| precharge | row_act | idle |
| row_activation | idle | row_act |
| single_read | row_act | row_act |
| burst_read | row_act | row_act |
| single_write | row_act | row_act |
| burst_write | row_act | row_act |

### Figure 3-15. Important state machine (ISM) of the SDRAM Controller

Note, that it is possible to consider the whole service of a read or write request as operation. However, this would lead to many operation properties because three different cases must be distinguished for each read or write operation. (start in idle, start in row_act if a row activation is necessary, and start in row_act if a row activation is not necessary.)

It is recommended to start with an operation that starts in the state after reset i.e. in idle like row_activation. To start this operation, there must be either read_request_i or write_request_i active. This can be derived from the VHDL code. I.e. that (read_request_i = '1') or (write_request_i = '1') is the trigger condition of that operation property.

```
 case state is
  when idle =>
          if (read_request_i = '1' or write_request_i = '1') then
       ...
       next_state <= ra;
```

If the trigger condition holds in idle the FSM is to state ra in the next clock cycle. Since the idle state will be assumed at t by convention the state ra is reached at t+1. When the state machine is in state ra it goes in the next cycle to state row_act which is the end state of the operation. The operation property looks therefore like

```
 macro row_act_state : boolean :=
  (state = row_act);
 end macro;
 
 property row_activation is
 dependencies: no_reset;
 assume:
 at t: idle_state; -- important state
 at t: (read_request_i = '1') or -- trigger condition
         (write_request_i = '1');
 prove:
 at t+1: state = ra; -- intermediate state
 at t+2: row_act_state; -- important state
 left_hook: t;
 right_hook: t+2;
 end property;
```

The left hook is set to t which is the time point where the important state at the beginning of the operation holds. This is the same time point when this important states holds at the right hook of an arbitrary predecessor property like reset. The right hook is set to t+2 because this is the time point where the successor properties assume the important state.

Row activation is the first operation to serve a read or write request. After row activation, the actual read or write operation is carried out. From the VHDL code it can be derived that read_request_i must be active while burst_single and acc_rw must be inactive to start the single read operation in state row_act. Moreover, same_row must be asserted because the branch for precharge is taken otherwise.

```
 when row_act =>
  if <((read_request_i = '0') and (write_request_i = '0')) or
         (same_row = '0')) then
    -- precharge
    ...
  elsif ((read_request_i = '1') and (burst_single_i = '0') and
           (acc_rw = '0')) then
    -- single read
    ...
    next_state <= sr1;
```

These conditions are the triggers of the single read operation. In the single read operation the FSM is in state sr1 in first clock cycle after row_act i.e. at t+1. In the next clock cycles the FSM goes to states sr2...sr4 before it returns to row_act.

```
property simple_read is
 dependencies: no_reset;
 assume:
  at t: row_act_state; -- important state
  at t: read_request_i = '1'; -- trigger
  at t: burst_single_i = '0'; -- trigger
  at t: acc_rw = '0'; -- trigger
  at t: same_row = '1'; -- trigger
 prove:
  at t+1: state = sr1; -- intermediate state
  at t+2: state = sr2; -- intermediate state
  at t+3: state = sr3; -- intermediate state
  at t+4: state = sr4; -- intermediate state
  at t+5: row_act_state; -- important state
 left_hook: t;
 right_hook: t+5;
 end property;
```

The remaining operation properties are created in the same way as row_activation and simple_read. All properties can be found in sdram1. vhi.

### Executing the Minimality Test

After the creation of the properties it should be checked whether the left and right hook of the properties are set correctly. Therefor, it is necessary to create a completeness description that describes which property can follow which one. It is recommended to group those properties together that start or end in the same important state. The set of properties that start in a certain important state is then the successor of each property that end in this state. In addition, it is necessary to declare the reset property.

```
 completeness sdram is
 reset_property:
  reset;
 property_graph:
  to_idle_state := reset, nop, nop_ract, precharge;
  from_idle_state := nop, row_activation;
  to_row_act_state := simple_read, burst_read, simple_write, burst_write,
                                row_activation;
  from_row_act_state := simple_read, burst_read, simple_write, burst_write,
                                nop_ract, precharge;
 
  to_idle_state -> from_idle_state;
  to_row_act_state -> from_row_act_state;
 end completeness;
```

To check the consistency of the properties the minimality checks must be carried out for this completeness description by the command check_completeness -minimality {* *},

### DMA Controller Tutorial

### Interfaces

The DMA has mainly two interfaces: one to the CPU and one to the memory. The CPU interface is a slave interface because the CPU initiates the transactions (read or write configuration registers, grant the memory bus). The memory interface is a master interface since the DMA initiates the transactions (read or write of the memory). The address and data ports of the DMA are shared between the two interfaces. However, the control signals define two interfaces. This implies that the interfaces could not be used at the same time. The CPU defines via the read and write requests and the bus grant if it is active or not.

### Finding the control register

The DMA consists of two submodules: one for the data path and one for the control. In the control module is one register with an enumeration type which is likely to be the control register of the main FSM: state. Also the name of the register suggests it nature.

### Analysis of reset behavior

After reset the control register state is in state idle. The reset property looks therefore like this:

```
 constraint no_reset :=
          reset_n = '0';
 end constraint;
 
 macro idle_state : boolean :=
  (ctrl_i/state = idle);
 end macro;
 
 property reset is
 dependencies: no_reset;
 assume:
  reset_sequence;
 prove:
  at t: idle_state; -- important state
 right_hook: t;
 end property;
```

The constraint no_reset describes that reset is not active. This constraint does not contradict the assumption of reset_sequence because the constraint no_reset is assumed after the application of the reset sequence only. (Figure 3-3)

The important state idle_state is described by a macro which looks cumbersomely at the first place. However, using macros for important states increases the maintainability of the important state during the further development of the operation properties.

It is recommended to check that the reset property holds for the DMA controller using command check_property. In this tutorial the reset property holds.

### Analysis of normal operations

To define the operations of the DMA controller the main FSM should be analyzed. In idle_state are four different branches defined. The first branch is probably for a handling a read access to the configuration registers. This can be concluded from the names of the signals that are relevant for this branch: read_access_i and valid_reg_addr_s.

```
 case state is
 when idle =>
  if read_access_i = '1' then
      if valid_reg_addr_s = '1' then
        ...
        n_state <= idle;
```

This leads to the first operation property. The next state of state is idle which can be derived from the VHDL code.

```
 property read_register is
 dependencies:
  no_reset;
 assume:
  at t: idle_state; -- important state
  at t: ctrl_i/read_access_i = '1'; -- trigger
  at t: ctrl_i/valid_reg_addr_s = '1'; -- trigger
 prove:
  at t+1: idle_state; -- important state
 left_hook: t;
 right_hook: t+1;
 end property;
```

A similar operation property can by achieved for the write operation of the configuration registers. The third branch for idle_state contains a conjunction.

```
 elsif grant_i = '1' and
         (command_s(transfer_mem) = '1' or chk_parity_g /= 0) then
   ...
   n_state <= read_wait;
```

If the DMA gets a grant two different operations can start: either a transfer or a check operation starts. It can be assumed that this branch belongs to both operations. At this point a decision is needed if this branch is described by one operation property or by two operation properties: one for transfer and one for check. None of the possibilities is wrong. Since there is still no additional information just one property is created for this branch.

```
 macro read_wait_state : boolean :=
   ctrl_i/state = read_wait;
 end macro;
 
 property action_1 is
 dependencies:
   no_reset;
 assume:
    at t: idle_state; -- important
 state
    at t: (ctrl_i/command_s(0) _ '1') or (chk_parity_g =1); -- trigger
    at t: ctrl-i/grant-i = '1'; -- trigger
    at t: ctrl_i/read_access_i = '0'; -- trigger
    at t: ctrl_i/write_access_i = '0'; -- trigger
 prove:
    at t+1: read_wait_state; -- important
 state
 left_hook: t;
 right_hook: t+1;
 end property;
```

The last (else) branch for state = idle in the VHDL code treats all cases in which there is no request from the CPU. This behavior will be described by an extra operation property. In the assume-part of this property, all cases that are already treated by another property must be excluded explicitly. If this condition is wrongly described in the property, either the check of the property or the completeness check (phase four of GapFreeVerification process) will show this mistake.

```
 property idle is
 dependencies:
    no_reset;
 assume:
    at t: idle_state;
    at t: -- read/write to other location than config regs
            ((ctrl_i/read_access_i = '1' or ctrl_i/write_access_i = '1') and
              ctrl_i/valid_reg_addr_s = '0')
            or
            -- neither read/write nor transfer:
            (ctrl_i/read_access_i = '0' and
             ctrl_i/write_access_i = '0' and
             ctrl_i/grant_i = '0');
 prove:
    at t+1: idle_state;
 left_hook: t;
 right_hook: t+1;
 end property;
```

The operation property action_1 for the first part of transfer and check end in read_wait_state. The analysis of the control structure should therefore be continued at this state. From the VHDL code it can be derived that the FSM stays in this state until rdy_i becomes 1. In operation properties only a finite waiting period can be described. To ease the change of the waiting period a macro is defined for the maximum number of waiting cycles.

```
 macro max_wait : numeric := 2; end macro;
 
 If rdy_i = 1 the next state depends on a condition.
 
 if command_s(transfer_mem) = '0' and chk_parity_g /= 0 then
```

It can therefore be assumed that the two branches (then and else) describe the continuation of the check and the transfer operation, respectively. If this guess would be wrong, just the names of the operation properties do not represent the behavior actually described by the properties.

```
macro write_wait_state : boolean : :=
  ctrl_i/state = write_wait;
 end macro;
 
 property transfer_2 is
 dependencies:
  no_reset;
 for timepoints:
  t_read_ack = t + 0..max_wait waits_for ctrl_i/rdy_i = '1';
 assume:
  at t: read_wait_state; -- important state
  at t_read_ack: (ctrl_i/command_s(0) = 1) or -- trigger
                      (chk_parity_g = 0);
 prove:
  during [t+1, t_read_ack]: read_wait_state; -- intermediate state
  at t_read_ack+1: write_wait_state; -- important state
 left_hook: t;
 right_hook: t_read_ack+1;
 end property;
 
 property check_parity_2 is
 dependencies:
  no_reset;
 for timepoints:
  t_read_ack = t + 0..max_wait waits_for ctrl_i/rdy_i = '1';
 assume:
  at t: read_wait_state; -- important state
  at t_read_ack: ctrl_i/command_s(0) = '0'; -- trigger
  at t_read_ack: chk_parity_g = 1; . -- trigger
 prove:
  during [t+1, t_read_ack]: read_wait_state; -- intermediate state
  at t_read_ack+1: idle_state; -- important state
 left_hook: t;
 right_hook: t_read ack+1;
 end property;
```

The property transfer_2 ends in write_wait_state. In this state the FSM waits again until rdy_i becomes active. The FSM returns then to idle_state. This describes the third part of the transfer part.

```
 property transfer_3 is
 dependencies:
  no_reset;
 for timepoints:
  t_write_ack = t + 0..max_wait waits_for ctrl_i/rdy_i = '1';
 assume:
  at t: write_wait_state; -- important state
 prove:
  during [t+1, t_write_ack]: write_wait_state; -- intermediate state
  at t_write_ack+1: idle_state; -- important state
 left_hook: t;
 right_hook: t_write_ack+1:
 end property;
```

Now, all control states are investigated. Phase four of the GapFreeVerification process will show if an operation property would be missing.

### Executing the minimality test

After all properties are created and checked it should be tested by the minimality test if the properties fit together. It is therefor needed to create a completeness description. This description declares the reset property and describes which operation property can be the successor of each operation property. The successor properties of a property is defined by the important states. A property can be the successor of another property if the predecessor property ends in the same important state as the successor property starts. To ease the description a set of simple properties is defined that starts and ends in idle_state. It is assumed that the properties check_parity_1, transfer_1 and transfer_2 can be continued by check_parity_2, transfer_2 and transfer_3 only. If this assumption would not be true the completeness check in phase four of GapFreeVerification process would fail.

```
 completeness dma is
 reset_property: reset;
 property_graph:
  simple := idle, write_register, read_register;
  reset, simple, check_parity_2, transfer_3 -> simple, action_1;
  action_1 -> check_parity_2, transfer_2;
  transfer_2 -> transfer_3;
 end completeness;
```

### VCORE Processor Tutorial

### Design interfaces

### Figure 3-16. Schematic of VCORE

VCORE is a processor that has two interfaces: one to the instruction and one to the data memory. For both interfaces VCORE is the master, i.e. VCORE controls when an instruction is fetched from the instruction memory and when data is read or written. Note, that the interface to the data memory has a control input dmem_valid_i. However, the transactions at that interface are initiated by the VCORE. dmem_valid_i controls just the end of the memory access transaction.

### Operation properties

### Finding the control register

VCORE is implemented in a pipeline architecture with a non-trivial control structure. curr_mem_state is a register that contains values that are described by parameters. It is therefore the first candidate for a control register. Having Figure 3-11 in mind, registers of a pipeline, that are feed back to a control register of the same pipeline stage are also candidates for control registers. In VCORE, ex_branch fulfills this condition. Note that ex_op_b, dec_PC, or ex_PC do not belong to this category because they are data registers. Because VCORE has two control registers, the important state must be a conjunction of both control registers.

### Analysis of the reset behavior

From the source code of the VCORE it becomes obvious that curr_mem_state == MEM_IDLE and ex_branch == 0 after reset.

```
constraint no_reset :=
          reset_n;
 end constraint;
 
 property reset;
 dependencies:
  no_reset;
 assume:
  reset_sequence;
 prove:
  at t: (current_mem_state == MEM_IDLE) &&
         !ex_branch;
 end property;
```

An operation property should describe the execution of an instruction. Since each instruction can follow each instruction it is expected that there is just one important state that holds at the beginning of the execution of each instruction. This state should also be the state after reset. There is some freedom which state is chosen as the start state of the execution of an instruction. Since an instruction can stay for a number of clock cycles in the decode stage and the number of cycles is determined by the previous instruction it is a good idea to define the start state as the state where the instruction moves to the execution stage in the next cycle. Note, that it is not possible to corrupt the verification in the GapFreeVerification process by choosing an inappropriate definition of the important states. In the worst case the operation properties cannot be extended to describe the data operations in phase 2 and 3. In this case, phase 1 must be repeated with a redefined important state. Immediately after reset it is not possible for an instruction to be moved to the execution stage because dec_valid is not active. Therefore, dec_valid must become a part of the important state. The prove part of the reset property is extended by the important state that holds at t+1.

```
 macro boolean important_state_1 :=
  (current_mem_state == MEM_IDLE) &&
  !ex_branch &&
  dec_valid;
 end macro;
 
 property reset;
 dependencies:
  no_reset;
 assume:
  reset_sequence;
 prove:
  at t: (current_mem_state == MEM_IDLE) && // intermediate state
             !ex_branch &&
             !dec_valid;
  at t+1: important_state_1;
 right_hook: t+1;
 end property;
```

### Basic instructions

Since VCORE is a pipeline processor, an instruction normally starts when the previous instruction is not yet finished. For the verification the state of the processes after the end of an instruction is therefore not interesting. Instead, the state of the processor when it is ready to start the next instruction is of interest. Since arithmetic operations of VCORE do not cause a pipeline stall or cancel its successor instruction, an arithmetic instruction starts just one clock after the arithmetic instruction.

```
property inst_add;
 dependencies:
          no_reset;
 assume:
  at t: important_state_1;
  at t: instruction_word_reg[15:11] == 5'h01; // trigger: opcode of "add"
 prove:
  at t+1: important_state_1;
 left_hook: t;
 right_hook: t+1; // the next operation can start here
 end macro;
```

A similar property can now be written for each arithmetic instruction. It can be expected that the only difference between the arithmetic operations is the kind of the arithmetic that is executed. It is therefore recommended to put all arithmetic operations into a property macro that is parameterized with the opcodes of the operations. This property macro is then instantiated for each arithmetic operation. This style of writing increases the maintainability of the code.

```
 macro property inst_arith(unsigned instr_opc) :=
 dependencies:
          no_reset;
 assume:
  at t: important_state_1;
  at t: instruction_word_reg[15:11] == instr_opc; // trigger
 prove:
  at t+1: important_state_1;
 left_hook: t;
 right_hook: t+1;
 end macro;
 
 property inst_not;
 inst_arith(5'h00);
 end property;
 
 property inst_add;
 inst_arith(5'h01);
 end property;
 
 property inst_sub;
 inst_arith(5'h02);
 end property;
```

### Branch instructions

For the branch operation two different cases must be distinguished: the branch is taken or not taken. VCORE implements a speculative execution strategy. It is assumed that a branch is not taken. If this prediction is not true the instruction after the branch is canceled and the VCORE continues with the instruction at the branch target address.

In the GapFreeVerification process it is not necessary to verify the cancellation explicitly. Instead, the property shows that the next regular operation is the one that is fetched two cycles after the branch. Note that the verification of the correct address for the instruction memory part of phase 3 and will be explained there. Moreover, in phase 3 it will be shown that the canceled instruction will not affect the visible registers of VCORE.

```
 property inst_beqz_mispredict;
 dependencies:
          no_reset;
 assume:
  at t: important_state_1;
  at t: instruction_word_reg[15:11] == 5'b00111;
  at t+1: ex_result[0] == 1; // condition that the branch is taken
 prove:
  // intermediate states
  at t+1: current_mem_state == MEM_IDLE;
  at t+1: ex_branch;
  at t+1: dec_valid;
 
  at t+2: important_state_1;
 left_hook: t;
 right_hook: t+2;
 end property;
```

If the branch is not taken it cannot be shown by check_property that important_state_1 is reached one cycle after the start of the operation. Basically, this might be caused by a reachability issue, a too strictly chosen important state, or a bug that occurs after correctly predicted branch. The second case can be investigated with the lowest effort and should therefore assumed first.

In the first step an additional important state (important_state_2) is created that represents the control state after the correctly predicted branch. From the counter example it can be derived that it is possible to reach the following state:

```
 macro boolean important_state_2 : :=
     (current_mem_state == MEM_IDLE) &&
     ex_branch &&
          dec_valid;
 end macro;
```

It can be shown that important_state_2 holds always at right_hook of property inst_beqz. Therefore, it is unlikely that this behavior is caused by a bug. It would be more typical for a bug that the state at the right hook is not always the same.

It must now be investigated if all instructions can start from important_state_2 in the same way as from important_state_1 i.e. if the same important state is reached even if the operation starts in important_state_2 instead of important_state_1. The assume part of the properties are therefor extended such that the operations start in one of the important states:

```
 ...
 assume:
 either
  at t: important_state_1;
 or
  at t: important_state_2;
 end either;
 at t: instruction_word_reg[15:11] == ...
```

However, it cannot be shown that the arithmetic operations can start in important_state_2. This is caused by an reachability issue in important_state_2. The counter-examples show that register ex_op_a is zero at left hook if important_state_2 is assumed. Since important_state_2 is reached after a mistaken branch only, ex_op_a is always non-zero in this situation. important_state_2 is therefore extended:

```
 macro boolean important_state_2 :=
     (current_mem_state == MEM_IDLE) &&
    ex_branch &&
     (ex_op_a != 0) &&
          dec_valid;
 end macro;
```

Property inst_beqz can still be proven with this definition of important_state_2. Moreover, all properties can now be proven even if they start in important_state_2. (see example file vcorela.vli)

Since each operation can start either in important_state_1 or important_state_2, there is no need to distinguish these two important states, i.e. important_state_2 can be merged by disjunction into important_state_1:

```
 macro boolean important_state_1 :=
     (current_mem_state == MEM_IDLE) &&
     (!ex_branch | | (ex_op_a a != 0)) &&
          dec_valid;
 end macro;
 
 macro property inst_arith(unsigned instr_opc) :=
 dependencies:
          no_reset;
 assume:
  at t: important_state_1;
  at t: instruction_word_reg[15:11] == instr_opc;
 prove:
  at t+1: important_state_1;
 left_hook: t;
 right_hook: t+1;
 end macro;
 
 property inst_beqz;
 dependencies:
          no_reset;
 assume:
  at t: important_state_1;
  at t: instruction_word_reg[15:11] == 5'b00111;
  at t+1: ex_result[0] == 0;
 prove:
  at t+1: important_state_1;
 left_hook: t;
 right_hook: t+1;
 end property;
 
 property inst_beqz_mispredict;
 dependencies:
          no_reset;
 assume:
  at t: important_state_1;
  at t: instruction_word_reg[15:11] == 5'b00111;
  at t+1: ex_resulte[0] == 1;
 prove:
  // intermediate states
  at t+1: current_mem_state == MEM_IDLE;
  at t+1: ex_branch;
  at t+1: dec_valid;
 
  at t+2: important_state_1;
 left_hook: t;
 right_hook: t+2;
 end property;
 ...
```

### Load and store instructions

The operation properties for arithmetic or branch instructions have a fixed duration, i.e. the number of cycles between the left and the right hook is determined by the instruction and the state of the processor. The memory instructions of VCORE have a different behavior. They send a read or write request to the memory and wait until the memory asserts dmem_valid_i to show that the memory transaction has finished. The VCORE has to stall the pipeline until the end of the memory transaction.

This wait is treated in the GapFreeVerification process by the definition of a time point that represents the end of the transaction. This time point is called t_nostall is this tutorial. There is no upper bound for the duration of the memory transaction specified. It is therefore necessary in the GapFreeVerification process to introduce a finite bound (4 in this tutorial) and a constraint that restricts the behavior at the memory interface accordingly.

```
 macro numeric max_wait_dmem := 4; end macro;
 
 property inst_ld;
 dependencies:
          no_reset;
 for timepoints:
          t_nostall=t+1..max_wait_dmem waits_for dmem-valid-i;
 assume:
  at t: important_state;
  at t: instruction_word_reg[15:11] == 5'b00100;
 prove:
  // intermediate state
  during [t+1, t_nostall-1]: mem_stall;
  during [t+1, t_nostall-1]: !ex_mispredict;
  during [t+1, t_nostall-1]: dec_valid;
 
  at t_nostall: important_state;
 left_hook: t;
 right_hook: t_nostall;
 end property;
```

The instruction after the memory instruction can start when dmem_valid_i becomes active i.e. at t_nostall. However, at this time point curr_mem_state is not yet in MEM_IDLE such that it cannot be proven that important_state_1 is reached. Following the same strategy as for the branch instruction (the Section called *Branch instructions*) new important states are introduced for the state of the load and store operation at right hook. These important states contain the differing assignment to curr_mem_state and the condition about dmem_valid_i. dmem_valid_i is asserted at the end of each memory access and must be assumed at the beginning of the successor operation. If dmem_valid_i would not be assumed in the important state, the important state would not only describe the possible start state of a new instruction but also the waiting states of the memory instructions. (cf. the Section called *Non-Trivial Abstraction of FSM* in Chapter 1)

```
 macro boolean important_state_3 :=
      (current_mem_state == MEM_READ) &&
     dmem_valid_i &&
      (!ex_branch | | (ex_op_a a != 0)) &&
         dec_valid;
 end macro;
 
 macro boolean important_state_4 :=
      (current_mem_state == MEM_WRITE) &&
     dmem_valid_i &&
      (!ex_branch | | (ex_op_a != 0)) &&
          dec_valid;
 end macro;
```

After proving that the load and store operation really end in important_state_3 and important_state_4, resp. it must be checked that all operations can be started in these important states (see vcore1c.vli).

```
 ...
assume:
 either
   at t: important_state_1;
 or
 at t: important_state_3;
 or
  at t: important_state_4;
 end either;
 at t: instruction_word_reg[15:11] == ...
```

Since this check is successful for all properties the important states can be merged by disjunction into important_state.

```
macro boolean important_state : :=
     ((current_mem_state == MEM_IDLE) | |
       ((current_mem_state == MEM_READ) && dmem_valid_i) | |
       ((current_mem_state == MEM_WRITE) && dmem_valid_i == 1)) &&
     (!ex_branch | | (ex_op_a != 0)) &&
          dec_valid;
 end macro;
```

It can now be shown that all operations start and end in one and the same important state (see vcore1d.vli) which fits to the expectation that each instruction can be executed by VCORE after an arbitrary predecessor instruction.

```
 ...
 assume:
  at t: important_state;
  at t: instruction_word_reg[15:11] == ...
 prove:
  at t...: important_state;
  ...
```

### Operation properties (alternative version)

### Finding the control register

An operation property should describe the execution of an instruction. Since each instruction can follow each instruction it is expected that there is just one important state that holds at the beginning of the execution of each instruction. This state should also be the state after reset. There is some freedom which state is chosen as the start state of the execution of an instruction. Since an instruction can stay for a number of clock cycles in the decode stage and the number of cycles is determined by the previous instruction it is a good idea to define the start state as the state where the instruction moves to the execution stage in the next cycle. Note, that it is not possible to corrupt the verification in the GapFreeVerification process by choosing an inappropriate definition of the important states. In the worst case the operation properties cannot be extended to describe the data operations in phase 2 and 3. In this case, phase 1 must be repeated with a redefined important state.

From the Verilog source code the condition for the entry of an instruction to the execute stage can be derived. This condition is the first version of the important state.

```
always @ (posedge clk or negedge reset_n)
           
      if (!reset_n)
      ...
        else if (!mem_stall)
           begin
           ...
                       if (dec_valid && !ex_mispredict)
                               case (opcode)
                                  NOT:
                                          begin
                                              ex_write_reg <= 1;
                                              ex_dest_reg <= regD;
                                              ex_not <= 1;
                                          end
 ...
 
 macro boolean important_state : :=
  !mem_stall &&
  !ex_mispredict &&
 dec_valid:
 end macro;
```

This important state deviates from the kind that is explained in the Section called *Analysis of the design implementation.* There is not just one control register in the important state but three. However, the concatenation of the signals in the important state can be seen as one register:

```
 macro boolean important_state : :=
  (mem_stall, ex_mispredict, dec_valid) == 3'b001;
 end macro;
```

The signals mem_stall and ex_mispredict are not registers but internal signals. However, this does not corrupt the verification. If the important state would not be defined appropriately either the verification of the properties or the verification of the completeness would fail.

### Analysis of the reset behavior

The important state does not hold immediately after reset because the reset value of dec_valid is zero. However, important_state holds one cycle after reset, i.e. at t+1. It can be expected that VCORE needs the first clock cycle after reset for initialization. In phase 3 it will be shown that VCORE does not run an operation in the first cycle after reset.

```
 constraint no_reset :=
          reset_n;
 end constraint;
 
 property reset;
 dependencies:
  no_reset;
 assume:
  reset_sequence;
 prove:
  at t: (current_mem_state == MEM_IDLE) && // intermediate state
             !ex_branch &&
             !dec_valid;
  at t+1: important_state;
 right_hook: t+1;
 end property;
```

### Basic instructions

Since VCORE is a pipeline processor, an instruction normally starts when the previous instruction is not yet finished. For the verification the state of the processes after the end of an instruction is therefore not interesting. Instead, the state of the processor when it is ready to start the next instruction is of interest. Since arithmetic operations of VCORE do not cause a pipeline stall or cancel its successor instruction, an arithmetic instruction starts just one clock after the arithmetic instruction.

```
 property inst_add;
 dependencies:
          no_reset;
 assume:
  at t: important_state;
  at t: instruction_word_reg[15:11] == 5'h01; // trigger: opcode of "add"
 prove:
  at t+1: important_state;
 left_hook: t;
 right_hook: t+1; // the next operation can start here
 end macro;
```

A similar property can now be written for each arithmetic instruction. It can be expected that the only difference between the arithmetic operations is the kind of the arithmetic that is executed. It is therefore recommended to put all arithmetic operations into a property macro that is parameterized with the opcodes of the operations. This property macro is then instantiated for each arithmetic operation. This style of writing increases the maintainability of the code.

```
 macro property inst_arith(unsigned instr_opc) :=
 dependencies:
          no_reset;
 assume:
  at t: important_state;
  at t: instruction_word_reg[15:11] == instr_opc; // trigger
 prove:
  at t+1: important_state;
 left_hook: t;
 right_hook: t+1;
 end macro;
 
 property inst_not;
 inst_arith(5'h00);
 end property;
 
 property inst_add;
 inst_arith(5'h01);
 end property;
 
 property inst_sub;
 inst_arith(5'h02);
 end property;
```

### Branch instructions

For the branch operation two different cases must be distinguished: the branch is taken or not taken. VCORE implements a speculative execution strategy. It is assumed that a branch is not taken. If this prediction is not true the instruction after the branch is canceled and the VCORE continues with the instruction at the branch target address. The logic for the misprediction and the program counter shows that ex_result [0] decides whether a branch is taken:

```
 assign next_PC = ex_mispredict ? (ex_PC,1'b0) + ex_op_b : dec_PC + 2;
 assign ex_mispredict = ex_branch && ex_result[0];
```

In the GapFreeVerification process it is not necessary to verify the cancellation explicitly. Instead, the property shows that the next regular operation is the one that is fetched two cycles after the branch. Note that the verification of the correct address for the instruction memory is part of phase 3 and will be explained there. Moreover, in phase 3 it will be shown that the canceled instruction will not affect the general purpose registers of VCORE.

```
 property inst_beqz_mispredict;
 dependencies:
          no_reset;
 assume:
  at t: important_state;
  at t: instruction_word_reg[15:11] == 5'b00111;
  at t+1: ex_result[0] == 1; // condition that the branch is taken
 prove:
  // intermediate state
  at t+1: !mem_stall;
  at t+1: ex_mispredict;
  at t+1: dec_valid;
 
  at t+2: important_state;
 left_hook: t;
 right_hook: t+2;
 end property;
```

If the branch is not taken the behavior of the branch instruction is the same as a nop.

```
 property inst_beqz;
 dependencies:
          no_reset;
 assume:
  at t: important_state;
  at t: instruction_word_reg[15:11] == 5'b00111;
  at t+1: ex_result[0] == 0; // trigger
 prove:
  at t+1: important_state;
 left_hook: t;
 right_hook: t+1;
 end property;
```

### Load and store instructions

The operation properties for arithmetic or branch instructions have a fixed duration, i.e. the number of cycles between the left and the right hook is determined by the instruction and the state of the processor. The memory instructions of VCORE have a different behavior. They send a read or write request to the memory and wait until the memory asserts dmem_valid_i to show that the memory transaction has finished. The VCORE has to stall the pipeline until the end of the memory transaction.

This wait is treated in the GapFreeVerification process by the definition of a time point that represents the end of the transaction. This time point is called t_nostall is this tutorial. There is no upper bound for the duration of the memory transaction specified. It is therefore necessary in the GapFreeVerification process to introduce a finite bound (4 in this tutorial) that restricts the behavior at the memory interface accordingly.

The instruction after the memory instruction can start when dmem_valid_i becomes active i.e. at t_nostall.

```
 macro numeric max_wait_dmem := 4; end macro;
 
 property inst_ld;
 dependencies:
          no_reset;
 for timepoints:
          t_nostall=t+1..max_wait_dmem waits_for dmem_valid_i;
 assume:
  at t: important_state;
  at t: instruction_word_reg[15:11] == 5'b00100;
 prove:
  // intermediate state
  during [t+1, t_nostall-1]: mem_stall;
  during [t+1, t_nostall-1]: !ex_mispredict;
  during [t+1, t_nostall-1]: dec_valid;
 
  at t_nostall: important_state;
 left_hook: t;
 right_hook: t_nostall;
 end property;
```

The verification of this property fails. In the counter-example the value of current_mem_state at t is 3. However, this value is never assigned to current_mem_state i.e. that the start state of the property is not reachable. To fix this problem, the important state is extended by the reachability information that current_mem_state ! = 3 which let the property for the memory instructions hold. Note, that all properties must be reproven because it must now be shown that at the right hook of each operation this stricter important state holds.

```
 macro boolean important_state :=
  (current_mem_state != 3) &&
  !mem-stall &&
  !ex_mispredict &&
  dec_valid;
 end macro;
```

### Executing the minimality test

At the end of phase 1 it should be checked if the left and right hook of the different operation properties do really fit together. Therefor, a completeness description is created that contains just the property graph and declares the reset property.

```
 completeness vcore;
 reset_property:
          reset;
 property_graph:
          insts := inst_not, inst_add, inst_sub, inst_ld, inst_st,
                                inst_beqz, inst_beqz_mispredict, inst_nop;
          reset, insts -> insts;
 end completeness;
```

Since the minimality check holds it can be concluded that the operation properties fit together and that the left and right hook is set correctly. Note, that most of the other completeness checks will not hold. However, this does not affect the intermediate verification result of phase 1.

### Notes

1. J. Bergeron, E. Cemy, A. Hunter, A. Nightingale: Verification Methodology Manual for SystemVerilog, Springer, 2006

### Chapter 4. Phase Two: Verification of Full Control

### Overview

- visible register mappings
- protocols
- reachability
- important state refinement
- assertions

### Introduction

In phase two of the GapFreeVerification process, the verification of the central control of phase one is extended to the verification of the *full* control. Note that the extended functionality is still ignored, that is, the existing operations from phase one are only refined. Phase two still ignores the data path and focuses on the control part of the design; however, the influence of inputs and visible registers on the control is actually verified in phase two. To be more precise, the goal of this phase is to base the triggers and the timing of the operations from phase phase one only on the visible registers and inputs of the design. In terms of operation properties, this means that phase two focuses only on the assume part and the for timepoints part. An operation property after phase two is illustrated in Figure 4-1.

### Figure 4-1. Operation Property after Phase Two

Phase two has mainly three steps:
1. identify the visible registers of the specification as far as they are used in order to trigger operations and capture their mapping to the registers in the implementation
2. relate the triggers of the operation properties of phase one to the visible registers and to design inputs
3. add the inputs and visible registers used in the triggers to the completeness description

Phase two terminates once the full control and sequencing of the core functionality has been captured in operations and verified. Sequencing in phase two means that the triggers of all the core functionality operations have been described only in terms of inputs and visible registers as in the specification. This is checked with the successor test of the completeness analysis. Note that describing something only in terms of visible registers and inputs is called *determining* in the GapFreeVerification process. Hence, the goal of phase two is simply to determine the trigger and timing of each operation. The termination of phase two is certified by 360 MV in case the following conditions are met:
- The operation properties all hold on the RTL.
- The ISM for the core functionality is represented in the property graph of the completeness description.
- Only inputs of the design are listed as inputs in the completeness description.
- The visible registers used in order to trigger operations are listed as local determination requirements in the completeness description.
- All successor tests hold as well as the reset assumption test, a special kind of successor test for the reset property.

The remainder of this chapter is structured as follows: the Section called *Visible Register Mappings* and the Section called *Protocols* introduce visible register mappings and protocol verification in the GapFreeVerification process. Afterwards, the main working steps in phase two are described. the Section called *Inputs at trigger time point* shows how to base triggers on inputs of the design. the Section called *Implementation registers* describes how the mapping of visible register to implementation registers for the trigger of *one* operation property is identified locally. Finally, the Section called *Introducing Visible Registers* describes how to use only a single mapping for a visible register in *all* the operation properties. Checking the sequencing of the operations by executing and debugging the successor test in order to achieve termination of phase one is introduced in the Section called *Executing the Successor Test.* This concludes the description of phase two of the GapFreeVerification process.

After the description of phase two, the Section called *Reachability* introduces a general problem in the verification of the GapFreeVerification process from phase two onwards, namely reachability. In addition, this section also describes various ways to deal with reachability problems.

The final three chapters are a tutorial for phase two for the three example designs for the GapFreeVerification process, the Section called *SDRAM Controller Tutorial,* the Section called *DMA Controller Tutorial,* and the Section called *VCORE Processor Tutorial.*

### Visible Register Mappings

When the specification refers to some input or output signals, the correspondence between this input or output and a concrete signal in the implementation is trivial since the input or output signals listed in the specification correspond to an input or output signal of the RTL. In other words, they can be identified by name alone. For visible registers, however, the situation is slightly more complex: while these registers are observable in the specification, the way they are actually realized is implementation-dependent. Therefore, *finding* visible registers in the implementation is not a trivial task, in particular in the presence of design optimizations like pipelining and forwarding (see the Section called *Introducing Visible Registers*). This section therefore focuses on mapping the visible registers of the specification to registers in the implementation.

Since the actual location of a visible register is implementation-dependent and the high-level view of operations should be as close to the specification as possible, we recommend to introduce a *macro* whose name equals the name of the visible register in the specification and hide the mapping of that visible register to actual signals in the implementation inside the definition of this macro as shown below. In this way, the high-level property just argues about the visible register like the specification and the mapping of visible registers to low-level signals that is implementation-dependent is cleanly separated. Hence, it becomes less effort to adapt the verification code to a new revision of the design because only the mapping inside the macro needs to be adapted, not the high-level property as well.

```
 macro visible_reg: unsigned :=
          my_hierarchy/implementation_reg;
 end macro;
```

In general, it is possible to implement a visible register by several registers. The relation between the registers in the implementation and the visible register must be described in this case by an expression. Consider for example a configuration register where some bits are not used at all, the used bits are grouped according to the functionality they influence, and the different groups of visible register bits are actually implemented in different modules of the design close to the code they actually influence. In this case, a visible register mapping for such a distributed register needs to collect all the different signals for the different bits of the configuration register and concatenate them; note that unused bits have to be added explicitly as 0 to the concatenation. This is illustrated below with a configuration register split between a master and a slave side module and three unused bits in between these two parts. However, this is still a simple visible register mapping since it only consists of a *concatenation* of signals.

```
 macro conf_reg: unsigned :=
          i_master/cfg_reg & "000" & i_slave/cfg_reg;
 end macro;
```

The signals of the design that are used in the macro are called *implementation registers.* Note, that a signal plays the role of an implementation register only at the time point when the data is transferred from one operation to the next one. During an operation the same signal may store other data.

The choice of the macro name of a visible register should reflect the name of the visible register in the specification. In case there are several visible registers that are accessed in the same way, one should try to reflect this in the verification by introducing a *parameterized* macro where the specific visible register is chosen by the value of the parameter. This ensures a uniform treatment of all these visible registers in the verification similar to the specification. Examples for such sets of visible registers are:

A controller with a status, command, and data register that are accessible via different addresses. In other words, at address addr_cmd defined in the specification, the visible register cmd can be read and written; similarly for the other two registers. In this case, a macro cfg_reg is introduced which takes the address of the register as parameter. This macro just returns the cmd register in case the address matched addr_cmd and the other two visible registers at their respective addresses. For any other address, the macro returns an arbitrary value. In this way, the command register is denoted by cfg_reg (addr_cmd) in the verification, thus making it clear that the command register is actually the register that is accessed at addr_cmd.

```
 macro cfg_reg(addr: unsigned): unsigned :=
            case addr is
                       when addr_cmd => implementation_cmd_reg;
                       when addr_status => implementation_status_reg;
                       when addr_data => implementation_data_reg;
            -- non-existing registers return 0 in specification
                       when others => 0;
            end case;
 end macro;
```

Register files of processors that result in a macro with a parameter corresponding to the index of the register. Hence, data_reg (0) returns the current value of data register 0, typically denoted as D [0] in the specification. The implementation of such a register file is typically in an array; in case of an implementation as a set of separate registers, a case statement over all the possible values of the index is needed as illustrated in the second example below. Note that for pipelined processors, the visible register mapping is typically more complex as outlined in the Section called *Visible Register Mapping in Pipelines.*

```
 macro data_reg(index: unsigned): unsigned :=
            reg_update/implementation_reg_file[i];
 end macro;
  macro data_reg(index: unsigned): unsigned :=
            case index is -- collect separate registers to make it look like
  array
                       when 0 => reg_update/implementation_reg_0;
                       when 1 => reg_update/implementation_reg_1;
                       when 2 => reg_update/implementation_reg_2;
                       when 3 => reg_update/implementation_reg_3;
                       when 4 => reg_update/implementation_reg_4;
                       when 5 => reg_update/implementation_reg_5;
                       when 6 => reg_update/implementation_reg_6;
                       when 7 => reg_update/implementation_reg_7;
                       when others => undefined(32); -- non-existing registers
  are undefined
            end case;
  end macro;
```

In the design, a visible register can be implemented by different registers. These registers use sometimes different timepoints (relative to left_hook/right_hook) to transfer the data from one operation to the next one. This offset must be included in the macro of the visible register. In general, there is an offset to right_hook/left _hook for each occurrence of a design signal in the visible register macros. Note that this offset might be positive or negative, i.e. the information can be available in the implementation signal some clock cycles before or after right_hook/left_hook. This offset is expressed using prev() and next() operators in the macro.

```
 macro conf_reg: unsigned :=
    next(i_master/cfg_reg) & -- right/left_hook + 1
     "000" &
    prev(i_slave/cfg_reg); -- right/left_hook - 1
 end macro;
```

Note, that the declaration in the local determination requirements relates the visible register to the left_hook/right_hook of the property while the next() and prev() operators relate the timepoint of the data handover in an implemenation register to left_hook/right_hook.

It must be noted that the definition of visible registers strongly influences the result of the verification, i.e. a wrongly chosen visible register lets the verification fail. However, if the verification succeeds for a certain definition of visible registers (i.e. the properties hold and the completeness is shown) then the verification is done. the Section called *Soundness of Visible Register Verification* in Chapter 5 explains why a complete verification with the GapFreeVerification process cannot be compromised by a wrong choice of visible register mappings.

It cannot be derived from a property which entries of the assume or prove part refer to visible registers. Therefore, these registers must be declared in the *local* determination requirement. There are two types of visible registers:
- *General visible registers* transfer data between all properties i.e. each operation property writes a value in the visible register or ensures that the value keeps constant. The transfer timepoint of those visible registers is declared in the local_determination_requirement of the completeness description.
- *Local visible registers* that transfer data between some pairs of properties i.e. only some properties write a value in the visible register. Note that all properties on the left side of an arrow in the property graph must write the same visible registers, because the succeeding operation properties rely on the availability of the value in the visible register. The transfer timepoint of those visible registers is declared in the local_determination_requirement of each property that writes the value to the visible register.

```
 local_determination_requirements:
 at right_hook: determined(visible_register_1);
 at right_hook: determined(visible_register_2);
 ...
```

During phase two, only the visible registers that are used in triggers for operation actually have to be added as local determination requirements; in addition, the check that these visible registers are actually determined by the operations is only carried out during phase three of the GapFreeVerification process. Nevertheless, without adding the local determination requirements for those visible registers that appear in the computation of the trigger of an operation, the final completeness analysis carried out in phase two, namely the successor test, will fail.

### Visible Register Mapping in Pipelines

In case the update of a visible register is *pipelined* in the implementation and forwarding takes place when reading the visible register, the register mapping may be more complex. If a visible register is simply updated with one cycle delay because of one pipeline stage (Figure 4-2), the visible register macro can simply be mapped to the value of the corresponding implementation signal *in the next cycle* since it is sure that after this one additional cycle, the signal implementing the visible register is actually updated. Using this visible register macro also when the visible register is read ensures that the implementation indeed forwards the value to be written from the pipeline register. Thus, the verification of visible register with a simply pipelined implementation can be accomplished by just using next in the visible register mapping.

```
 macro visible_reg: unsigned :=
         next(implementation_reg);
 end macro;
```

### Figure 4-2. A simple pipeline

Note that the arguments why a complete verification with visible register mappings is fail safe in the Section called *Soundness of Visible Register Verification* in Chapter 5 is *independent* of the actual content of the mapping; hence, the verification cannot be compromised by using next inside a visible register mapping.

The above remark about pipelined updates of visible registers also applies to many memory controllers. There, stores to a memory are often buffered in an intermediate register before actually writing the data to the memory. A succeeding load then does not necessarily access the memory, but first checks whether the store in the buffer register can satisfy its request. If so, it just returns the data of the store. Although this may look different, such an implementation in a memory controller is nothing but a pipelining of a store with corresponding forwarding and hence, it is treated accordingly in the GapFreeVerification process.
**Note**: The concept *implementation registers* is used in this section in a different way in comparison to the previous sections!
Note: we should perhaps have an example other than vcore that writes configuration registers with one "delay" register and forwards from this delay register, this would illustrate the most simple form of virtual register using next (as introduced above); that should be sufficient for everything but a full-fledged pipeline

From the point of view of the specification, operations always read the *current* value of a visible register. The current value of a visible register is the value *after* the previous operation has updated the visible register, independent of the actual implementation. This is illustrated in Example 4-1 with a piece of assembly code of a processor.

### Example 4-1. Reading of Visible Registers of a Processor

add r5.r1,r2 ; this computes r5 <= r1+r2 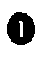 sub r2,r7,r6 : this computes r2 <= r7-r6 and r2,r2,r9 ; this computes r2 <= r2&r9 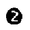 mul r8,r2,r5 ; this computes r8 <= r2*r5 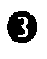
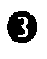 The last instruction in this program reads r2 and r5 in order to compute its result. According to the specification, the mul instruction reads the result of the *last* instruction *writing* the register it reads. In other words, it reads the values of the source registers after the execution of the previous instruction in order to produce its own result.
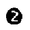 Since the and instruction 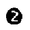 writes r2, the mul instruction 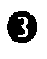 reads the value of r2 that is provided by the and instruction 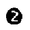 .
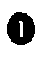 For r5, the last instruction reads the result of the add instruction 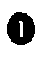 since none of the intervening instructions write r5.

If there is no previous instruction writing the register at all, the *initial* value of the register after reset is read.

The pseudo code below summarizes Example 4-1 by returning the current register value from the point of view of an instruction instr.

```
 current_register(instr) :=
  if is_first_instruction(instr) then -- first instruction?
          initial_value -- take initial value
  elsif writes_register(previous(instr)) then-- write from previous
 instruction?
          result(previous(instr)) -- take result of previous
 write
  else -- no write?
          current_register(previous(instr)) -- take current value of
 previous instruction
  end if
```

Note that this piece of pseudo code applies to any visible register updated by instructions, or, to be more generic, operations. The main idea is that if the previous operation updates the register, the value written by the previous operation is returned, that is its result. Otherwise, the value of the register did not change from the previous operation to the current one and hence, the current value of the previous operation is returned.

This view of reading visible registers is general, that is not specific to processors, and it is derived directly from the specification. Thus, any implementation must adhere to the view from the example. The crucial fact is that the view can be transferred to a pipelined implementation. Note that for every visible register in the specification, there is a corresponding *implementation* register in the pipeline; however this implementation register does not necessarily hold the current value of the visible register for an operation in the pipeline as shown in Example 4-2.

### Example 4-2. Reading of Visible Registers in Pipelines

The example extends Example 4-1 to a pipelined implementation with three pipeline stages DEC, EXE, and WB. When the last instruction from Example 4-1 (mult) has just entered the DEC stage, the previous two instructions are still in the pipeline, whereas the first instruction has already left the pipeline. Thus, the sub instruction is the last instruction in the pipeline at that time. This is illustrated in the pipeline picture below. Since the final add instruction from Example 4-1 has already left the pipeline, the implementation register contains the visible registers after the execution of the add instruction 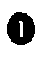 .
add r5,r1,r2 ; this computes r5 <= r1+r2 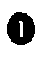
'WB' : sub r2,r7,r6 ; this computes r2 <= r7-r6
'EXE': and r2,r2,r9 ; this computes r2 <= r2&r9 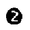
'DEC' : mul r8,r2,r5 ; this computes r8 <= r2*r5 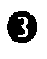

As in the specification, an instruction in the pipelined implementation reads the result of the last instruction writing the register it intends to read. Therefore, the instruction in decode 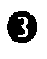 checks whether the previous instruction 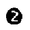 produces a result it intends to read. Note that the previous instruction can typically be found in the next pipeline stage, that is the EXE stage in this case. If the previous instruction writes the register, the result of this instruction is read. Otherwise, the previous instruction from the point of view of instruction 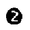 in the EXE stage is examined whether it writes the register that is supposed to be read. This process continues until either an instruction has been found that writes the register or all pipeline stages have been taken into account.

If no pipeline stage produces a relevant result, the value from the actual *implementation* register is read because that already contains the value of the last instruction that wrote to this register. In the concrete example above, r2 is read as the result of the and in the execute stage 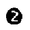 while r5 is taken directly from the implementation register as there is no longer a write to r5 in the pipeline.

### Figure 4-3. Forwarding in a Pipeline

If an operation in a pipeline reads a visible register, it cannot rely on the fact that the corresponding *implementation* register already contains the value of the visible register after the update of the previous operation. Therefore, the implementation needs to check whether any previous operation still in the pipeline provides a result that is written to the visible register that the current operation reads. This is called *forwarding;* Figure 4-3 illustrates the forwarding mechanism to the DEC stage in a pipeline. Based on this forwarding mechanism, the visible register mapping for pipelines is constructed; this is called *virtual register.* The forwarding paths to the decode stage of a processor typically encode the virtual register in a manner more suited to actual hardware design. Note that the virtual register very much depends on the actual implementation of the design and it closely reflects how pipelines are *designed.* For a pipeline as described in Example 4-2, the generic virtual register looks as follows:

```
 macro virtual_register: unsigned :=
          if write_register(ex_stage) then -- register write in exe stage?
                    result(ex_stage) -- return result of exe
 stage
          elsif write_register(wb_stage) then -- register write in wb stage?
                     result(wb_stage) -- return result of wb
 stage
          else -- no write in pipeline?
                     impl_register -- return implementation
 register
          end if;
 end macro
```

This generic virtual register works for both r2 and r5 in Example 4-2. For r2, it returns the result of the and instruction in the EXE stage since that one writes r2. For r5, there is no write in either the EXE or WB stage and hence, the implementation register is returned.

Let us generalize this virtual register further. The above macro is very similar to the recursive description after Example 4-1. The instruction previous to the one in DEC is the one in EXE and so on. So the *previous* instruction is typically found in the *next* pipeline stage. The virtual register really queries whether the previous instruction writes the register; in that case, the result of the previous instruction is returned. This process is continued until the last instruction in the pipeline is encountered, the one in the last pipeline stage; in our example, this is the WB stage. Since this is the oldest instruction, there is no more previous instruction in the pipeline and the value of the implementation register is returned. This leads to the following generic recursive definition of the virtual register.

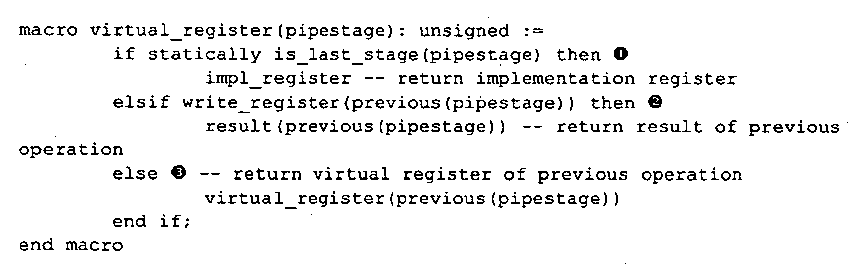

The virtual register is parameterized over a pipeline stage and returns the current value of the visible register for the operation in the given pipeline stage. Typically, the virtual register macro is only used for the decode stage since operands are read in this stage. The definition uses a macro previous that takes some pipeline stage as input and returns the pipeline stage where the previous instruction is located. This is typically the next pipeline stage since it contains the next older instruction. The definition of the above macro equals what was previously described:
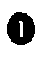 If the pipeline stage is the last one (typically writeback), the implementation register value is returned. Note that the keyword statically is needed since the macro is recursive.
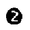 Otherwise, if the previous operation performs a write to the register, the *result* of the write of the operation in the previous pipe stage is returned, that is the result of the previous operation.
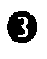 Finally, if none of the above two conditions apply, the virtual register value of the previous operation is returned.

Like all visible register mapping macros, virtual registers are heavily implementation dependent. Since a verification with visible register mappings is fail-safe in general as outlined in the Section called *Soundness of Visible Register Verification* in Chapter 5, visible register mappings do *not* have to be reviewed at the end of the verification.

Sometimes, the concept of visible registers needs to be extended if operations produce a result only in late pipeline stages. Consider a multiplication operation which is often spread over two pipeline stages in the implementation and there can be no forwarding of the result in the earlier of these two stages. For these cases, the visible register mapping needs to be extended by *validity* information for each register. A register is valid if its current value is already available and invalid if it is not yet available. This extension is described in detail in Part II in *GapFreeVerification Process Manual.*

### Protocols

The input/output interface of a design typically adheres to some protocol which is specified with the help of timing diagrams. These timing diagrams describe how *transactions* like a read access are translated into protocol signals. It is therefore also a goal of a complete verification according to the GapFreeVerification process to capture the transaction level in operations.

The transactions at each interface are described by temporal macros. These macros get the timepoints relevant for the transaction as arguments. At the slave interfaces these macros describe the values at the inputs of the interface in their sequence. The macros for the transactions at the slave interfaces are used in the assume part as trigger.

### Figure 4-4. Timing Diagram for a Protocol at a Slave Interface

```
 macro read_request(t_req: timepoint): temporal : :=
  at t_req: req_i = '1';
  at t_req+1: req_i = '0';
  at t_req+1: rw_i = '1';
 end macro;
 
 property read is
 assume:
  at t: important_state;
  read_request(t) ;
 prove:
 ...
 end macro;
```

Note that for protocols, some care should be taken to distinguish proper *triggers* of operations from protocol *constraints* during phase two. If the trigger of an operation after phase two still contains protocol constraints, this is sure to be identified as a gap in the verification during phase four. Hence, the verification according to the GapFreeVerification process cannot be compromised by triggers that contain constraints. However, it may actually save time to try to cleanly distinguish between triggers and constraints during phase two. This is discussed in some detail in the Section called *Protocol Constraints* in Chapter 6.

### General Working Steps

When introducing visible registers it is recommended to select a few basic operation properties from phase one and identify in a first step the visible registers that are needed as trigger of these properties. The other properties should be extended later if the first set of extended properties can already been verified. In a second step the macros for the visible states should be created as described in the following sections. check_property should be used to check whether the new trigger expression describes the behavior of the operation correctly.

The exchange of the trigger expression is carried out in three steps. Note that for this section, the timing of the operation described in the for timepoints section of a property is just treated like a trigger in the assume part.
1. The triggers are investigated to find inputs that influence the trigger at the trigger time point. *(the Section called Inputs at trigger time point)*
2. The triggers are investigated to find register that influence the trigger. (the Section called *Implementation registers)*
3. The visible register macros are created and the triggers in the properties refer to the visible registers. (the Section called *Introducing Visible Registers)*

After changing the triggers of all properties to the visible registers, the successor test is applied to check the consistency of the changes (the Section called *Executing the Successor Test*).

### Inputs at trigger time point

The triggers of the properties as they are created in phase one are expressions that refer to internal signals of the circuit. In the first step of phase two the combinational logic that drives the trigger signals is investigated. In general, this logic is driven by some inputs and some registers. The trigger expression is rewritten such that it expresses the same trigger but refers to the inputs and some internal signals that are combined with the input signals (the green signals in Figure 4-5).

### Figure 4-5. Relating the trigger to inputs and internal signals (green)

```
 property example_p1 is
 assume:
  at t: (full_j = '1') and -- internal signal
          (write_req_j = '1'); -- internal signal
 ...
 left_hook: t;
 right_hook: ...
 end property;
 property example_p2_1 is
 assume:
  at t: (full_j = '1') and -- internal signal
          (write_req_n_i = '0'); -- design input
 ...
 left_hook: t;
 right_hook: ...
 end property;
```

In some cases, the new trigger expression describes two or more different transactions that trigger similar operations or the same operation. It is recommended to split the property in this case.

### Implementation registers

### Identify implementation registers

In the second step of phase two the implementation registers are identified that will occur in the description of the visible states. In order to find the implementation registers, one should start to look for design signals with similar names. If some actual implementation documentation is present, this will typically describe the implementation of visible registers explicitly. Note that it is not really required to choose an actual *register* in the RTL to be mapped to the visible register macro; it is perfectly all right to choose arbitrary signals. However, in most cases the signal should not be connected to an input by pure combinational circuitry.

When trying to find a single implementation signal representing a visible register, it may be that there is no such signal since the RTL chooses to implement the register in a *distributed* way. (see the Section called *Visible Register Mappings* for examples) In many cases it is not possible to safely identify the implementation registers at this step of phase two. It is a good idea to start with a reasonable good choice and, if necessary, to adjust the choice later.

### Relate properties to implementation registers

Once the implementation registers are identified the trigger expressions are rewritten such that they refer to implementation registers and inputs only. In some cases the implementation registers are read in the same clock cycle as the internal signals in the trigger expression. Then it is straight forward to describe the trigger expression in terms of implementation registers. In the example below, property example_p3_3 is derived from property example_p3_2 by introducing an implementation register.

```
 property example_p3_2 is
 assume:
  at t: write_req_n_i = '0'; -- design input
  at t: full_j = '1'; -- internal signal
 ..
 left_hook: t;
 right_hook: ...
 end property;
 property example_p3_3 is
 assume:
  at t: write_req_n_i = '0'; -- design input
  at t: full_reg = '1'; -- implementation register
 ..
 left_hook: t;
 right_hook: ...
 end property;
```

In other cases, the implementation register is not read directly. Instead an intermediate register is read that stores the value of the implementation register from one cycle before. In this case, the trigger is rewritten such that it refers directly to the implementation register using the prev() operator or using another time point after "at". There is no need to refer to the intermediate register. In the example below, properties example_p3_2a and example_p3_2b are two variants that are derived from example_p2_2.

```
 property example_p2_2 is
 assume:
  at t: write_req_n_i = '0'; -- design input
  at t+1: full_j = '1'; -- internal signal
 ..
 left_hook: t;
 right_hook: ...
 end property;
 property example_p2_3a is
 assume:
  at t: write_req_n_i = '0'; -- design input
  at t+1: prev(full_reg) = '1'; -- implementation register
 ..
 left_hook: t;
 right_hook: ....
 end property;
 
 property example_p2_3b is
 assume:
 at t: write_req_n_i = '0'; -- design input
 at t: full_reg = '1'; -- implementation register @ t
 ..
 left_hook: t;
 right_hook: ...
 end property;
```

In general, it is necessary to investigate the origin of a value of an internal signal deeper in the past. Therefor, it is recommended to backtrace the trigger to get a first idea about the timing and functional relation. The backtrace should be carried out by an unrolling of the design as it is shown in Figure 4-6. This backtrace starts with the trigger signal in one property and investigates its drivers. The signals that are connected to the trigger via logic circuitry only are assigned to the same timepoint as the trigger, whereas register mark a border between time points.

When investigating the origin of a trigger some more dependencies to input signals might be detected. This input occurs then in the description of the trigger at the respective time point. Depending on the transaction that triggers the operation, it is possible that the transaction ensures that the input has a fixed value.

### Figure 4-6. Timing relation of implementation registers to a trigger, the dark blue parts occur in the property or in macros

If it is not possible to verify a property after the introduction of the implementation registers the counter example should be investigated if the implementation registers contain values that could not occur in a simulation that starts from reset. If this is the case it is likely that a reachability issue occurred, the Section called *Reachability* explains the steps that are necessary to fix it.

### Introduction of transaction macros

The assume part of the properties contain now (besides the important state) some trigger expressions at different time points that refer to inputs and implementation registers. These trigger expressions are now restructured. At first, the references to the inputs must be separated from the references to the registers because the behavior at the inputs must follow the specified transactions while for the registers a suitable mapping to the visible registers must be found.

```
 property read is
 assume:
 at t: important_state;
 -- inputs
 at t: req_i = '1';
  at t+1: req_i = '0';
  at t+1: rw_i = '1';
  -- implementation registers
  at t+1: (wd > 10) or (prev (cnt) = 0);
 prove:
 ...
 end macro;
```

The operation properties are created based on the transactions at the slave interface. (see the Section called *Identification of operations* in Chapter 3) After the changes of the triggers as described in the last sections, the assume part of each property should require that some input signals of the slave interface have at some time points values according to the transaction. It should be checked now, if these values fit to the specification of the transaction. It might happen that the property contains unintentionally references to two consecutive transaction. In this case the selection of control states as important states or the selection of implementation registers might be wrong. The knowledge about the dependency between control inputs at the slave interface and the changes of the control state should lead to a better choice of important states and visible registers.

If the input assignment of the properties fits to the specification of the transactions at the slave interface macros for the transaction should be created and used instead of single assignments to inputs. This increases the readability of the properties.

```
 -- transaction according to specification
 macro read_request (t_req: timepoint): temporal :=
  at t_req: req_i = '1';
  at t_req+1: req_i = '0';
  at t_req+1: rw_i = '1';
 end macro;
 
 property read is
 assume:
  at t: important_state;
  read_request(t);
  -- implementation registers
  at t+1: (wd > 10) or (prev(cnt) = 0);
 prove:
 ...
 end macro;
```

### Introducing Visible Registers

This section describes how to fill the macros for visible registers with actual content, that is to *map* the visible register from the specification to the implementation registers in the RTL. Depending on the optimizations present in the implementation of the visible register, this may be a non-trivial task in itself.

After the introduction of the transaction macros, the assume part contains some expressions that refer to the implementation registers. For these expressions a suitable description as visible register macro must be found such that the trigger condition can be expressed as specified.

Visible registers are assumed to contain the value from the previous operation normally at left_hook which is in most cases t. As a first step it is therefore necessary to rewrite the expression of the assume part that refer to the implementation registers such that all of them are assumed "at t". This can be achieved by introducing prev() and next() operators in the expressions. (see properties example_2_3a and example_p2_3b in the Section called *Relate properties to implementation registers*)

The introduction of the visible registers is now a creative task. It should be clear which visible register is needed for the triggering of the operations and which conditions over the visible registers are specified to start an operation. The definition of the macros for the visible registers is inspired by the expressions in the assume part of the properties.

It is common that the visible register macros contain non-trivial expressions, even in a simple fifo. Consider a common implementation with a read count, a write count, and a full flag that is needed in order to distinguish between an empty fifo and a full fifo in case both counters match. All three registers together implement the fill level of the fifo, namely how many elements there actually are in the fifo. Therefore, the visible register mapping for the fill level is a complex expression on there implementation signals.

```
 macro fill_level: numeric :=
          if (read_ptr = write_ptr) then
                     if (full_reg = '1') then
                               16 -- the size of the fifo
                     else
                               0 -- the fifo is empty
                     end if
          else
                     (write_ptr + 16 - read_ptr) mod 16;
          end if;
 end macro;
```

In addition, the buffer content is captured in a corresponding visible register mapping such that element 0 is the bottom element in the fifo, that is the element to be returned on the next read from the fifo. This corresponds to the specification view of a fifo where read and write counters of the implementation are not visible, but just a fill level and as many elements in the buffer as specified by the fill level.

```
 macro buffer_content (element: unsigned) : unsigned :=
          fifo_buffer[(read_ptr + element) mod 16]:
 end macro;
```

Since a complete verification cannot be compromised by the choice of a wrong mapping for a visible register as discussed in the Section called *Soundness of Visible Register Verification* in Chapter 5, one should simply *try out* candidates for the visible register mapping that look good. If a candidate works out with both property checking and completeness, we consider the mapping to be correct. Note that during the verification of the core and extended functionality in phase three and four, it may turn out that the visible register mapping needs some further refinements to actually work with all operations. In this way, a visible register mapping may be built incrementally like an important state.

It must be noted that the description of the visible register in a macro holds for *all* properties that read this register. This may lead to conflicting requirement to the timing relation between the implementation registers and the visible registers. In case of such a conflict, it is necessary to find a suitable definition of the visible registers that suits to all properties. There are three ways the conflict can be resolved:
1. The implementation register does not change its value over several clock cycle such that there is some freedom in which timepoint this register is referred to. In most cases the property with the earliest reference (related to left_hook) should be used to define the macro for the visible register.
2. The implementation register plays this role just at the beginning and the end of operations. During the operation, it is used to store intermediate values. The register can then be read as implementation register at one timepoint and as intermediate register at another timepoint. In the latter case, it must be investigated from which implementation register the trigger really depends on or at which timepoint the registers counts as implementation register.
3. The offset depends on the important state in the assume part of the properties. Then the visible register gets an if-then-else construct that selects the timepoint depending on the important state. E.g. "if (ctrl_state = idle) then read_ptr else prev(read_ptr) endif".

It is possible that new reachability issues occur during the introduction of visible registers into the properties. See the Section called *Reachability* how to cope with them.

### Executing the Successor Test

In order to achieve termination of phase two, it is necessary to carry out the successor test of the completeness analysis. This makes sure that the assumption of each operation property is only based on inputs and visible registers. Therefore, the completeness description developed in phase one needs to be extended. The inputs of the design are added to the input section and the visible registers that are used in the computation of the triggers are added as local determination requirement at the right hook.

```
completeness my_design is
 inputs:
  reset_i, req_i, read_i;
 local_determination_requirements:
  at right_hook: determined(my_visible_register);
 reset_property:
  reset;
 property_graph:
  reset, idle, read, write -> idle, read, write;
 end completeness;
```

Some visible register may only be relevant in one of the important states. In such a case, the visible register can typically only be determined in those operations that end in this particular important state. This leads to a local determination requirements only in the operation properties ending in this state. However, one typically cannot decide during phase two whether a visible register is general or tied to a specific important state. Therefore, all visible register should be treated equally in phase two by adding them as local determination requirements to the completeness description. During phase three, some of the visible registers may then be identified as belonging to a specific important state if they cannot be determined in all important states; their local determination requirements are then moved to the corresponding properties.

The successor test can be started from the GUI or from the OneSpin shell. Note that the reset assumption test checks whether the assumption of the reset property is determined and must be run in addition to all ordinary successor tests in order to achieve termination of phase two.

```
 mv> check_completeness -reset assumption
 mv> check_completeness -successor {* *}
```

By adding all important states as local determination requirements at the right hook, the successor tests can also be carried out with length one. This typically speeds up the checks significantly and also allows for a more focused debugging since failures of the tests can only be caused by the property itself or the completeness description, but not by the predecessor property. The corresponding gaps in the predecessor property are then identified during phase three for this predecessor property.

```
completeness my_design is
 ...
 local_determination_requirements:
  at right_hook: determined(my_visible_register),
                      determined(important_state_1),
                      determined(important_state_2);
 ...
 end completeness;
 
 mv> check_completeness -length 1 -successor {* my_prop}
```

### Debugging a Failing Successor Test

As described before, the successor test makes sure that the assumption and the timing of an operation are determined. Note that determined means described in terms of inputs and visible registers. A failing successor test highlights a scenario where the assumption depends not only on visible registers and inputs, but on further internal signals. This means that there exists a trace such that the assumption is fulfilled, while for a different trace whose values of inputs and visible registers are identical to the first trace, the assumption is violated. The former trace is called *witness* since it certifies that the property can indeed succeed. A counterexample of the successor test therefore shows a scenario consisting of a witness trace and a counterexample trace such that the assumption fulfills the former, but not the latter; in addition, both traces share the values of inputs and visible registers. Any part of the assumption that is not determined is shown in red in order to direct the user to the critical part of the counterexample. There are six different causes for counterexamples of the successor test.
• An input is missing in the completeness description. This causes any trigger condition based on this missing input not to be determined. Adding the input to the completeness description resolves the counterexample.
• A visible register is missing in the completeness description. This causes any trigger condition based on this missing visible register not to be determined. Adding the visible register to the local determination requirements resolves the counterexample.
• A trigger condition is based on a visible register with a local determination requirement, but the trigger reads the visible register *not* at the left hook. Since visible registers are handed over to the next operation exactly at the hooks, any trigger condition must only read the visible register at the hook.
• The right hook in the predecessor property is set incorrectly. This is one of the three causes of an undetermined important state in the assumption; it is fixed by correcting the right hook in the predecessor property. Note that this problem is only identified during phase two if the successor test are carried out with length two. By using a length of one and adding the important states as local determination requirements, this issue in the predecessor property is identified during phase three of the predecessor property.
• The predecessor property does not prove any end state at all. This is the second cause of an undetermined important state in the assumption; it is obviously fixed by proving the important state at the end of the predecessor property. As for the other cause for an undetermined important state, it is only identified here in phase two in case the tests are carried out with a length of two.
• The left hook in the property is set incorrectly, that is it does not match the cycle the property assumes its important start state. Note that this case should not occur when applying the GapFree Verification process since left hook should always equal t, the cycle the start state is assumed. Nevertheless, this is the third and final cause for an undetermined important state in the assumption; it is fixed by adapting the left hook accordingly.

Finding out which of the six causes applies in a concrete counterexample involves investigating the red parts in the counterexample. If the important state is colored read, it is immediately clear that one of the three last causes applies. Any red in the trigger of the operation needs to be traced back to the cause, i.e., whether it is caused by a missing input or a visible register. The corresponding actions are detailed in the first three causes of counterexamples.

Note that the successor test quite obviously also fails in case some trigger has been forgotten to rewrite in terms of inputs and important states, that is the trigger just refers to internal signals. In that case, phase two just has to be applied to this forgotten trigger and afterwards, the successor test is carried out again.

### Reachability

In mature designs, the most common reason for properties to fail is *not* an actual bug in the design. Instead, either the property claims something wrong due to a mistake in writing the property or the counterexample shows a situation that cannot occur in the actual design. It is clear what has to be done in case the property just claims a wrong thing. This section therefore focuses on how to handle counterexamples that cannot happen in the design at all. There are mainly two reasons for impossible counterexamples.
- The inputs of the design show some scenario that cannot occur due to environment restrictions, for example a violation of the input protocol.
- The starting state of the implementation as it is shown in the counterexample is not reachable from reset. In other words, no matter how long the design actually may be operating, it can *never* reach the starting state of the counterexample. Such an unreachable starting state is manifested by an impossible value in one register or an impossible combination of values in several registers.

In case the inputs show a scenario that violates the protocol, the protocol needs to be captured with a *constraint* and this constraint needs to be used as a *dependency* in the verification of a property. The most trivial constraint used in a verification is typically the absence of reset. Note that this constraint does not restrict the verification at all since there is also a reset property handling the presence of reset. (see the Section called *Analysis of the reset behavior* in Chapter 3) Other typical protocol constraints are that no errors are signaled unless there is actually a request going on. Note that protocol constraints are also a familiar concept in simulation based verification.

In contrast to simulation based verification, however, *reachability* is an issue in formal verification. This is because formal verification does not only examine traces actually starting after a reset of the design, but instead examines operations starting in *arbitrary* states of the design. If an operation can be proven to hold on an arbitrary starting state, it is obvious that the design behaves according to the operation, no matter how long after reset the operation occurs. In short, starting in an arbitrary state guarantees complete functional coverage in case the property holds.

If, on the other hand, there is some starting state such that the operation under examination is violated, a counterexample is produced that shows this scenario. However, this does not necessarily mean that the design actually violates the property and there is a bug. It is equally possible that the starting state chosen in the counterexample is just a state that the design can never reach, not matter how long after reset. The following sections discuss several means to get rid of unreachable counterexamples.

### Bounded Proof from Reset

The first task in analyzing a counterexample is in general to understand if the counterexample is due to a bug in the RTL or whether it is unreachable. There is always a quick reachability check, namely to try to prove the operation just on bounded traces from reset. In 360 MV, bounded checks for properties can be carried out with the option assume_reset.
check_property -assume_reset 12 my_property
- If the property still fails on such a trace from reset, it cannot be due to reachability any more. The only possible causes are missing input constraints, a property claiming the wrong thing, or an actual bug in the RTL. By reviewing the counterexample against the specification, one can then find out which of the three scenarios applies. Note that in the presence of visible register mappings (cf. the Section called *Introducing Visible Registers*), extra care needs to be taken in order to check is a wrong mapping of a visible register causes the counterexample. In this way, one can detect whether the visible register mapping is wrong (the trace conforms to the specification with respect to a visible register, but its mapping claims it has a wrong value), or there is actually a bug (the trace does not conform to the specification). An example for such a mapping issue can be found in (let's see where we will have it).
- If the bounded check on the trace from reset produces contradictory assumptions, this means that the scenario described in the assumption of the operation cannot occur on these bounded traces from reset. This is a pretty strong indication that the length of traces examined in the bounded check is not great enough. One should increase the length until the bounded proof either holds or fails.
- If, on the other hand, the bounded check holds, the result is inconclusive: this only means that within the given number of cycles after reset, the property always holds. This means that either the original problem was due to reachability or the length of the examination was not long enough to trigger the particular scenario from the original problem.

Note that a sensible length of the bounded examination heavily depends on the design under verification. The length should be sufficiently great such that most scenarios can actually occur after the initialization carried out after reset; on the other hand, an unduly long examination after reset increases runtime of the property checking without any real benefits. A length of 12 cycles plus the length of the initialization sequence is probably a good initial choice.

### Extend Examination Window of Property

Let us now assume the bounded check according to the Section called *Bounded Proof from Reset* yields a holding property. We take this as a strong indication for a reachability issue. The easiest means to overcome simple reachability problems is to add some initial cycles to the property. This can be achieved by just referring to timepoints before t in the assume part.

```
 property my_operation is
 ...
 assume:
 at t-1: true;
 ...
 left_hook: t;
 end property;
```

In the above property, timepoint t-1 is referenced in the assume part while the property actually starts at t since this is the left hook. Therefore, the state of the design at the start state of the property is not an arbitrary one, but a state which can be reached within one cycle after an arbitrary state. While this distinction seems rather weak, many simple reachability issues can be resolved in this way. Consider the case that the result of some computation is stored redundantly in three different registers. If these three registers contain different values, an unreachable counterexample is shown for a property. Just adding this one cycle to the beginning of the property trivially causes the three registers to have the same value at the start of the property and hence, it makes the unreachable counterexample disappear.

More clock cycles may be added at the beginning of the property by looking more than one cycle into the past. However, it is typically not useful to add more than 3 cycles at the beginning of the property. If this is not sufficient to make a counterexample disappear, a more elaborate investigation is needed.

### Using Automatically Proven Design Assertions

Before spending *manual* effort in resolving the reachability issue, it is a good idea to exploit all *automated* resources. As has been discussed in Chapter 2, explicit assertions coded in the RTL by the designer can be proven. In addition, further reachability information can already be gathered during design consistency checking. Note that some of the design assertions may simply be proven with, while for others the proof may fail. This section just focuses on using the assertions that can actually be proven. In the following section, the remaining assertions will be exploited as well.

The first use of design assertions is to use all the proven assertions during property checking in order to eliminate further unreachable counterexamples. Note that this is not done automatically since run time may suffer from using all proven assertions needlessly. Therefore, the user can control via one option whether *all* proven assertions should be used in a property check or *none* of them. In 360 MV, automatically proven assertions are used with the option assume_generated_invariants.
check_property -assume_generated_invariants my_property

All the assertions actually used in such a property check with the above option have actually been proven to hold on the design. Therefore, assuming these invariants in the proof of the property does not restrict the verification in any way. If the property check with the above option yields a holding property, the reachability issue is therefore resolved since the property holds on traces of arbitrary length. If, on the other hand, the property still fails, the automatically proven assertions did not contain enough reachability information and more work is required in order to resolve this problem.

### Finding the Cause of an Unreachable Counterexample

In case the additional reachability information derived from the proven design assertions is still insufficient to make the property hold, it is finally time for some manual work. The general idea is to find out which combination of register values actually causes the unreachable counterexample and then prove that this combination of register values cannot occur, thus making this particular unreachable counterexample disappear. This process is iterated until there is no more unreachable counterexample for the property under examination.

There are two major steps in this process of eliminating unreachable counterexample, namely *identifying* the cause of the unreachable counterexample and then *proving* the absence of this cause. The former is a creative process requiring much insight into the implementation, while the latter is to a large extent a question of efficient proof techniques. This section describes how to identify the cause of an unreachable counterexample. How to actually prove that these scenarios cannot occur is addressed in the following section.

As has been discussed before, the fact that some of the design assertions cannot be proven with does not necessarily mean that the assertions are actually violated by the design. What is more, the assertions encode design intent, for example that some register is supposed to be one-hot encoded. Therefore, one should try to exploit the failing design assertions as well in order to resolve reachability problems.

Therefore, before actually starting to analyze the design manually for the cause of an unreachable counterexample, it is a good idea to collect the related failing design assertions and, as a test, assume that they hold in the important state at the left hook. In case that this make the property hold, one proceeds by actually proving that assuming these assertions is justified and not a restriction in the verification; the technique of the GapFreeVerification process to prove this reachability is outlined in the Section called *Refining the Important State.* If, on the other hand, the property still fails even with all the failing design assertions assumed at the left hook, one has to identify the cause of the failing counterexample manually.

There are several typical scenarios causing unreachable counterexamples. These can be classified into two main categories, general reachability and reachability in important states. We first focus on general reachability, namely cases where some signal or a combination of signals that are unrelated to the important state have a value in the counterexample which they can *never* take on a trace from reset. Typical examples for this class of reachability problem are:
1. A signal sig_a that is supposed to be one-hot encoded, but has a value in the counterexample that is not one-hot. Assuming that the registers is actually one-hot makes the unreachable counterexample disappear.
2. Redundancy in the design, for example two registers reg_1 and reg_2 that should always have the same value. In this case, the counterexample often picks a scenario where the two registers actually have different values and thus, the counterexample is unreachable. Assuming that the two registers actually are the same makes the unreachable counterexample disappear.
3. Some register values are mutually exclusive, that is, some register cond_a encodes a particular condition, whereas register cond_b encodes a different condition and these two conditions can never be active simultaneously. An unreachable counterexample is then characterized by both these registers being active simultaneously; the reachability issue can be resolved by assuming that in case cond_a is active, cond_b is not.

Let us now focus on reachability in important states. This means that there is a combinations of signal values that can occur in general on a trace from reset, but *never* in an important state. This is illustrated in Figure 4-7. Consider the example that some special_condition at the left hook of the property actually causes the unreachable counterexample. Furthermore, this condition can actually occur: during the special operation in the figure, the condition becomes active, but not during the normal operation. However, the crucial fact is that the condition can only occur *during* the operation, that is between the left and right hook, but never at the hook itself when the design is in the important state idle. The RTL relies on this fact, i.e., it is not checked in the RTL whether the controller is in the idle state when special_condition occurs. Therefore, unreachable counterexamples are produced if the condition is active in the important state.

### Figure 4-7. Reachability in Important States

In order to eliminate a counterexample that is unreachable in an important state, one just needs to assume that the corresponding condition does not occur at the left hook; for the example above, the absence of special_condition is assumed at the left hook.

After identifying the cause of an unreachable counterexample, there are two different approaches how to actually prove that this counterexample is not reachable. First of all, there is the traditional approach of simply writing a corresponding assertion and proving it. In other words, one captures the reachability in an ITL assertion and then proves this assertion. This ensures that some unreachable scenarios can never occur, no matter whether in important states or between important states. This way of proving reachability fits to simple reachability, that is reachability unrelated to important states. The piece of ITL code below shows an assertion for the three examples of simple reachability given above.

```
 assertion my_reachability :=
          one_hot(sig_a) and -- sig_a a is one-hot
          reg_1=reg_2 and -- reg_1 and reg_2 are equal (redundancy)
          if cond_a='1' then
                     cond_b='0' -- cond_a and cond_b mutually exclusive
          end if;
 end assertion;
```

In addition, there is a different way of handling reachability problems that only proves the absence of unreachable scenarios in important states, but completely ignores the time between important states. This way of proving reachability is particularly well suited for reachability in important states; it is described in detail in the Section called *Refining the Important State.*

In general, identifying the cause of an unreachable counterexample means testing whether assuming some additional reachability in the property makes the unreachable counterexample disappear. Note that this explicit assuming of reachability in the property is *temporary.* After actually proving the reachability with the help of assertions or by refining the important state, the explicit assumption should be removed again from the property. Reachability should be kept only inside assertions or important state mappings in order to keep properties simple and easy to understand. This also facilitates the final review of a verification after the GapFreeVerification process since neither assertions nor important state mappings require a review.

### Refining the Important State

Proving assertions fully, that is, inductively, is a well-established technique in formal verification. So why does the GapFreeVerification process add a new way of proving reachability? In short, the answer is to overcome the deficiencies of the assertion based approach. Assertions prove reachability inductively at every time, no matter whether in or between important states. This directly leads to the major weakness of the approach: in order to prove an assertion at every time, one typically needs to strengthen it in order to make it inductive. As an example, consider the simple arbiter example from in the user manual. There exists some reachability in the important state, namely grant_o is never active in the important state. This reachability in the important state can also be captured in an assertion as follows:

```
 assertion important_state_assertion ; boolean :=
  if state_s = idle then -- grant_o never active in idle state
     grant_o = '0';
  end if;
 end macro;
```

However, the proof of this assertion fails with an unreachable counterexample, but the assertion itself can never be violated on a trace from reset. The assertion fails nevertheless because it only captures the time in the idle state, but gives no details about the activation of grant_o in the other FSM states. In order to prove this assertion, one needs to strengthen it by adding the relation between the unimportant FSM states and grant_o explicitly. As anyone who ever proved substantial assertions inductively can testify, this strengthening of assertions is time-consuming hard work. Therefore, the GapFreeVerification process offers a way of proving reachability only in the important states, thus disregarding the time between the important states that assertions also need to capture. This technique is called *refining* the important state. Proving reachability by refining the important state is easier to achieve than the proof of the stronger assertion. A comparison between proving assertions and proving reachability only in important states is available in Table 4-1.

**Table 4-1. Proving Assertions versus Refining Important States**

| | **Proving assertion** | **Refining important state** |
|---|---|---|
| **Result** | proof at every cycle | proof only in important states |
| **Required checks** | proof of single assertion | proof of all properties starting or ending in some important state |
| **Manual effort** | high since assertion must be inductive | low since time between important states can be ignored |
| **Summary** | well suited for simple reachability at every cycle | well suited for reachability in important states |

In the Section called *Important States* in Chapter 1, important states have been introduced as an abstraction of FSM states. It was recommended to use a macro for each important state; the macro itself then *maps* the important state to the design, much like a visible register mapping. The ISM describes the possible sequencing of operations in the design; note that the ISM is based on the abstract important states, but is independent of the mapping of the important state to the design. Again, this is very similar to visible registers and their verification. Therefore, reachability in important states can be handled simply by adding it to the important state mapping. For the example above where grant_o can not be activated in the important state, this results in the following refined important state.

```
 macro important_state : boolean :=
 state_s = idle and grant_o = '0'; -- grant_o never active in idle state
 end macro;
```

In contrast to the corresponding assertion shown above, all the properties of the arbiter can actually be proven with this important state *without* any further need to make things inductive. Therefore, proving reachability by refining the important state is indeed less manual effort than doing it with assertions. On the other hand, it requires re-running all properties that start or end in the modified important state while an assertion requires just a single check. As Table 4-I summarizes, it is a good idea to try to prove simple reachability with the help of assertions since this is more efficient in terms of required checks. If the assertion holds, one never needs to think again about the reachability it captures; if, on the other hand, the assertion fails, one should try just to refine the important state instead of wasting effort by trying to make the assertion inductive. Conversely, it typically makes no sense to try to prove reachability in important states with assertions since it is much harder than refining the important state.

In a verification with the GapFreeVerification process, one can really just focus on the crucial points in time when an important state is reached. Since you both assume the important state at the beginning and prove it at the end of any operation, this achieves the same job as an assertion, namely to actually provide reachability at the left hook and prove it at the right hook instead of just constraining a verification. The arguments why a complete verification with such an important state is sound are given in the Section called *Soundness of Visible Register Verification* in Chapter 5.

It is not the goal of the important state in the GapFreeVerification process to *exactly* capture the reachable state space of the design under verification. Instead, the important state is only refined if there is actually some unreachable counterexample. Therefore, the important state becomes more and more restricted as verification proceeds; however, the refinement of the important state does not influencing the ISM. Similar to visible register mappings, the mappings for important states do not have to be reviewed after a complete verification.

As was illustrated in Figure 4-7, reachability in important states deals with special conditions like exceptions. The special operation (the one dealing with the exceptional behavior) ends only *after* the special condition, namely the exception condition, has become inactive again. Hence, one just has to refine the important state as shown below and re-check the two operations starting and ending in idle_state.

```
 macro idle_state : boolean : :=
  state_s = idle and
  special_condition = '0'; -- no exceptional behavior in idle state
 end macro;
```

Application experience with the GapFreeVerification process on a wide variety of design suggests that during phase two, you have to refine your initial important state several times before properties actually hold. Afterwards, in phase three, further refinements are typically needed for the same properties. Finally, in phase four, the important state has to be refined again in order to resolve the reachability issues for the extended functionality.

### Debugging Important States

Note: This section should be enhanced like the one about debugging visible register mappings Sometimes, when refining an important state, it happens that it actually is no longer possible to prove that all operations reach the refined important state at the end. This typically means that the last refinement made the important state too restrictive. The refinement was strong enough to exclude the unreachable counterexample, but it actually also excluded some reachable behavior. This is illustrated in Example 4-3.

### Example 4-3. Refinement of Important States

```
 macro important_state: boolean :=
 state=idle and internal_exception_condition='0' and
 special_condition_3='0'; -- needed for my_prop1
 end macro;
```

In order to eliminate an unreachable counterexample of my_prop1, the absence of special_condition_3 is added to the important state as shown above. This makes the formerly failing my_prop1 pass, but now a different property my_prop2 fails because special_condition_3 is active in the end state. Further analysis of this counterexample and the one of the originally failing property suggest that special_condition_3 only causes the initial property to fail if special_condition_2 is active as well. Therefore, the important state is weakened again accordingly.

```
 macro important_state: boolean :=
  state=idle and internal_exception_condition='0' and
  if special_condition_2='1' then -- needed for my_prop1 and my_prop2
     special_condition_3='0'
  end if;
 end macro;
```

This way, one may easily end up with an important state that is not just a simple conjunction of terms, but may be any *arbitrary expression.* This important state is strong enough to make the unreachable counterexample of my_prop1 disappear since special_condition_2 and special_condition_3 cannot be active simultaneously. On the other hand, the important state is also weak enough to actually prove it at the end of my_prop2 since either special_condition_2 or special_condition_3 is allowed in the important state, but not both.

If the important state is strengthened in order to eliminate an unreachable counterexample in one property and a different property now fails since it does not reach this stronger important state any more, it is a good idea to examine the newly failing property with a bounded check from reset as described in the Section called *Bounded Proof from Reset.* If this yields another counterexample, the important state has indeed become too strong and one needs to weaken it again as described in Example 4-3. If, on the other hand, the bounded examination after reset yields a holding property, this is a good indication that nothing is wrong with the important state; it just needs to be strengthened further in order to make the seemingly unreachable counterexample disappear. Hence, the important state is just further refined until all the properties hold.

In general, refining an important state is to some extend simple trial and error. When some scenario disturbs the verification of the current operation and looks like it should not happen in the important state, one just excludes it in the important state and as a validation for the new important state, a regression on all properties using this important state is run. If some property does not reach the refined important state at the end, the important state may have to be weakened again; otherwise, further refinements of the important state may be necessary to resolve further reachability problems. During this trial and error period of refining the important state, one cannot compromise the final result of the verification since a complete verification with important states according to the GapFreeVerification process is sure to fail in case the important state is actually too restrictive, i.e., wrong.

### SDRAM Controller Tutorial

### Investigation of the triggers

At first, the triggers of one property are analyzed. In this tutorial, the property simple_read has been chosen. This property contains as triggers inputs (read_requeset_i and burst_single_i) and internal signals (same_row and acc_rw). The inputs are not relevant for the analysis of the visible registers. Only the internal trigger signals have to be considered.

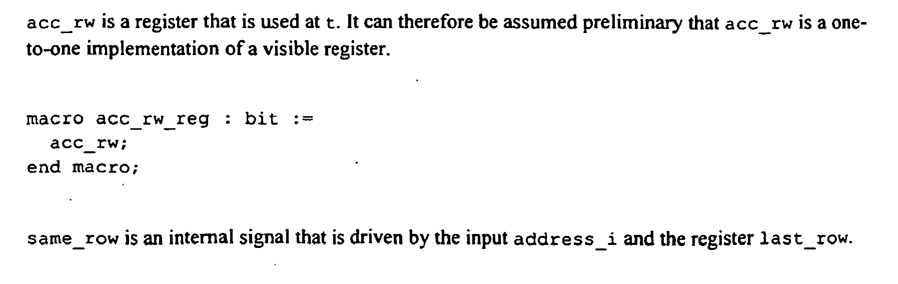

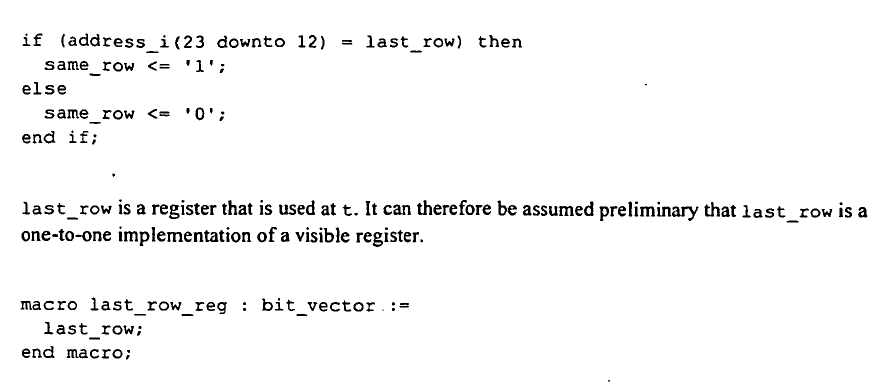

In the property simple_read the triggers are substituted using the newly defined macros for the visible registers. After this substitution the property should be checked to ensure that the substitution did not introduce some errors.

```
 property simple_read is
 dependencies: no_reset;
 assume:
 at t: ract_state;
 at t: read_request_i = '1';
 at t: burst_single_i = '0';
 at t: acc_rw_reg = '0';
 at t: address_i(23 downto 12) = last_row_reg;
 prove:
 ...
```

This process is to be repeated for each property. Since all properties use all triggers at t and no other internal signal than same_row and acc_rw is used the macros that define the visible states can be reused for all properties.

### Executing the successor test

After substituting the triggers of the properties, the properties must be extended by the local_determination_requirements. This entry describes which visible register must be available at the end of each property such that the triggers of all successor properties can be determined. In case of the SDRAM controller, the local_determination_requirements depend on the important state. The properties that start in ract_state require that last_row and acc_rw is available at their left hook. These visible registers must be determined at the right hook of all predecessor properties i.e. at all properties that are defined in the property_graph of the completeness description as to_ract_state.

```
 property simple_read is
 right_hook: t+5;
 local_determination_requirements:
 at right_hook: determined(ract_state);
 at right_hook: determined(last_row_reg);
 at right_hook: determined(acc_rw_reg);
 end property;
```

**Note:** Is it necessary to determine the important state?

The properties that start in idle_state do not require the availability of an visible register. The properties that end in idle_state need therefore to determine idle_state only.

```
 property precharge is
 ...
 right_hook: t+2;
 local_determination_requirements:
 at right_hook: determined(idle_state);
 end property;
```

In addition to the properties, the completeness description must be extended as well by the list of all inputs of the design that are used as trigger.

```
 inputs:
  reset,
  read_request_i,
  write_request_i,
  burst_single_i,
  address_i;
```

The successor test of the completeness checker finds out whether the local_determination_requirements and the triggers in the properties fit together.

### DMA Controller Tutorial

### Inputs at trigger time point

Many different signals occur as trigger in the properties that are created in phase 1. From the VHDL code it can be observed, that the following signals are directly connected to inputs:
- ctrl_i/rdy_i
- ctrl_i/read_access_i
- ctrl_i/write_access_i
- ctrl_i/grant_i

These signals can be substituted in all properties by the inputs they are connected with. The internal signal ctrl_i/valid_reg_addr_s is computed directly from the input addr_i. All occurrences of ctrl_i/valid_reg_addr_s in the properties can therefore be substituted by an expression that describes the condition for ctrl_i/valid_reg_addr_s to be 1.

```
 property read_register is
 dependencies:
 no_reset;
 assume:
 at t: idle_state;
 at t: read_access_i = '1';
 at t: addr_i = transfer_len_addr_g or
          addr_i = src_addr_addr_g or
          addr_i = tgt_addr_addr_g or
          addr_i = parity_addr_g or
          addr_i = command_addr_g;
 ...
```

### Visible Registers

After the treatment of the inputs there is just one internal signal used as trigger of some properties: ctrl_i/command_s. This signal is directly connected to the register data_i/command. In the property action_1 this register is used at the left hook (i.e. in idle state) to decide whether a transfer or a check operation is started, It can therefore be assumed that data_i/command is the implementation of the command register from the specification. Since there a several configuration registers beside the command register a parameterized macro should be defined for all the configuration registers. The address of the configuration registers in the address space is a good candidate for the parameter. There is still nothing known about the implementation the most configuration registers. The macro contains therefore just placeholders for those registers. They will be filled in phase 3 of the GapFreeVerification process.

```
 macro config_register(addr: numeric: numeric :=
  case addr is
    when src_addr_addr_g => 0; -- placeholder
    when tgt_addr_addr_g => 0; -- placeholder
    when transfer_len_addr_g => 0; -- placeholder
    when command_addr_g => data_path_i/command;
    when parity_addr_g => 0; -- placeholder
    when others => 0;
  end case;
 end macro;
 
 property action_1 is
 dependencies:
  no_reset;
 freeze:
  command_f = config_register(command_addr_g) @ t;
 assume:
  at t: idle_state; -- important state
  at t: (command_f(0) = '1') or -- visible register
          (chk_parity_g = 1);
 ...
```

In the properties transfer_2 and check_parity_2 the register data_i/command is assumed at t_read_ack. An analysis of the VHDL code shows that the register data_i/command does not change in read_wait_state. It is therefore possible to assume the value of the command register at the left hook, i.e. at t.

```
 property transfer_2 is
 dependencies:
 no_reset;
 for timepoints:
  t_read_ack = t + 0..max_wait waits_for rdy_i = '1';
 freeze:
  command_f = config_register (command_addr_g) @ t;
 assume:
  at t: read_wait_state; -- important state
  at t: command_f(0) = 1; -- visible register
 ...
```

### Executing the Successor Test

To check that the properties still fit together the successor check should be run. For this check, the module inputs must be declared in the completeness description. In addition the control register that is used as trigger must be declared as local_determination_requirements in the completeness description as well because this visible register is used as trigger at left hook. It must therefore contain a determined value at the right hook of all predecessor properties.

```
 completeness dma is
 inputs:
  reset_n,
  grant_i,
  read_access_i,
  write_access_i,
  rdy_i,
  addr_i,
  data_i;
 local_determination_requirements:
  at right_hook: determined (config_register(command_addr_g));
 reset_property:
 ...
```

### VCORE Processor Tutorial

### Visible Registers

The execution of an instruction consists of
- the execution of an arithmetic or logical operation over up to two general purpose registers,
- the load or store of data,
- the write back of the result or the loaded data into the general purpose register, and
- the fetch of the next instruction.

The result of the instruction fetch is stored in a visible register IR for the next instruction that reads that register to decide which operation is to be executed. This is exactly what instruction word_reg does in the properties of phase 1. It can therefore be assumed that IR is implemented directly by instruction_word_reg. Hence, IR is defined as follow:
macro unsigned IR := instruction_word_reg; end macro;

Another visible register of the VCORE are the general purpose registers virtual_register. These registers are read in each arithmetic, branch, and store operation and written in arithmetic and load operations. In phase 2 of the GapFreeVerification process, only those read accesses are of interest, that are needed to trigger or to enable the different operations. In case of VCORE the general purpose registers are read to control the branch instruction. If the register that is addressed by the field A of the instruction word is zero the branch is taken. In the properties of phase 1 the internal signal ex_result [0] is used to decide whether the branch is taken. In phase 2 it is therefore necessary to relate ex_result [0] to virtual_register and to field A of IR.

First, property inst_beqz will be analyzed. The back trace of ex_result [0] in Verilog leads to

```
ex_op_a a == 0
 
 (because ex_branch == 0 at t+1 of beqz)
 
 prev(fwd_op_ a == 0)
 
 (because ! mem_stall, dec_valid, and ! ex_mispredict at t of beqz (important state); opcode
 is neither LD nor ST at t because of trigger.)
 
 prev(((ex_write_reg && ex_dest_reg == regA) ? real_ex_result :
             (wb_write_reg && wb_dest_reg == regA) ? wb_result:
 register[regA]) == 0)
 
 (following the combinational logic)
 
 prev(((ex_write_reg && ex_dest_reg == instruction_word_reg[10:8]) ?
                                                real_ex_result :
             (wb_write_reg && wb_dest_reg == instruction_word_reg[10:8]) ?
                                               wb_result :
                                               register[instruction_word_reg[10:8]])
 == 0);
```

The back trace should be stopped at this step because register is reached that implements the general purpose registers. Moreover, all signals (beside real_ex_result) would lead to a previous clock cycle that also indicates to stop back trace in the first trial. However, there is no strict rule when the back trace can be finished. It may happen that a further back trace is needed.

This expression can be substituted for ex_result [0] in the operation properties. Since at t+1: prev (<expression>) ; is equivalent to at t: <expression>; property inst_beqz looks as follow:

```
 property inst_beqz;
 dependencies:
          no_reset;
 assume:
  at t: important_state;
  at t: instruction_word_reg[15:11] == 5'b00111;
  at t: ((ex_write_reg && ex_dest_reg == instruction_word_reg[10:8]) ?
                                                    real_ex_result :
            (wb_write_reg && wb_dest_reg == instruction_word_reg[10:8]) ?
                                                    wb result :
 register[instruction_word_reg[10:8]]) == 0)
             == 0;
 prove:
 ...
```

After substitution of the trigger the property should be checked by check_property to make sure that the back trace is correct.

Because instruction_word_reg is the visible register IR it can be substituted in the trigger condition. To increase the readability the access to a certain field of IR should be expressed by a macro.

```
macro unsigned field opcode(unsigned iw) := iw[15:11]; end macro;
 macro unsigned field_A (unsigned iw) := iw[10: 8]; end macro;
 property inst_beqz;
 dependencies:
          no_reset;
 freeze:
          opcode = field_opcode(IR) @ t,
          a = field_A(IR) @ t;
 assume:
  at t: important_state;
  at t: opcode == 5'b00111;
  at t: ((ex_write_reg && ex_dest_reg == a) ? real_ex_result :
            (wb_write_reg && wb_dest_reg == a) ? wb_result :
                                                             register[a]) != 0;
 prove:
 ...
```

The remaining trigger condition can be split into the condition ! (virtual_register (a) == 0) according to the specification of the beqz instruction and into the definition of virtual_register.

```
macro unsigned virtual_register(unsigned r) :=
          if (ex_write_reg && ex_dest_reg == r)
                     real_ex_result
          elseif (wb_write_reg && wb_dest_reg == r)
                     wb_result
          else
                     register[r]
          endif;
 end macro;
 
 property inst_beqz;
 dependencies:
          no_reset;
 freeze:
          opcode = field_opcode(IR) @ t,
          a = field_A(IR) @ t,
          taken = virtual_register(a) == 0 @ t;
 assume:
  at t: important_state;
  at t: opcode == 5'b00111;
  at t: !taken;
 prove:
```

Since the trigger of property inst_beqz_mispredict uses also at t+1: ex_result [0]... the macro virtual_register can be used for this property as well. There is no alignment between the visible registers for the different properties necessary.

### Successor Test

To check the properties of phase 2 the successor test of the completeness check should be executed. For this check it is necessary to amend the completeness description by the inputs of the design and the determination conditions. The latter describe the timepoint of each property when the value of each visible register is assumed to be written in the predecessor property. In case of VCORE, the values of all visible registers are assume to be at available the left hook of each property i.e. it is assumed that these values are written at right hook of the predecessor properties.

```
 completeness vcore;
 inputs: // all inputs of the design
          reset_n,
          imem_data_i,
          dmem_data_i,
          dmem_valid_i;
 local_determination_requirements:
  at right_hook determined(important_state); // why is this
 needed??
  at right_hook: determined(IR);
  at right_hook: determined(virtual_register(0))
  at right_hook: determined(virtual_register(1));
  at right_hook: determined(virtual_register(2));
  at right_hook: determined(virtual_register(3));
  at right_hook: determined(virtual_register(4))
  at right_hook: determined(virtual_register(5));
  at right_hook: determined(virtual_register(6))
  at right_hook: determined(virtual_register(7));
 ...
```

### Chapter 5. Phase Three: Verification of Full Behavior

### Overview

- determination
- transaction level
- computation macro
- visible register verification

### Introduction

In phase three of the GapFreeVerification process, the core functionality is verified. In particular, this means that the output behavior of the *basic* operations is completely verified. Hence, the verification from phase two is mainly extended to cover outputs during phase three. What is still missing after phase three is only the verification of the *extended* functionality. An operation property after phase three is illustrated in Figure 5-1.

### Figure 5-1. Operation Property after Phase Three

The work in phase three consists of three steps:
1. identify all the visible registers of the specification, that is those not already identified in phase 2, and capture their mapping to the registers in the implementation
2. add the verification of all outputs and visible registers to each operation property; this replaces the verification of the intermediate values of the control register from phase one
3. add all outputs and the visible registers sill missing after phase two to the completeness description

Note that the identification of all visible register is driven by the verification of the outputs and the visible registers that have been identified so far. In other words, a missing visible register is identified when trying to verify those outputs or visible registers influenced by the missing visible register. Hence, it is not possible to compromise the verification by forgetting to verify a visible register.

One important aspect in the verification of phase three is to actually express the *expected* output behavior of operations. Therefore, phase three is completely driven by the specification, whereas phase one and two were to some extent driven by the implementation. Note that this makes phase three much more efficient in terms of actual bug finding than the previous phases.

In order to capture the expected behavior of the RTL in operations, it is important to create a high-level view of the operation that is compact and tries to capture the specification as obviously as possible. Therefore, this chapter also focuses on how to create compact and easy to understand high-level views of operations.

Phase three terminates once the core functionality is completely verified. This means that all outputs and visible registers are *determined* in the operation properties: they have been proven to always have a value that only depends on visible registers and inputs. The determination test of the completeness analysis makes sure that the value of no visible register or output depends on anything but inputs and visible registers.

Phase three only focuses on the functionality manually defined as core functionality at the beginning of the GapFreeVerification process. Any gaps in the verification of core functionality in terms of missing operations will be identified in phase four when all remaining gaps are found. Phase three just makes sure that all operations identified so far completely verify all outputs and visible registers. The termination of phase three is certified by 360 MV in case the following conditions are met:
- The operation properties all hold on the RTL.
- The ISM for the core functionality is represented in the property graph of the completeness description.
- Only inputs of the design are listed as inputs in the completeness description.
- All relevant outputs and visible registers of the design are listed as determination requirements in the completeness description.
- All successor and determination tests hold as well as the reset assumption test, a special kind of successor test for the reset property, and the reset determination test.

The remainder of this chapter is structured as follows: the Section called *Verification of Outputs* and the Section called *Verification of Visible Registers* describe how outputs and visible registers are determined in operation properties, respectively. Executing and debugging the determination test in order to achieve termination of phase three is introduced in the Section called *Executing the Determination Test.* This concludes the description of phase three of the GapFreeVerification process.

The final three chapters are a tutorial for phase three for the three example designs for the GapFreeVerification process, the Section called *SDRAM Controller Tutorial,* the Section called *DMA Controller Tutorial,* and the Section called *VCORE Processor Tutorial.*

### Verification of Outputs

In order to start the complete verification of output signals, one just adds the outputs of the design to the *determination requirements* in the completeness description.

```
 determination_requirements:
 determined(output1);
 determined(output2);
 ...
```

It is quite natural only to add those outputs of the design as determination requirements that the specification actually talks about. However, in protocol driven scenarios, outputs often have unspecified values unless some specific protocol condition applies. As an example, consider an address output that obviously only has a defined value in case there is a request going on. Therefore, when adding the determination requirements for outputs to the completeness description, one should already raise the question if the output indeed needs to be determined always or if there just is some condition under which the output needs to be determined. This is called a *conditional* determination requirement.

```
 determination_requirements:
 if valid_o then determined(data_o) end if;
 ...
```

Why should one be so careful in identifying the condition under which an output has a specified value? It is quite obvious that in the absence of such a condition, the completeness analysis will fail unless the output signal is indeed always determined in the properties. So an alternative solution would be to actually determine the output signal in all such operations. This way, one does not have to worry about exact conditions and can achieve a complete verification nevertheless.

The values of the output at those times the specification does not require a defined value is implementation dependent. Hence, rewriting the RTL in the property would allow to achieve a complete verification of the output. However, rewriting the RTL in properties should be avoided because it is additional work, accomplishes no verification, and even introduces new implementation-dependent components into the verification. Therefore, one should not blindly determine outputs until all determination tests hold, but rather identify the exact condition under which an output has a defined value in the specification.

It is possible that during an initialization sequence, outputs are undefined in the specification; they only have defined values *after* the initialization sequence. While it is possible to handle this scenario also with the help of conditional determination by finding a corresponding condition, there is a special ITL construct for just such a scenario that does *not* require you to actually find a corresponding condition in the RTL which may be time-consuming work. Assuming the initialization sequence is verified in the reset property, the section determination_domains_start can be used to specify a timepoint in the reset property that is taken as the first timepoint that the output is to be determined. Thus, by simply using a timepoint, you avoid defining a condition on the RTL. The default for this start is t in the reset property, hence, all outputs need to be determined from the cycle right after reset onwards by default. You can shift the start of the determination individually for each output; this is achieved by introducing *labels* for the determination requirements in the completeness description and referring to this label when shifting the start of the determination. 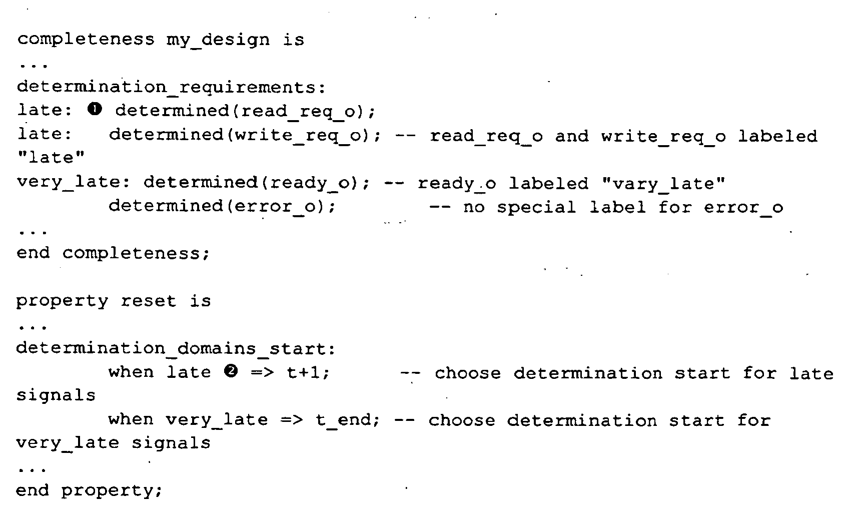
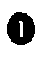 A label late is introduced for *two* outputs, namely read_req_o and write_req_o. For the output ready_o, there is a different label very_late, and error_o does not have a label.
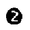 The labels are used in the determination_domains_start section of the reset property with the syntax of a case statement in order to start the determination of the late signals at t+1. For the very_late signal ready_o, determination starts only at t_end, a local time variable in the reset property.

In a complete verification, any possible input trace is covered by a sequence of operations. Therefore, determining an output just means that the sequence of operations determines the output. Operations overlap at least at their hooks, that is, the right hook of an operation equals the left hook of the succeeding operation. Hence, at least at the hooks, two operations are active simultaneously, and it is not clear which of the two operations is supposed to determine an output at the hook: should the preceding operation determine the output at the right hook or the succeeding operation at the left hook? The answer actually differs depending on the concrete output under examination.

The time interval for which an operation is supposed to determine an output is called the *determination domain* of the output. Therefore, the above question can also be rephrased: Does an operation determine its outputs during [left_hook, right_hook-1] or during [left_hook+1, right_hook]? In both cases, a sequence of operations determines the output always. The concept of a determination domain is illustrated in Figure 5-2. A sequence of operations overlapping only at their hooks is shown and three different types of outputs are visualized with their respective determination domains as colored time intervals. The color of the determination domain identifies the operation responsible for determining the output in that interval. These three types of outputs are described in detail in the following.

### Figure 5-2. Determination Domains of Output Signals

The normal case are *registered* outputs. This means that a change of inputs or visible registers only influences the output with one cycle delay. Therefore, an operation cannot sensibly verify the value of a registered output at the beginning of the operation: the operation just starts at the left hook and therefore, it cannot have influenced the output yet. This means that the value of the output at the left hook only depends on the *previous* operation, not the current one. Therefore, it is the task of the previous operation to actually verify this output at its right hook. Consequently, any operation verifies this output at its right hook, but not at its left hook. In summary, the determination domain for normal registered outputs is during [left_hook+1, right_hook]. Since the completeness analysis regards registered outputs as the default, no additional hint to the completeness analysis is needed in this case.

Naturally, some outputs in the RTL may also be combinational. This means that they are directly influenced by the current value of inputs and visible registers. Therefore, any operation needs to verify the output behavior one cycle earlier than in the registered case. This means that the determination domain for combinational outputs is during [left_hook, right_hook-1]. This also reflects the fact that the operation itself influences the combinational output at the left hook, but the value at the right hook already depends on the *next* operation. For combinational outputs, completeness analysis requires an additional hint. Since the standard domain is shifted by one cycle to the left, an end offset of-1 is given in the determination requirements.

```
 determination_requirements:
 determined(combinational_output), end_offset=-1;
```

Note that in some cases, the completeness analysis may also hold in case a combinational output has *not* been declared with a proper end offset. However, always declaring the end offset explicitly has the advantage that one can naturally develop the operations to examine the output in the determination domain specified in the completeness description.

Similarly, registered outputs may be delayed further by adding another register. For these outputs, the determination domain is shifted to the right to during [left_hook+2, right_hook+1]; the corresponding hint to the completeness analysis defines an end offset of +1.

```
 determination_requirements:
 determined(doubly_delayed_output), end_offset=+1;
```

Any further constant delay of outputs can be taken care of by shifting the determination domain with the help of the end offset. For cases involving pipelines with stalling where a constant shifting of the determination domain may turn out not be enough, see (extended part).

In the following, we distinguish between the verification of control signals and the verification of data signals.

### Control Outputs

Typically, control signals need to be always verified. As an example, consider a control output signaling an access on a bus. It is not only important to verify that the output is activated according to protocol, but also that it is not activated anytime else. Hence, control signals typically require unconditional determination requirements and their determination domain needs to be taken into account.

There are also control signals that depend on other signals. Consider a signal distinguishing between a read and write access. Such a signal typically only has a defined value in the specification if there is a request at all. Therefore, control outputs also may require conditional determination requirements.

The actual value some control signal has at some time typically only depends on the protocol; hence there is no actual result computation for control outputs. Capturing the intended behavior of control signals in operations is therefore straightforward: at the time specified by the protocol, operations need to verify that the control signal is activated, while it remains inactive for the rest of the operations.

### Data Outputs

In contrast to control outputs, data outputs are typically only defined under certain conditions. Hence, data outputs require a conditional determination requirement in order to avoid verifying implementation-dependent values. In the operations, the value of the data outputs is only described at the dedicated times prescribed by the protocol. The protocol aspect of the verification is further illustrated in the Section called *Protocol verification.*

For data outputs, the actual computation of the *result value* of the output is important. The simplest form that such a computation can take is to copy data from some inputs to the outputs. A more elaborate form might add two input values in order to compute the result value for the output.

In the specification, the computation of a data output is expressed in terms of visible registers and inputs since only these are observable in the specification. For a complete verification, the result computation for a data output therefore needs to be based on inputs and visible registers only. Inputs need to be sampled only at the dedicated time where they are relevant according to the specification; visible registers are always sampled at the beginning of the operation, the left hook.

In case there are several operations with similar computations or the same computation occurs for several operations, it is a good idea to capture the computation itself with a macro. This macro takes as inputs the visible registers and inputs that are relevant for the result computation as well as an additional parameter selecting for which operation the result is to be computed. The macro then returns the result of the computation. Note that such a macro is completely independent of the implementation; it just rephrases part of the specification. Hence, result computation macros need to be reviewed after completing a verification with the GapFreeVerification process in order to check that they really capture the specification.

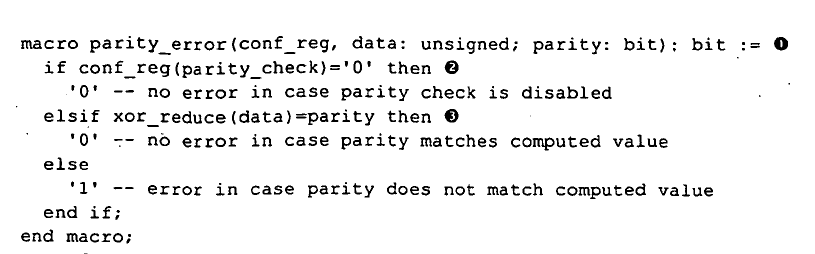

The above macro illustrates a simple example for a result computation macro. The design under verification can be configured to check the parity and output an error in case the computed parity of some data does not match a given parity bit. 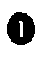
The macro takes as arguments the visible register conf_reg where bit parity_check encodes whether parity is to be checked, and the inputs data and parity. Its return value is an error bit. 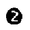
In case parity check is deactivated, the design must never signal an error. 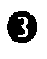
If, on the other hand, parity needs to be checked, the parity of data is computed with xor_reduce and compared to the expected parity. A parity error occurs if and only if they do not match.

A result computation macro is simply instantiated in an operation by passing the concrete visible register and input values to its parameters. Note that like in all visible register computation, the visible registers are taken from the left hook of the operation and the inputs from the dedicated protocol times. In the example below, a parity error is computed at t_end based on the data and parity inputs from the same cycle.

```
 property operation_with_parity_check is
 freeze:
          conf_reg_f = conf_reg @ t; -- read visible register at left hook
 assume:
 ...
 prove:
 ...
 -- use computation macro to determine parity error err_o
 at t_end: err_o = parity_error(conf_reg_f, data_i,parity_i);
 end property;
```

### Protocol Verification

The input/output interface of a design typically adheres to some protocol which is specified with the help of timing diagrams. These timing diagrams describe how *transactions* like a read access are translated into protocol signals. It is therefore also a goal of a complete verification according to the GapFreeVerification process to capture the transaction level in operations. This transaction level is then mapped to the concrete protocol in the implementation much like the visible register mapping discussed in the Section called *Introducing Visible Registers* in Chapter 4. However, in contrast to a visible register mapping, a transaction level for protocols just relates to inputs and outputs of the design; hence, it is much easier to get a transaction level protocol description right than to get a visible register mapping right.

The actual task of developing a transaction level description for a protocol is split into two parts. The first is just to capturing dedicated protocol timepoints, and the second to express the protocol with the help of these protocol timepoints.

### Figure 5-3. Timing Diagram for a Protocol

As an example, consider a simple request-acknowledge protocol as depicted in the slave_* signals of Figure 5-3. After sending a slave read request in cycle 2, the design *waits* for an acknowledge from the slave before it proceeds. This acknowledge does not arrive after a fixed amount of cycles, but a *variable* amount of cycles. In the particular example in Figure 5-3, the acknowledge arrives in cycle 6. Hence, one needs to define a timepoint t_ack equaling the time the acknowledge arrives in order to describe the part of the transaction after the acknowledge arrives. In Figure 5-3, the slave request is sent in cycle 2 and the acknowledge arrives 4 cycles later in cycle 6.

```
 for timepoints:
         ...
 ··· t_ack=t_slave_req+1..4 waits_for slave_ack_i='1'; -- timing
 ...
```

The above ITL code expresses that t_ack is the first timepoint after t_slave_req where the input slave_ack_i is asserted. In addition, only wait periods up to 4 cycles are taken into account. This is due to the fact that with 360 MV, a *single* property can only examine a limited time, that is no infinite waits. Hence, a suitable maximum length for wait periods has to be chosen and a corresponding constraint that the waiting lasts only that long has to be added to the verification. Note that a verification with the GapFreeVerification process still shows that arbitrarily long traces from reset have been completely verified, not just bounded traces.

Based on these timepoints, transactions are captured in so-called *temporal* macros. These macros take the protocol timepoints as arguments; in case the transaction also involves data like a read transaction, the correct data is a also passed to the macro as an argument. Based on these parameters, the temporal macro then expresses the protocol transaction. As an example, consider the macro below encoding a master read according to Figure 5-3.

```
 macro master_read(t_req, t_end: timepoint; read_data: unsigned): temporal
 := during [t_req+1, t_end-1]: master_busy_o='1'; -- busy until end of
 access
         at t_end: master_ready_o='0'; -- not busy at end of
 access
         at t_end: master_data_o=read_data; -- correct data
 returned
 end macro;
```

The protocol requires that master_busy_o is signaled until the access ends. In the cycle the cycle that the access ends, the actual data word that is supposed to be read by the access is available at master_data_o. In the actual property, the declaration of the protocol timepoints and the instantiation of the protocol macros needs to be combined. This is illustrated in the following property.
**Note:** how to handle read data properly?
in this example, data for a read is "just" frozen in read_data. should the transaction macro also check (redundantly) for the data, i.e., read_data be an argument of the transaction macro slave_read? in principle, yes, although it looks kind of artificial to check the freeze against itself in the macro.
I guess the real "clean" thing would be to replace the freeze read_data by a declare. In that case, the slave-read temporal could just fix the value of read_data and master_read could just use it. But declares have their own problems with completeness, so we'll have to live with the redundancy of declaring the freeze and checking it against itself in the temporal macro. 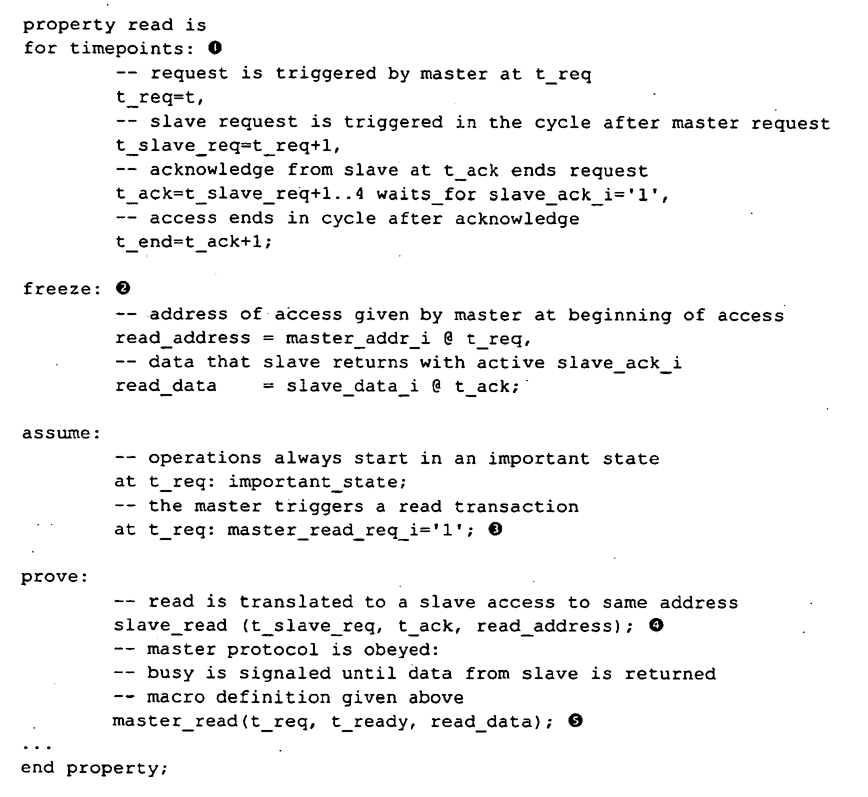
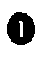 The protocol timepoints are declared. t_req denotes the time a new request starts, t_slave_req the time the corresponding slave request starts, t_ack the time after a request where the slave gives its acknowledge, and t_end the time the master request ends.
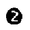 The relevant data inputs for the protocol access are sampled at the dedicated protocol timepoints. Here, the address of the access is sampled at the time the request is given and the data to be returned to the master at the time the slave acknowledges valid data.
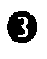 According to the specification, a read request is triggered by asserting master_read_req_i.
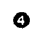 The master access is translated to a slave access at the same address. Hence, the address of the master access and the beginning and end of the slave access need to be passed as parameters to the temporal macro slave_read,
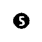 The data returned by the slave and the beginning and end of the access are passed to the macro master_read that checks that the master access is finished according to protocol.

### Verification of Visible Registers

The concept of visible registers has already been introduced in as part of phase two of the GapFreeVerification process in the Section called *Visible Register Mappings* in Chapter 4. Since visible registers are observable in the specification, the verification of a visible register in phase three must ensure that the visible register is updated exactly as specified and that the current value of the register influences the output computation exactly as specified. In the terminology of completeness, this means that visible registers only need to be determined at the right hook. On the other hand, all visible registers need to be determined in all operations, including reset. As introduced in the Section called *Visible Register Mappings* in Chapter 4, this can be ensured by adding a *local* determination requirement to the completeness description for every visible register according to the specification. During phase three, the local determination requirements for those visible registers that are *not* used in the computation of triggers are added to the completeness description.

One of the challenges of phase three is therefore to find all the visible registers in the RTL. In phase two, one uses back-tracing of a trigger condition in order to find out how a visible register is implemented. In phase three, one only adds a visible register to the local determination requirements once determining the output of an operation fails since the output depends on this visible register. In that case, one can also use back-tracing of the output in order to find out how a visible register is implemented. In addition, if some actual implementation documentation is present, this will typically describe the implementation of visible registers explicitly. Note that it is not really required to choose an actual *register* in the RTL to be mapped to the visible register macro; it is perfectly all right to choose arbitrary signals.

In processor pipelines, there is an alternative approach to identify the typically complex visible register mapping. It is quite straightforward to actually find the implementation register file in the RTL. From that register file, one can then trace back through the earlier pipeline stages how and when the implementation register file is updated. This procedure is sure to end up with the right mapping for the visible register file since *all* updates of the implementation register file are taken into account. The reverse approach, that is, starting with forwarded data that is read from the register file, may actually return incomplete results since some forwarding paths may not be implemented. See the tutorial example on processors in the Section called *Visible Register Mapping* for further details.

Since a complete verification cannot be compromised by the choice of a wrong mapping for a visible register as discussed in the Section called *Soundness of Visible Register Verification,* one should simply *try out* candidates for the visible register mapping that look good. If a candidate works out with both property checking and completeness, we consider the mapping to be correct. Note that during the verification of the extended functionality in phase four, it may turn out that the visible register mapping needs some further refinements to actually work with all operations. In this way, a visible register mapping may be built incrementally like an important state.

In some advanced pipelines, visible registers are read at the right hook of an operation and may only be determined at the right hook of the *succeeding* operation which, in turn, depends on a time variable. For the handling of these cases, please refer to (extended part).

In general, a visible register mapping is built on a lot of implementation signals. It is one of the goals of a complete verification according to the GapFreeVerification process to fully determine all visible register mappings. For complex visible register mappings like the ones discussed in the Section called *Introducing Visible Registers* in Chapter 4, this does *not* mean that actually all the implementation signals that the visible register mapping is built from are determined, but just that the visible register mapping itself is determined. This is illustrated below.

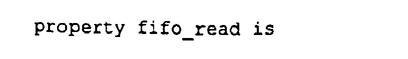

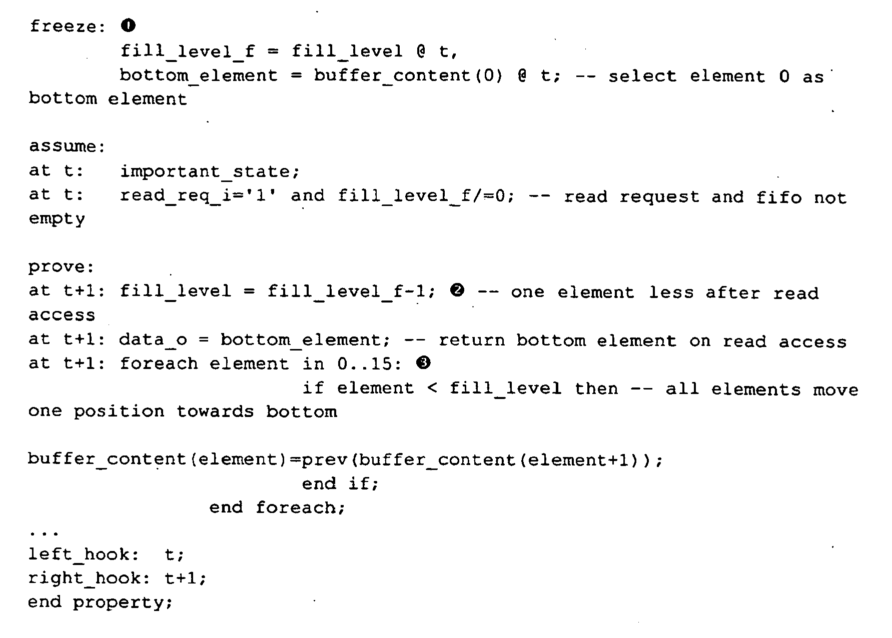

The above property is about a read access to a fifo. The property applies to the case where there fifo is not empty. The property proves how the visible registers fill_level and buffer_content are updated and the data output data_o is computed. Note that both fill_level and buffer_content may be complex macros like the ones introduced in the Section called *Introducing Visible Registers* in Chapter 4.
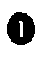 . The visible registers are sampled at the beginning of the operation using their visible register mappings fill_level and buffer_content (0).
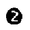 The new value of fill_level is just a decremented version of the old value. Note that since the assumption excludes the case that the old fill level was 0, the decremented value is still not negative. In addition, the data output is just the old bottom element in the fifo. If the property holds, it determines both fill_level and data_o regardless of the content of the visible register mapping for fill_level or buffer_content.
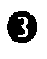 The property checks the fill_level elements of the buffer after the read operation have moved one position towards the bottom of the fifo. Again, a holding property determines the bottom fill_level elements of buffer_content independent of the content of the visible register mapping.

In this way, a complete verification of the fifo neither determines the read counter nor the write counter of the implementation explicitly. Instead, the verification just determines how many elements there are in the fifo and what these elements are regardless of the way the fifo is implemented in hardware.

As this example shows, it is possible to determine a visible register without explicitly determining any of the signals it consists of. What is more, one should not even try to determine all the signals in a visible register mapping. This defies the purpose of the visible register mapping, namely to hide the implementation details and make the high-level property independent of the implementation.

As has been stated in the Section called *Verification of Visible Registers,* all visible registers need to be verified in all operations at the right hook which is ensured by a local determination requirement in the completeness description. In particular, this means that a complete verification according to the GapFreeVerification process needs to verify that visible registers do not change when they are not supposed to change.

In addition, verification must make sure that all visible registers are properly initialized according to the specification. To that end, the initial values need to be collected in the specification and the reset operation needs to prove that the visible registers have these initial values after reset. However, there are also cases where a specification gives initial values of visible registers as *implementation dependent.* Like all implementation dependent behavior, this behavior should not be part of a verification according to the GapFreeVerification process. In order to achieve a complete verification of the visible registers, it is therefore necessary to declare those visible registers whose initial value is indeed implementation dependent accordingly. This can be done by adding the visible register to a special section in the completeness description.

```
 allow_uninitialized:
 uninitialized_visible_register_1,
 uninitialized_visible_register_2,
 ... ;
```

This treats the arbitrary value that a visible register holds after reset as a *determined* value. In other words, the completeness analysis does *not* require you to determine the value in the reset operation, much like what could be achieved with a conditional determination requirements, but for succeeding operations, the register then is determined. The fact that the register is treated as determined for the next operation is the crucial difference to a conditional determination requirement. Note that this treatment of visible registers concerns only the reset operation and that the verification needs to treat all visible registers alike after the reset operation, whether they are properly initialized or not.

Since most visible registers typically are not modified during an operation, visible register verification mostly consists of checking that they keep their old value. To that end, the value of the visible register is sampled at the beginning of an operation, that is the left hook, and at the right hook, the operation checks that the new value of the visible register equals the sampled one from the left hook.

In case a visible register is updated, the computation of the new value at the right hook needs to be described in terms of sampled old values of visible registers at left hook and input signals. This is just like the computation of the result values of data signal outputs as described in the Section called *Data Outputs.*
Note: some operations may produce undefined results in visible regs according to spec. concept of "allow_undetermined" for visible registers needed to handle that case properly in a complete verification (this is just an extension of "allow_uninitialized"). requires extension of completeness
Note: if verification is carried out at lower level of abstraction than spec, more registers may become visible due to the lower level of abstraction, but this is a topic for the extended part

### Debugging of Visible Register Mappings

In case a property fails due to a visible register mapping not returning the value expected by the specification, there are three possibilities as to the cause.
- There is a reachability issue which means nothing is wrong with either the RTL or the visible register mapping.
- The visible register mapping is wrong and the RTL is right.
- The RTL is wrong and the visible register mapping is right.

With the techniques introduces in the Section called *Bounded Proof from Reset* in Chapter 4, one can find out whether reachability is the cause of the failing property and act accordingly. In case the counterexample also happens from reset, one needs to locate the discrepancy between the property and the RTL. To that end, the property is split into three parts with corresponding intermediate proof goals that allow for a focused debugging of the counterexample.
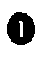 the reading of source operands via visible register mappings
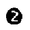 the computation of a result value based on these source operands
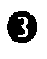 the saving of the result in the visible register

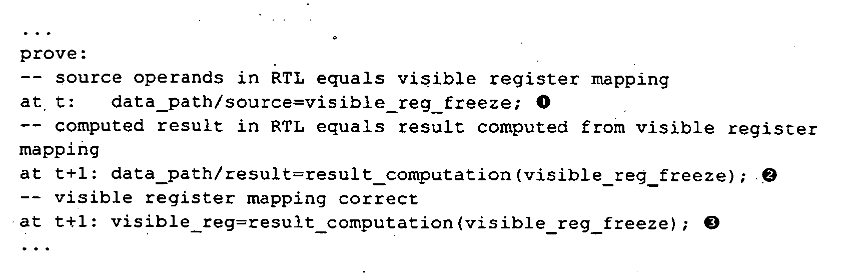

Therefore, we identify the signals in the RTL that hold the source operands and those that hold the result. We then add as an intermediate proof goal that source operand signal in the implementation equals the expected visible register mapping 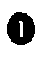 and that the result signal in the implementation equals the result as computed according to the specification 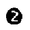 . Depending on which of the intermediate proof goals fails, we act accordingly.
1. If the source operand implementation signal does not equal the visible register mapping, either the forwarding in the RTL is wrong or the visible register mapping is wrong. In order to disambiguate, a trace from reset is examined and one needs to compute the value of the visible register for this trace according to the specification *manually.* If this value equals the one returned by the visible register mapping, an actual bug has been identified in the RTL since the RTL then reads a wrong value. If, on the other hand, the manually computed visible register equals the one delivered by the source operand implementation signal, the visible register mapping obviously needs some refinement in order to take that particular trace into account.
2. If the source operand implementation signal equals the expected value, but the result does not, diagnosis is very easy: either the result computation in the property or the RTL is wrong. A comparison with the expected result computation in the specification answers this question.
3. If both intermediate proof goals hold, but the visible register mapping *after* the operation fails, this means that the correct result of the operation as computed by the implementation does not find its way into the visible register mapping. Thus, either the visible register mapping is wrong or the *update* of the implementation register in the RTL has a bug. The best way to debug this scenario is to consider any *succeeding* operation reading the register causing these problems and apply the techniques described for wrong source operands.

### Soundness of Visible Register Verification

One of the questions that typically come up during a verification with visible registers and their mapping to the implementation is the danger involved in getting the visible register mapping *wrong.* In other words, can the result of a complete verification be compromised by poorly chosen mappings of visible registers and thus create the false confidence that a design is correct with respect to its specification?

### Figure 5-4. Visible Register Mappings in Complete Verification

Intuitively speaking, it is true that the actual content of a visible register mapping typically has to look deeply into the implementation. But the crucial thing about using this mapping is that *all* operations actually prove that this mapping behaves *exactly* like the visible register does in the specification. Hence, property checking and completeness analysis make sure that the mapping is actually right.

Let us look at visible register mappings in a little more detail. In case there is something wrong with the mapping, either some property or completeness are sure to fail. Figure 5-4 tries to illustrate this with the help of a simple diagram. The upper part stands for the high-level view of the operation containing the visible register only by named macro. The lower part is about the low-level view of the operations, thus containing the fully mapped visible register with all its implementation signals. The left-hand side of the diagram captures the visible registers before an operation and the right-hand side those after the computation of the operation.

The completeness analysis ensures that on the high-level view, operations only depend on inputs and visible register macros. Hence, the visible register macro is used consistently in the high-level view. In addition, property checking ensures that this high-level view corresponds to the low-level implementation view, both before and after the operation - otherwise, the property is sure to fail. In summary, property checking plus completeness analysis for one operation make sure that there is *something* in the implementation that behaves exactly according to the specification for the visible register for this particular operation, namely the content of the visible register macro.

Since True Functional Sign-Off requires the proof of *all* operations and their completeness, this means in particular that there can be no more missing operations. The low-level registers according to the visible register mapping *always* behave as specified for the visible register. There is just no more chance of the visible register mapping being wrong in this case.

### Tutorial Examples

SDRAM controller
see the Section called *Visible Registers*

DMA controller
see the Section called *Visible Registers*

VCORE processor
see the Section called *Visible Registers*

### Executing the Determination Test

The main termination criterion for phase three is that all outputs and visible registers are determined. This means that both the normal determination tests as well as the reset determination test hold. In order to achieve that goal, the completeness description is first enhanced by a determination requirements section listing the outputs of the design as described in the Section called *Verification of Outputs.* In addition, the visible registers not identified in phase two are added to the completeness description as well.

The determination test then checks whether a property determines all its outputs and visible registers listed in the completeness description. This means that the visible registers at the right hook and the outputs are proven to always have a value that only depends on visible registers at the left hook and inputs. The reset property must determine all its outputs and visible registers only based on inputs since there is no preceding property that could determine the visible registers. In case some visible register have implementation-dependent initial values according to the specification, this may be captured as described in the Section called *Verification of Visible Registers.* To sum up, the determination test discovers all scenarios where even a single output or visible register is not uniquely determined. The debugging of failing determination tests is described in the next section.
mv> check completeness -reset determination
mv> check_completeness -determination (my_prop my_prop)
mv> check_completeness -length 1 -determination {* my_prop}

Similar to the successor test, the determination test can be carried out with a length of 1 to increase performance.

### Debugging a Failing Determination Test

A determination test fails if an output or visible register is not determined in a property. Note that the determination of a visible register or an output is called *determination requirement* in the completeness analysis. Hence, a determination test fails if at least one determination requirement fails. This is characterized by two different traces with common values for visible registers at the left hook and for inputs; in addition, the property under examination holds in both traces. However, some determination requirement is violated, that is a visible register at the right hook or an output has two different values in the two traces. Since both traces have common values for visible registers at the left hook and for inputs, the failing determination requirement must depends on additional signals.

A counterexample for the determination test shows these two traces, the property under examination which holds in both traces, and the failing determination requirements which are colored in red. Similar to the successor test, the first trace is called *witness* and the second one *counterexample.* It is the task of the verification engineer to analyze how the failing determination requirement is verified in the property and find the additional signals in the property apart from visible register and inputs that the failing determination requirement depends on. Based on this analysis, the cause of the failing determination requirement can be identified.
- A visible register at the right hook or an output has simply been forgotten to describe in the property or its description does not only depend on inputs and visible registers. In that case, phase three simply has to be applied to this visible register or output in order to achieve a description based only on inputs and visible registers. Note that in case the completeness checks are carried out with length one, a missing important state at the right hook of a property also falls into this category.
- A failing determination requirement is caused by a signal that is supposed to be an input, but has been forgotten to add to the inputs in the completeness description. Adding the missing input to the completeness description closes the gap.
- A failing determination requirement is caused by a visible register that has been forgotten to add to the local determination requirements in the completeness description. Adding the missing visible register to the completeness description closes the gap. Note that in case a visible register is added to the completeness description, all determination tests should be re-run since they now have to check for the determination of an additional visible register.
- A failing determination requirement is caused by a visible register that is not read at the left hook. In this case, the property has to be modified in order to read the visible register only at the left hook and thus close the gap. Note that the property has to be re-checked in order to find out whether the visible register mapping is still correct, that is the property still holds.

### SDRAM Controller Tutorial

Note: This section is supposed to contain the application of phase 3 to the sdram controller. it is structured into several sections which, in turn, are referenced at the point in the documentation where the corresponding concepts are introduced very much work in progress, still.

### Visible Registers

In the SDRAM controller, there appears to be no visible register. However, there is only one visible register, although it is slightly hidden (see the Section called *Specification* in Appendix A). If an access has the same row address as the previous access, it can be carried out quickly without precharging first. Hence, the row address of the previous access is a visible register.

### Capturing the Protocol in Macros

### TBD

### DMA Controller Tutorial

Note: This section is supposed to contain the application of phase 3 to the dma controller. it is structured into several sections which, in turn, are referenced at the point in the documentation where the corresponding concepts are introduced very much work in progress, still.

### Visible Registers

In the DMA controller, there are several visible registers accessible via memory mapping (see the Section called *Specification* in Appendix B).

```
 command
    2-bit command register, found at address 0x80000000
 
 source_address
    32-bit source address register, found at address 0x80000004
 
 target_address
    32-bit target address register, found at address 0x80000008
 
 transfer_length
    32-bit transfer length register, found at address 0x8000000C
 
 parity_check
    1-bit parity check register, found at address 0x80000010
```

Such a set of memory mapped registers is handled by adding a macro *addr_cfg_reg* for each configuration register that returns the address of the register according to the above list. In addition, we introduce a macro cfg_reg that takes an unsigned parameter, the address of the register, and returns the visible register. Since we have not found out yet how the visible registers are implemented in the DMA controller, we end up with the following intermediate ITL code:

```
 macro addr_command : unsigned := x"80000000"; end macro;
 macro addr_source_address : unsigned := x"80000004"; end macro;
 macro addr_target_address : unsigned := x"80000008"; end macro;
 macro addr_transfer_length: unsigned := x"8000000C"; end macro;
 macro addr_parity_check : unsigned := x"80000010"; end macro;
 
 macro cfg_reg(addr: unsigned): unsigned :=
          case addr is
          when addr_command =>
                     0; -- dummy value until register is found in implementation
          when addr_source_address =>
                     0; -- dummy value until register is found in implementation
          when addr_target_address =>
                     0; -- dummy value until register is found in implementation
          when addr_transfer_length =>
                     0; -- dummy value until register is found in implementation
          when addr_parity_check =>
                     0; -- dummy value until register is found in implementation
          when others =>
                     0; -- non-existing registers always return 0 according to
 specification
          end case;
 end macro;
```

### Visible Register Mapping

actually finding the visible register in the implementation

```
 macro addr_command : unsigned := x"80000000"; end macro;
 macro addr_source_address : unsigned := x"80000004"; end macro;
 macro addr_target_address : unsigned := x"80000008"; end macro;
 macro addr_transfer_length: unsigned := x"8000000C"; end macro;
 macro addr_parity_check : unsigned := x"80000010"; end macro;
 
 macro cfg_reg(addr: unsigned): unsigned :=
          case addr is
          when addr_command =>
                     zero_ext(data_path_i/command,32); -- unused bits
 return 0
          when addr_source_address =>
                     data_path_i/src_addr;
          when addr_target_address =>
                     data_path_i/tgt_addr;
          when addr_transfer_length =>
                     data_path_i/transfer_len;
          when addr_parity_check.=>
                     zero_ext (data_path_i/parity_result,32); -- unused bits
 return 0
          when others =>
                     0; -- non-existing registers always return 0 according to
 specification
          end case;
 end macro;
```

### Verification of Visible Registers

update + initial value of visible register

```
 macro addr_command : unsigned := x"80000000"; end macro;
 macro addr source address : unsigned := x"80000004"; end macro;
 macro addr_target_address : unsigned := x"80000008"; end macro;
 macro addr_transfer_length: unsigned := x"8000000C"; end macro;
 macro addr_parity_check : unsigned := x"80000010"; end macro;
 
 macro cfg_reg(addr: unsigned): unsigned :=
          case addr is
          when addr_command =>
                     zero_ext(data_path_i/command,32); -- unused bits
 return 0
          when addr_source_address =>
                    data_path_i/src_addr;
          when addr_target_address =>
                    data_path_i/tgt_addr;
          when addr_transfer_length =>
                    data_path_i/transfer_len;
          when addr_parity_check =>
                     zero_ext(data_path_i/parity_result,32); -- unused bits
 return 0
          when others =>
                    0; -- non-existing registers always return 0 according to
 specification
          end case;
 end macro;
 macro write_mask(addr: unsigned): unsigned :=
          case addr is
          when addr_command =>
                    x"00000003"; -- command register consists only of 2 bits
          when addr_parity_check =>
                    x"00000001"; -- command register consists only of 1 bit
          when addr_source_address |
                    addr_target_address |
                     addr_transfer_length =>
                    x"FFFFFFFF"; -- address and length are 32 bit registers
          when others =>
                    x"00000000"; -- no other register exist, so there are no
 writeable bits
          end case;
 end macro;
```

### VCORE Processor Tutorial

Note: This section is supposed to contain the application of phase 3 to the vcore processor. it is structured into several sections which, in turn, are referenced at the point in the documentation where the corresponding concepts are introduced. very much work in progress, still. **Visible Registers** In the VCORE, there are the typical visible registers of a processor: the program counter PC and the 8 registers in the general purpose register file (see the Section called *Instruction Architecture Manual* in Appendix C).

### Visible Register Mapping

By investigating the RTL regarding signals that might implement the PC, we find three possible candidates, namely dec_PC, ex_PC, and next_PC. The name dec_PC seems to suggest this is the PC in the decode stage. Therefore, we pick dec_PC as the mapping of the visible register PC.

```
 macro unsigned PC:=
          dec_PC;
 end macro;
```

For the register file, we start to look for an array of 8 16-bit words in the RTL. This array exists under the name register. In order to find the complete visible register mapping, we start to trace how register is actually updated. This way, we encounter

```
          if (wb_write_reg)
                     register[wb_dest_reg] <= wb_result;
```

and thus have found the writeback stage of the VCORE. This leads to the following first step for the virtual register definition:

```
 macro unsigned virtual_register(unsigned r) :=
          if (wb_write_reg && wb_dest_reg == r)
                     wb_result
          else
                     register[r]
          endif;
 end macro;
```

Note that the above piece of ITL just recodes the update of the register file in the writeback stage. As a next state, the wb_* signals are traced further back through the pipeline. This leads to the execute stage of the VCORE.

```
          if (!mem_stall)
                     begin
                                ... ;
                                wb_write_reg <= ex_write_reg;
                                wb_result <= real_ex_result;
                                wb_dest_reg <= ex_dest_reg;
                     end
```

The writes in the execute stage of the VCORE are also added to the virtual register definition as follows.

```
 macro unsigned virtual_register(unsigned r) :=
          if (ex_write_reg && ex_dest_reg == r)
                     real_ex_result
          elseif (wb_write_reg && wb_dest_reg == r)
                     wb_result
          else
                     register[r]
          endif;
 end macro;
```

### Capturing Computations in Macros

In a processor, there are typically many arithmetic and logic instructions whose computation is quite similar. Therefore, the result computation of these instructions is captured with a macro that takes the opcode of the instruction and the different possible operands according to the specification as parameters. In addition, macros are introduced that slice the different fields from the instruction word according to the specification. Note that in a more complex processor, the location of a certain field in the instruction word is riot just a fixed slice, but typically also depends on the instruction layout.

```
 macro unsigned field_opcode(unsigned iw) := iw[15:11]; end macro;
 macro unsigned field_A (unsigned iw) := iw[10: 8]; end macro;
 macro unsigned field_B (unsigned iw) := iw[7: 5]; end macro;
 macro unsigned field_D (unsigned iw) := iw[4: 2]; end macro;
 macro unsigned field_imm5 (unsigned iw) := iw[4: 0]; end macro;
 macro unsigned field_imm8 (unsigned iw) := iw[7: 0]; end macro;
 macro unsigned instr_result(unsigned opcode, Ra, Rb) :=
         case (opcode)
         5'h00: -Ra; -- not instruction
         5'h01: (Ra+Rb) [15:0]; -- add instruction
         5'h02: unsigned(Ra-Rb) [15:0]; -- sub instruction
         default: undefined(16);
         endcase;
 end macro;
```

### Capturing the Protocol in Macros

### TBD

### Chapter 6. Phase Four: Verification of Extended Functionality

### Overview

- protocol constraints
- completeness dependencies
- complete time variables

### Introduction

In the first phase of the GapFreeVerification process, the design is partitioned into core functionality and extended functionality; the core functionality is then verified in the first three phases. Therefore, the work in phase four can be split into two steps:
1. verifying the operations that have been identified in phase one, but postponed to phase four due to their classification as extended functionality
2. identifying and closing all remaining gaps in the verification.

The first step, namely the verification of extended functionality that has already been identified at the beginning of the verification does in no way differ from the verification of core functionality; after all, the split between core functionality and extended functionality is completely arbitrary. In other words, verifying the extended operations that have already been identified in phase one is just a simple re-application of phases one to three for these operations. Since the core functionality is already fully verified at this point, applying phase one to three to the operations of the extended functionality is typically straightforward because a significant part of the problems of the verification, both in terms of abstraction and reachability, have already been solved. Since the first step from above is described in the first three phases, the remaining part of this chapter just focuses on the second step, namely automatically identifying all remaining gaps in the verification and closing them.

Note that after the first step, a complete verification of the operations that have been *manually* identified at the beginning of the verification has been carried out. In other words, all the operations from the manual verification plan have been verified. Conventional verification would stop at his point since the whole manual verification plan has been exercised. The GapFreeVerification process, on the other hand, does not terminate at this point since it is quite likely that there are still gaps in the verification.

The work in phase four mainly consists of three tasks. A detailed description for each of these tasks is available in the three subsequent sections.
1. Consistently use protocol constraints in property verification instead of implicit constraints in assumptions.
2. Properly handle time variables which are used to approximate unbounded waiting periods. Note that no special treatment for such time variables was required in the first three phases.
3. Add the restrictions of the verification to the dependencies of the completeness description.

In phase four of the GapFreeVerification process the automated completeness analysis is used in order to identify *all* remaining gaps in the verification. In particular, the focus is on the so-called case split test of the completeness analysis. This test answers the simple question whether, given some operation, there exists a succeeding operation in all possible scenarios. Note that the case split test in phase four actually drives the three main tasks listed above. In other words, a failing case split test is the starting point for the real work in phase four. This failing case split test is then analyzed and an appropriate action is taken. Further details on the case split test and its debugger are given in the Section called *Executing the Case Split Test.* Finally, the termination criterion for phase four consists of the following conditions:
1. The operation properties all hold on the RTL.
2. Only inputs of the design are listed as inputs in the completeness description.
3. All relevant outputs and visible registers of the design are listed as determination requirements in the completeness description.
4. The complete ISM (including the extended functionality) is represented in the property graph of the completeness description.
5. The set of properties is complete, that is all completeness tests hold.

The only thing that remains to be done after the termination of phase four is a final manual review of the verification code as discussed in Chapter 7.

The remainder of this chapter is structured as follows: The three main working tasks in phase four are described in the Section called *Protocol Constraints,* the Section called *Dependencies in the Completeness Description,* the Section called *Complete Time Variables.* Executing and debugging the case split test in order to achieve termination of phase four is introduced in the Section called *Executing the Case Split Test.* This concludes the description of phase four of the GapFreeVerification process.

The final three chapters are a tutorial for phase four for the three example designs for the GapFreeVerification process, the Section called *SDRAM Controller Tutorial,* the Section called *DMA Controller Tutorial,* and the Section called *VCORE Processor Tutorial.*

### Protocol Constraints

During phase two of the GapFreeVerification process, the trigger conditions for operations are described only on the basis of visible registers and inputs. However, there is still the possibility that there are implicit constraints in addition to the proper trigger conditions in the assume part of the operation properties. As an example, consider a property for a read operation that only holds if the address of the incoming read request is kept stable during the whole request. In such a scenario, one may end up with the following property after phase two:

```
 property read_operation is
 ... ;
 freeze:
          addr = addr_i @ t;
 assume:
 at t: important_state; -- start state
 at t: read_req_i='1'; -- trigger
 -- inputs are stable until t_ready
 during [t+1, t_ready]: addr_i=addr;
 during [t+1,t_ready]: read_req_i='1';
 
 prove:
 ... ;
 during [t, t_ready-1]: ready_o='0'; -- added in phase three
 at t_ready: ready_o='1'; -- added in phase three
 at t_ready+1: important_state; -- end state
 ... ;
 end property;
```

The proper trigger for the operation only consists of the activation of read_req_i@t. However, the stability of the address and the request during the operation is also needed for otherwise, the property fails. According to the specification for the above example, the address and the request are to be kept stable until the request is actually served. Hence, the assumption that address and request remain stable is justified.

In such a case, one should *not* try to implicitly add this constraint to the trigger in the assume part as shown above; instead, one should go for a solution where the implicit assumption is replaced by a proper constraint and this constraint is used in the verification of the *property* itself. This has the additional benefit that all restrictions of the verification can be found in the constraints employed in the verification; they are not spread over the properties.

Note that the case split test in phase four is sure to fail if there are implicit constraints in the assumption of the properties unless there are also corresponding constraints in the dependencies of the completeness description. Hence, proper protocol constraints have to be developed anyway in the course of the GapFreeVerification process and it is more natural to use them in the verification of the properties instead of the completeness description in order to facilitate debugging.

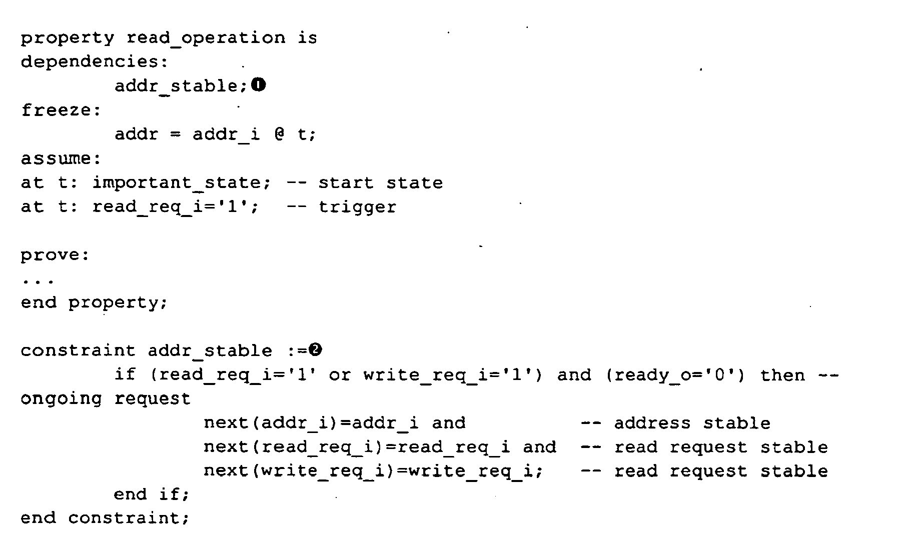

If some implicit constraint as part of the trigger of an operation is turned into an explicit constraint, this constraint is typically more general than the concrete scenario of a single operation since it applies to several operations. In the example above (see 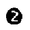 ), a constraint is created that captures *all* scenarios where the protocol requires the inputs to remain stable. The main challenge for this constraint is to characterize *when* inputs are supposed to remain stable. In this example, an ongoing access is characterized by an active read or write request, but an inactive ready since ready terminates the access. This constraint can then be used as a dependency in both the read and write operation in order to get rid of implicit constraints in the trigger conditions (see 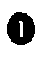 for the read operation).

### Dependencies in the Completeness Description

As has been discussed in the Section called *Protocol Constraints,* protocol constraints should be handled as dependencies in properties. Similarly, the trivial constraint about the absence of reset is also used in property checking only. To be more general, the constraints and assertions used in property checking as dependencies are typically not needed as dependencies in the completeness description. This section shows how the dependencies of the completeness description are to be used.

The general idea for the usage of constraints in the dependencies of a completeness description is to express *restrictions* of the verification. Consider a design with an incoming command over a bus cmd_i and not all possible values of the incoming command have a specified behavior. Hence, no properties are developed for these unspecified commands and the case split test fails with a counterexample showing such a command. Therefore, corresponding constraints have to be developed and used in the completeness description to complete the verification.

```
 constraint legal_command : :=
          if cmd_valid_i='1' then -- valid commands flagged by cmd_valid_i
                     cmd_i=read or -- only 3 admissible commands:
                     cmd_i=write or -- read, write, and rmw
                     cmd_i=rmw;
          end if;
 end constraint;
 
 completeness my_design is
 dependencies:
          legal_command; -- use legal_commands constraint for
 completeness
 ... -- hence, only read, write, rmw taken into
 account
 end completeness;
```

In the above example, there are three valid commands, namely read, write and rmw. Any other values are excluded in the constraint and the constraint is used only in the completeness description.

For the usage of assertions in the dependencies of a completeness description, see Part II in *GapFreeVerification Process Manual.*

### Complete Time Variables

After the completion of the first three phases of the GapFreeVerification process, operations with variable timing are encoded in properties with the help of time variables as shown in the following piece of code. Such time variables are called *normal* time variables in the following.

```
 for timepoints:
  t_ack = t_req+1..4 waits_for ack_i = '1'; -- timing
```

As described in for VHI and for VLI in the user manual, these time variables actually *assume* that the condition they are waiting for occurs in the given interval. In other words, a property with t_ack as declared above does not examine the case where ack_i is absent in the whole interval from t+1 to t+4. This means that the constraint that an acknowledge happens within 4 cycles after a request is encoded implicitly in the property instead of as a proper constraint. Note that such a constraint is typically called a *liveness* constraint since it ensures that one does not wait indefinitely for an event.

The case split test executed in phase four typically fails for normal time variables; it shows a counterexample where the event that the time variable waits for does not occur in the allotted time interval. Depending on the concrete functionality under examination, there are two different scenarios requiring individual treatment. On the one hand, the normal time variable may have been introduced in order to approximate an arbitrarily long waiting period. In this case, the implicit liveness constraint introduced by the normal time variable into the property needs to be removed; this is discussed in the Section called *Using Complete Time Variables.* On the other hand, there may be a special timeout behavior of the design in case the expected event does not occur after the maximum amount of wait cycles. In this case, a separate operation is required in order to capture the timeout behavior as described in the Section called *Using Normal Time Variables with a Timeout Property*

### Using Complete Time Variables

Following the general tenor of the Section called *Protocol Constraints,* this section focuses on how to rewrite an operation property with normal time variables in such a way that it uses an explicit liveness constraint instead of simply assuming that the corresponding event occurs. This rewriting consists of three steps:
- turn the normal time variable into a *complete* time variable
- capture the liveness constraint explicitly
- use this liveness constraint during property checking

As an example, consider the following property with normal time variables after phase three.

```
 property my_operation is
 ... ;
 for timepoints:
          t_ack = t_req+1..4 waits_for ack_i = '1'; -- timing
 ... ;
 prove:
 at t_req: req_o = '1'; -- req_o active at expected cycle
 ... ;
 end property;
```

The property just introduces a normal time variable. In addition, it prove that req_o is active at t_req since this is an output signal and phase three of the verification is already completed. Now we rewrite the property such that it no longer implicitly assumes a liveness constraint. 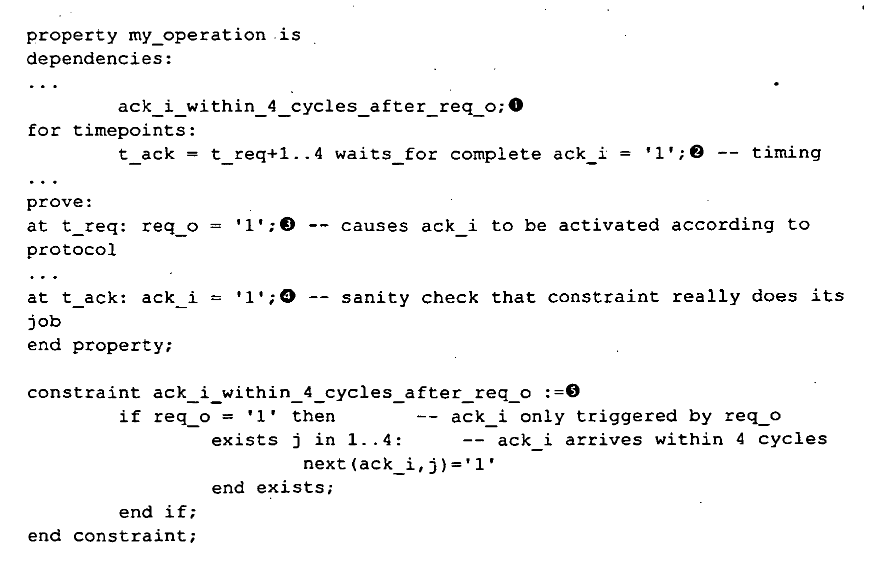
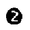 The first task in replacing a normal time variable by a complete one is just to use the keyword complete in its definition in ITL. Note that only carrying out this step typically results in a failing property since the expected event, ack_i in this case, does not occur, and the operation does not reach its end state in this case. Therefore, turning a normal time variable into a complete one needs to be accompanied by introducing and using a corresponding liveness constraint.
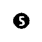 As a next step, a constraint is developed that restricts the environment behavior such that ack_i arrives within 4 cycles. However, it is typically not a valid constraint to assume that ack_i *always* arrives within 4 cycles. Instead, there is some request-acknowledge protocol going on, and it is only valid to assume that given a request, the acknowledge arrives within 4 cycles. Based on the protocol, this request signal needs to be identified; note that since this is typically an output signal, it is already described in the prove part of the property (see 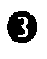 ). Note that a single liveness constraint is sufficient for all the properties relying on the fact that ack_i occurs after 4 cycles.
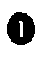 In addition, the newly developed constraint has to be used as a dependency in all properties using the complete time variable in order to make these properties hold. In order to facilitate debugging, it is recommended to carry out the final step below as well. However, the property should now hold again and the specific counterexample of the case split test that triggered the modification of the property should no longer occur.
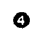 Finally, one should add a line to the prove part claiming that the desired event really occurs at the time variable; for this example, one adds that ack_i is really active at t_ack. The advantage of adding this line to the prove part is to explicitly check whether the liveness constraint correctly fits the waiting period in the complete time variable. As long as this line is colored red in the debugger, one only has to focus on getting the constraint right.

### Using Normal Time Variables with a Timeout Property

An operation with a normal time variable describing some transaction needs to be accompanied by a timeout operation describing the special behavior of the design in case a timeout is encountered. In this split of the verification between the normal operation and the timeout operation, one needs to take care to cover all scenarios. Note that as long as some scenario between the normal operation and the timeout operation has been forgotten, the case split test fails with a counterexample showing a corresponding trace. The usage of timeout operation together with normal operations is illustrated below. 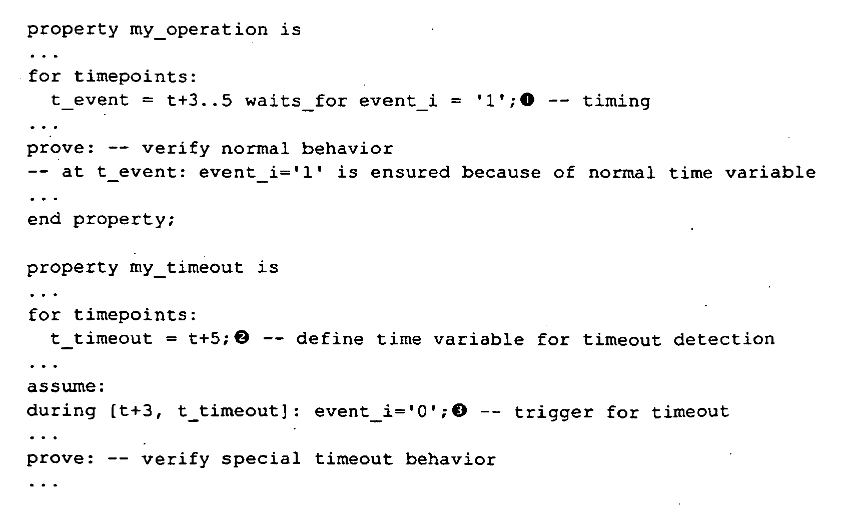 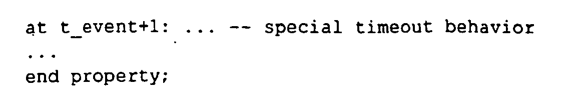
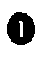 The operation introduces a normal time variable that ensures that the condition it is waiting for occurs in the given interval. In this particular example, event_i is sure to be active at t_event; hence, the case that event_i does not occur between t+3 and t+5 needs to be treated in a timeout property.
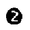 The timeout operation introduces the time that a timeout is detected as t_timeout. Note that this corresponds to the maximum value of t_event in the normal operation (see 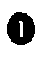 ).
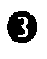 The trigger of the timeout operation consists of the absence of event_i in the whole range of the time variable t_event from the normal property (see 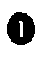 ). Therefore, the absence of event_i is assumed from t+3 to t_timeout.

### Executing the Case Split Test

The case split test answers the simple question whether, given some operation, there exists a succeeding operation in all possible scenarios. This general idea of the case split test is illustrated in Figure 6-1. There is an arbitrary input trace and the predecessor property, the add, holds in this trace. The red knob on the right hand side of the add symbolizes the concrete value of the visible registers after the add in this particular trace. The case split test then examines whether there exists a property among the possible successors of add in the property graph whose trigger matches both the inputs from the trace and the concrete value of the visible register after the add. This examination is carried out for all possible traces where the add holds.

In the concrete example in Figure 6-1, there are three possible successors of the add property, namely mul, load, and store. For these three successor properties, only the trigger part of the property including its timing is important, i.e., only the inputs and the visible register at the beginning (depicted by the blue indentation on the left-hand side of each property) are relevant. The outputs and the visible registers at the end of these properties are ignored for the case split test.

### Figure 6-1. Intuition of the Case Split Test

In the concrete example in the illustration, the mul property matches the input values of the trace, but not the visible register since the red knob does not fit into the blue indentation of the mul. Conversely, the inputs of the store do not match the trace while the visible registers actually do match. Finally, neither inputs nor visible registers match for the load. In other words, there is no successor of the add for this particular trace picked by the case split test and hence, a gap in the verification has been identified.

In phase four, the case split tests of the completeness analysis are carried out. This includes the normal case split tests that examine whether some property has a successor property in all possible scenarios as well as the reset case split test that examines whether the reset property covers all scenarios after a reset sequence. Note that the reset case split test trivially holds in case the trigger of the reset property contains only the reset sequence and no dynamic time variables are introduced in the reset property.
mv> check_completeness -reset case_split
mv> check_completeness -case_split my_prop

### Debugging a Failing Case Split Test

A counterexample for the case split tests consists of a specific trace such that the predecessor property holds in this trace; in addition, none of the triggers (including timing) of the possible succeeding properties apply. In other words, it shows a scenario that is encountered after the predecessor property for which no successor property currently exists in the verification.

In summary, if there exists any scenario for which there is no succeeding property, this scenario is identified with the case split test and represented as a counterexample. Such a counterexample shows a particular trace with some property A at the beginning of this trace, but none of the triggers of the succeeding properties applies in this trace. In terms of the example from Figure 6-1, the case split debugger displays the add property as predecessor and the triggers of all the succeeding properties are represented by the assume parts of the corresponding properties. Since none of the succeeding properties applies in the scenario of the counterexample, all assume parts must be violated and are shown in red. There are six typical gaps that are highlighted by counterexamples of the case split test.
1. An operation has been forgotten to capture and verify. Adding the property to the verification by applying the first three phases for it closes this gap.
2. An property has been verified, but is just missing in the property graph. Adding the property to the property graph closes this gap.
3. The trigger of some operation property is too restrictive. In other words, in a scenario where a specific operation property should apply according to the specification, it does not apply because the trigger in the property is more restrictive than it should be according to the specification. Removing the too restrictive part of the trigger closes this gap. Note, however, that the property needs to be re-checked in order to make sure it still holds with the weaker trigger.
4. Some implicit protocol constraint has been left in the assumption of an operation property. However, the assumption should only contain the important state and the trigger. Turning the implicit constraint in the assumption into a proper constraint and using it as a dependency for property checking as discussed in the Section called *Protocol Constraints* closes the gap.
5. A normal time variable has been used in order to approximate unbounded waiting periods. Applying the techniques described in the Section called *Complete Time Variables* in oder to transform the time variable into a complete one closes this gap.
6. The verification is carried out under some restriction that has not been captured yet. In practical terms, this means that the counterexample of the case split test shows a scenario that is not to be verified at all, like a debug command in case only the non-debug functionality is supposed to be verified. In this case, a constraint is developed and used as dependency in the completeness description as outlined in the Section called *Dependencies in the Completeness Description.*

### SDRAM Controller Tutorial

Note: This section is supposed to contain the application of phase 4 to the sdram controller, it is structured into several sections which, in turn, are referenced at the point in the documentation where the corresponding concepts are introduced, very much work in progress, still.

### DMA Controller Tutorial

Note: This section is supposed to contain the application of phase 4 to the dma controller, it is structured into several sections which, in turn, are referenced at the point in the documentation where the corresponding concepts are introduced very much work in progress, still.

### VCORE Processor Tutorial

Note: This section is supposed to contain the application of phase 4 to the vcore processor it is structured into several sections which, in turn, are referenced at the point in the documentation where the corresponding concepts are introduced very much work in progress, still.

### Chapter 7. Final Review

After a complete verification according to the GapFreeVerification process, it is ensured that all the design functionality is correctly captured in operation properties. In other words, there exists no design behavior that is not uniquely described in the set of operation properties. Hence, the only way that a bug can have escaped the verification so far is if some operation property does not capture the specification, but rather the buggy behavior in the design. Therefore, the final verification code in ITL needs some review. This chapter describes which parts of the ITL code need a review and how such a review is to be carried out. It also lists the parts of the ITL code that do not require a review because they are fail-safe.

### Verification Code to be Reviewed

- Constraints
- Completeness inputs
- Determination requirements (outputs)
- allow_uninitialized (if present)
- determination_domains_start (if present)
- Properties (protocol and computation)
- Macros (protocol and computation)

### Fail-Safe Code

The following components of a verification according to the GapFreeVerification process do not require a review.
- Determination requirements (visible registers)
- Determination domains (end_offset)
- Important state mappings
- Visible register mappings
- Assertions

### II. Extensions to the GapFreeVerification Process

### Chapter 8. Introduction

Currently, there is no documentation on the extensions of the GapFreeVerification process.

### III. Appendixes

### Appendix A. SDRAM Controller

Key features of example exploited in different phases
- has a visible register (at least implicit: last row)
- central controller and protocol driven
- split of transactions into several operations to avoid blow-up in number of operations and verifying the same part of the design several times. may also introduce reachability problems due to split into operations (this is what typically happens and one variable to take into account when deciding whether you go for single or split operations)
- not a good candidate for error handling because of bursts (treating error in 1.,2.,3., and 4. data separately in ITL will drive people crazy and only having error handling for single read seems too artificial to me)
- needs some reachability problems, suggestions:
   - rmw operation with extra control bit, no extra fsm states. becomes part of important state since rmw is verified as single operation
   - and we can do the usual phase 3 reachability (ready=0 part of important state), already implemented
- further possibility for reachability: counter for burst instead of separate states; counter not initialized at beginning of burst; counter=0 becomes part of important state. similar to the ready thing, so 1 do not regard it as essential. we should only do it if we want to stress reachability more. original location: ae/demos/complex_sdram

### Specification

### TBD

**Figure A-1****. Interface of the SDRAM Controller**
**Figure A-2****. Timing of a Single Read Access**

### RTL

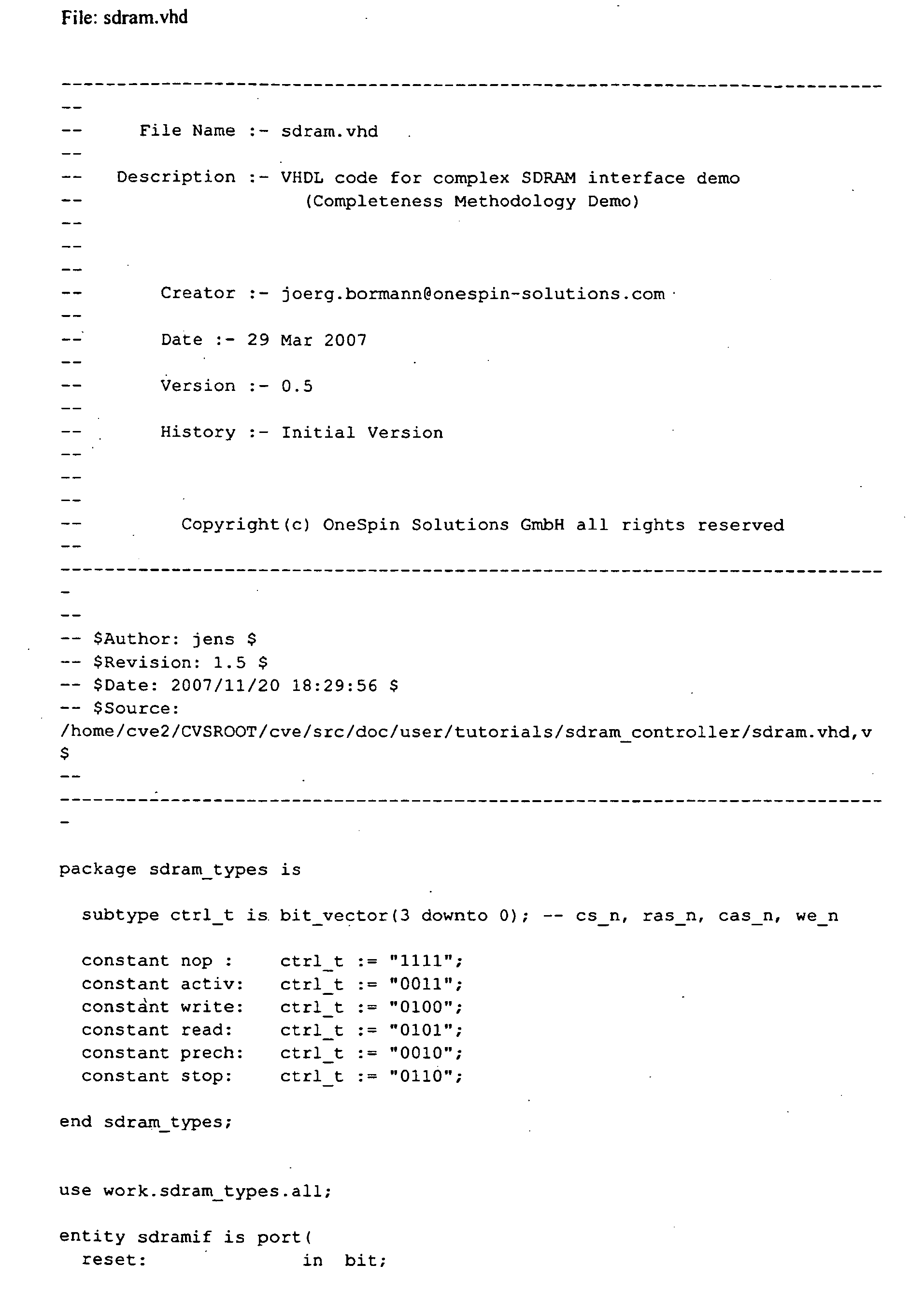

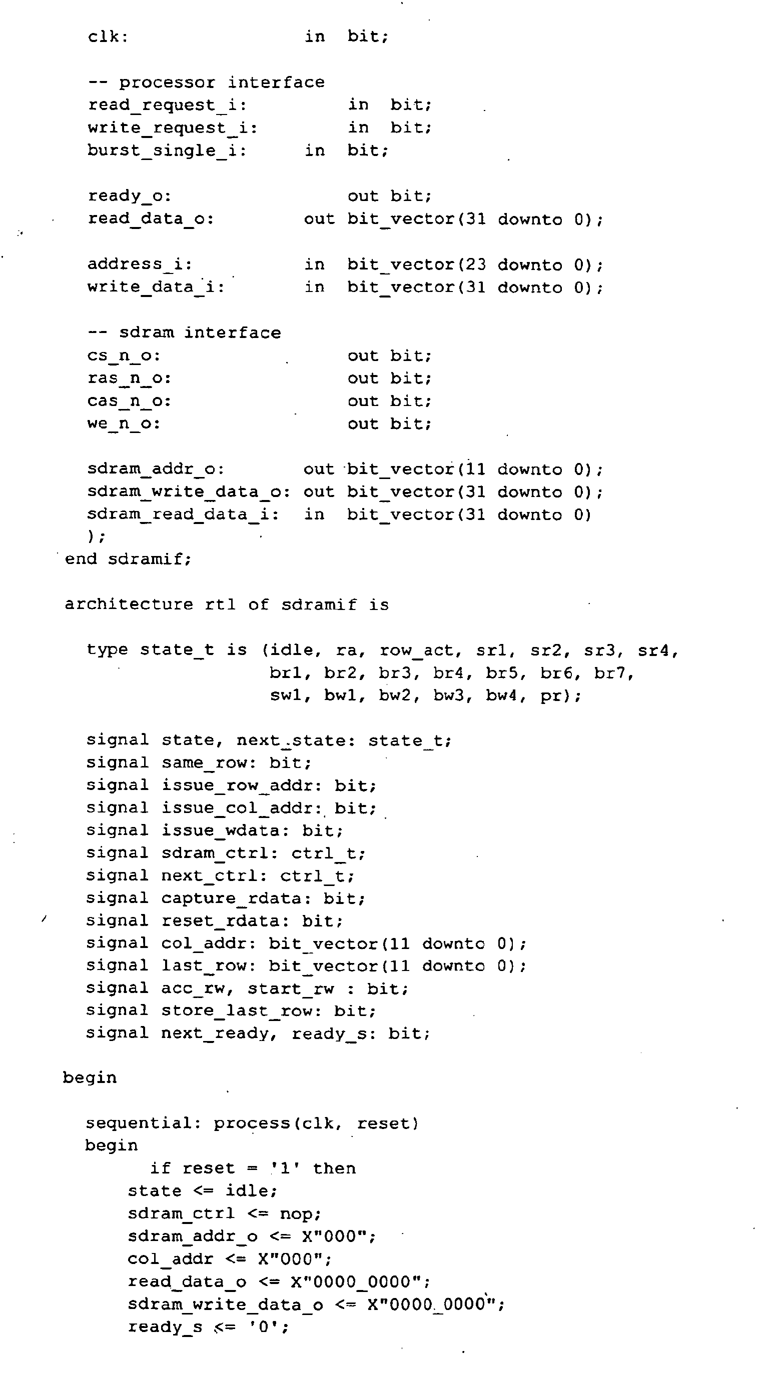

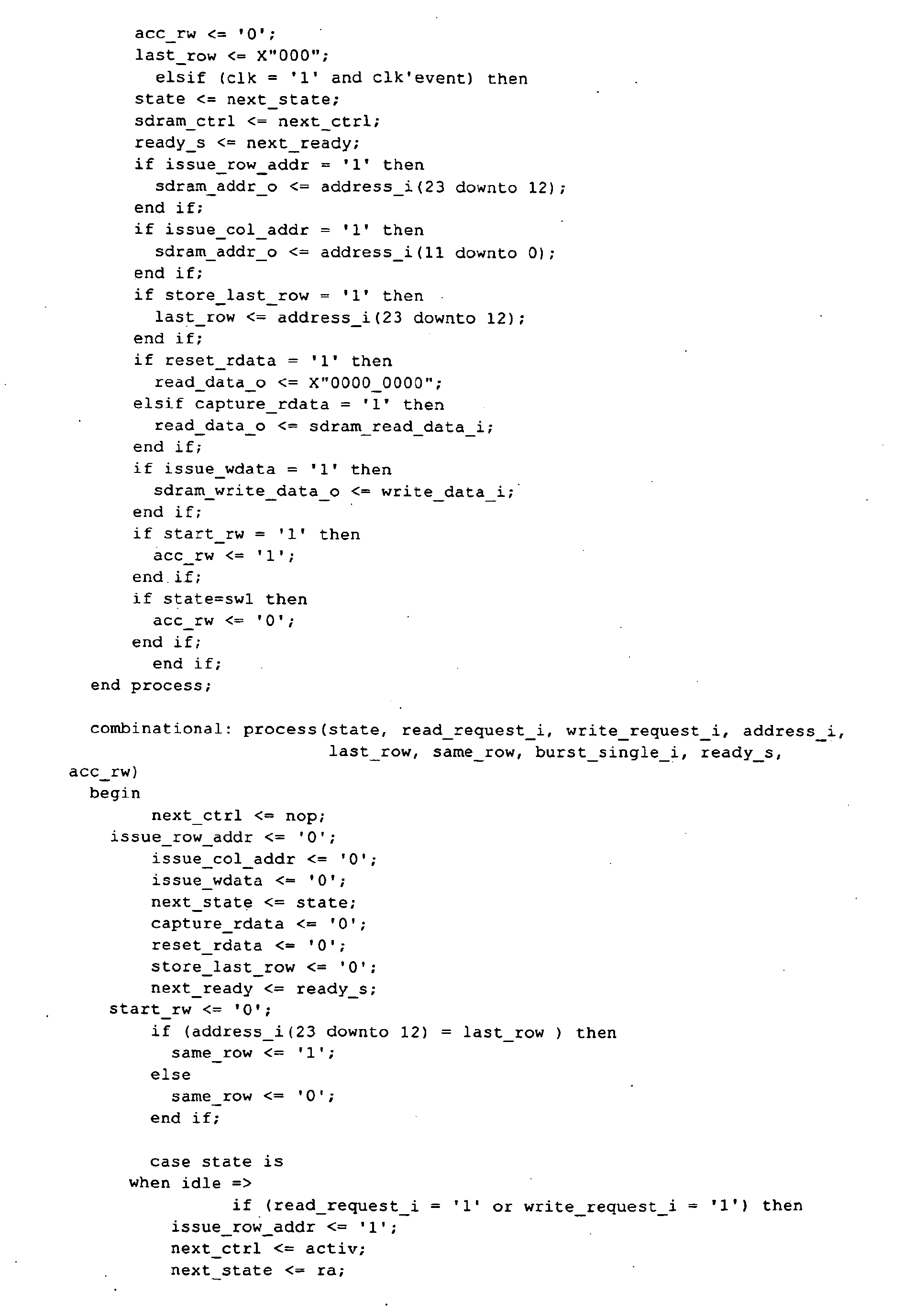

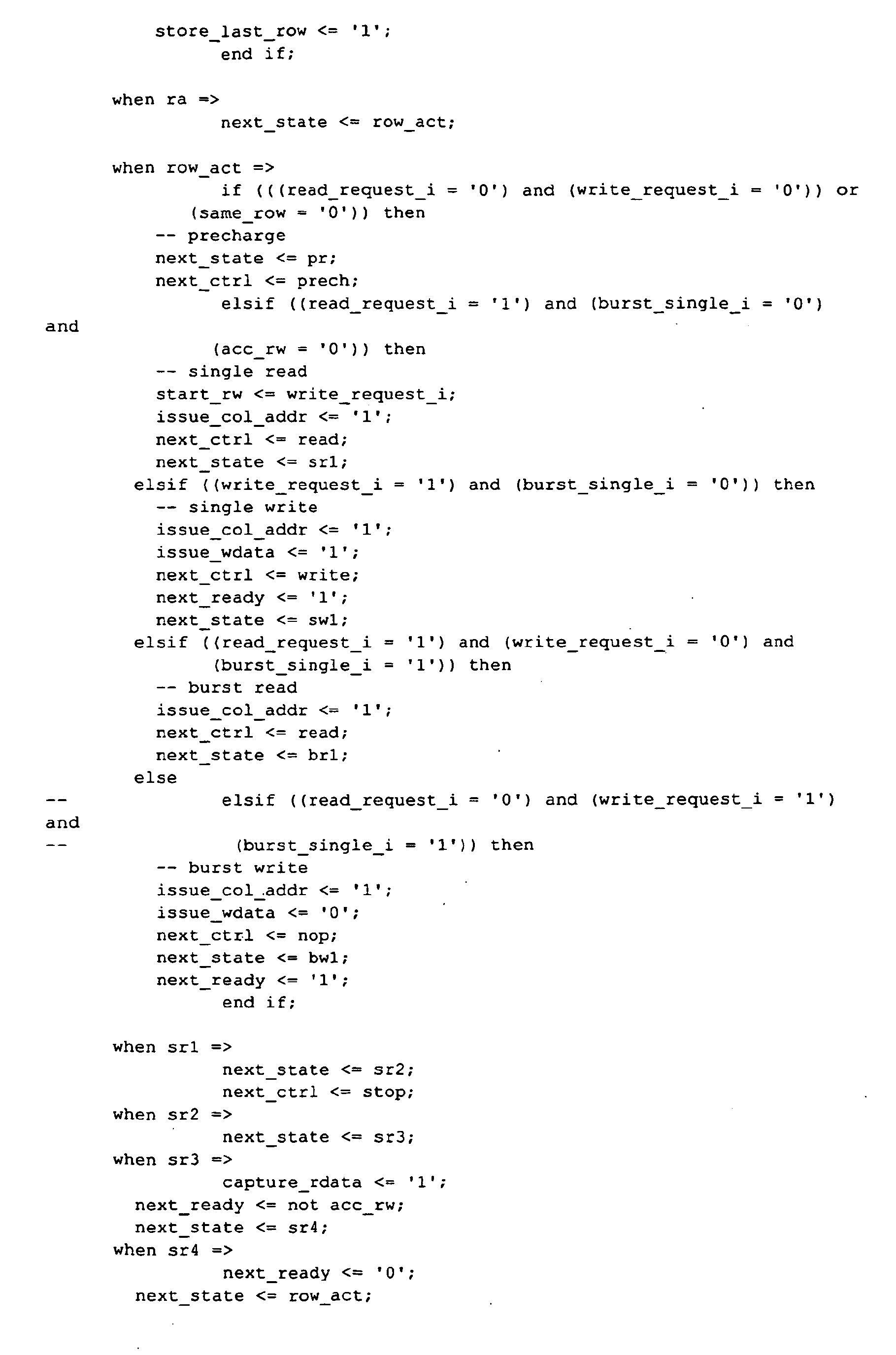

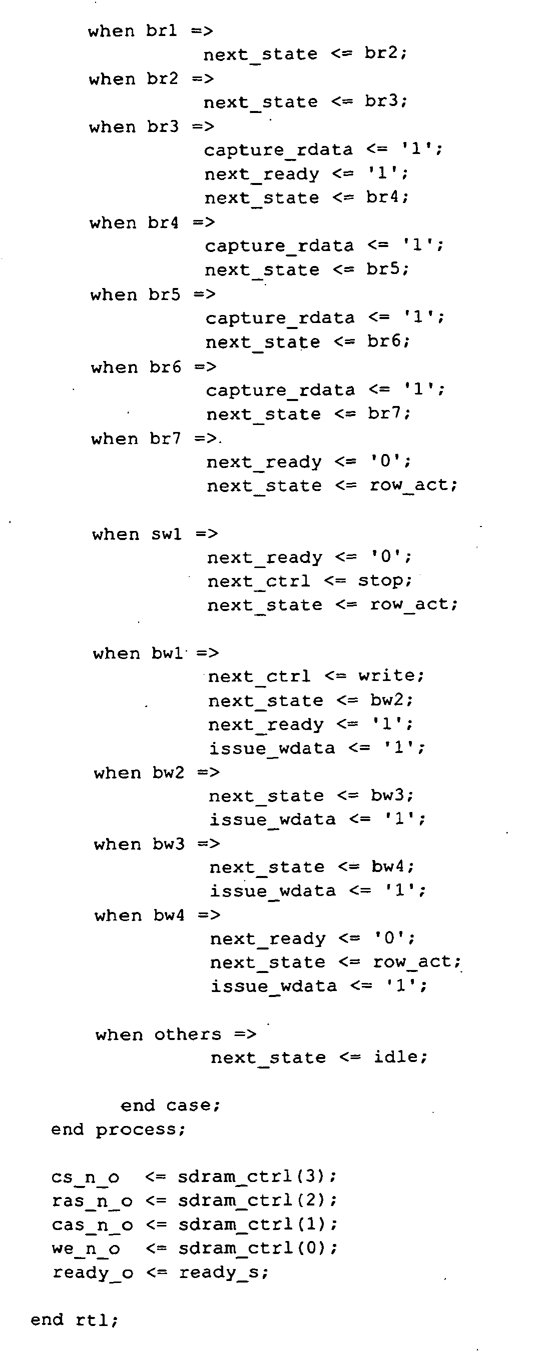

### Appendix B. DMA Controller

Key features of example exploited in different phases
- has set of visible registers (control and command/data registers)
- central controller and protocol driven
- variable wait periods (JS: unclear, how to use wait_for in connection with partial properties)
- can (and should) be extended to have a timeout; maybe timeout can even be configured?
- should be extended to update the configuration registers with a silly pipeline stage and forwarding first stage just decode config register address, second stage actually updates the register original location: ae/demos/dma

### Specification

The DMA (Direct Memory Access) unit is made to accelerate memory copy tasks of a CPU. To initiate a memory copy, the CPU writes the parameters of the copy task to configuration registers of the DMA unit. After setting a dedicated bit of the command register (a dedicated configuration register), the DMA starts the data transfer from the source to destination memory area. It is assumed that the DMA has not the highest priority to access the memory. Therefor, the DMA requests the bus for a data transfer. If the DMA is granted one word is copied from the memory to the DMA or from the DMA to the memory and the DMA requests the bus for the transfer of the next word. If all words are copied a bit in the command register is reset and the CPU can issue a new DMA task.
**Figure B-1****. Interface of the DMA Controller**
**Figure B-2****. Memory Transfer of the DMA Controller**

To write a configuration register, write_access_i is asserted while addr_i contains the address of the register and data_i contains the data that should be written to the register.

To read a configuration register, read_access_i is asserted while addr_i contains the address of the register. In the following cycle data_o contains the data of the register and rdy_o is asserted.

If bit 0 of the command register contains a 1 the DMA requests the bus to the memory by asserting bus_request_o. The bus is granted to the DMA by asserting grant_i. The DMA runs then a read and a write operation to the memory. Since the access time of the memory is not fixed the DMA starts a read or write request and waits until the memory acknowledges the request by asserting rdy_i.

**Note:** It is not dear for the CPU when the DMA has finished the copy and the grant can be issued to another device. The only way to find this out is to use read_request_o or write_request_o i.e. to sniff the memory bus.

### command

### Name

command - the command to be executed

### Synopsis

**command** (0x8000000)
reset value: 0x00000000

### Description

only bits 1 and 0 used; encoding of "copy" and "parity" operations

### source_address

### Name

source_address — the source address of the memory area to be transferred

### Synopsis

**source_address** (0x8000004)
reset value: implementation dependent

### Description

all bits used

### target_address

### Name

target_address — the target address of the memory area to be transferred

### Synopsis

**target_address** (0x8000008)
reset value: implementation dependent

### Description

all bits used

### transfer_length

### Name

transfer_length — the amount of words to be transferred

### Synopsis

**transfer_length** (0x800000C)
reset value: implementation dependent

### Description

all bits used

### RTL

```
 File: dma.vhd
 library ieee;
 use ieee.std_logic_1164.all;
 use work.dma_pack.all;
 entity dma is
  generic(
             addr_msb_g : address_range := 31;
             data_msb_g : address_range := 31;
             command_addr_g: std_logic_vector(address_range) :=
 x"80000000";
             src_addr_addr_g: std_logic_vector(address_range) :=
 x"80000004";
             tgt addr addr g: std_logic vector(address range) :=
 x"80000008";
             transfer_len_addr_g: std_logic_vector(address_range) :=
 x"8000000C";
       parity_addr_g: std_logic_vector(address_range) := x"80000010";
             chk_parity_g: integer := 1);
  port(
             reset_n: in std_logic;
             clk: in std_logic;
             bus_request_o: out std_logic;
             grant_i: in std_logic;
             read_access_i: in std_logic;
             read_access_o: out std_logic;
             write_access_i: in std_logic:
             write_access_o: out std_logic;
             lock_o: out std_logic;
             rdy_i: in std_logic;
             rdy_o: out std_logic;
             addr_i: in std_logic_vector(addr_msb_g downto 0);
             addr_o: out std_logic_vector(addr_msb_g downto 0);
             data_i: in std_logic_vector(data_msb_g downto 0);
             data_o: out std_logic_vector(data_msb_g downto 0));
 end dma;
 architecture structure of dma is
  signal command s: std_logic_vector(1 downto 0);
  signal last_access_s: std_logic;
  signal valid_reg_addr_s: std_logic;
  signal update_addr_s: std_logic;
  signal update_data_s: std_logic;
  signal address_select_s: std_logic;
  signal data_select_s: std_logic;
  signal reset_command_s: std_logic;
  signal read_reg_s: std_logic;
  signal write_reg_s: std_logic;
  component ctrl
     generic (
                chk_parity_g: integer);
     port(
                reset_n: in std_logic;
                clk: in std_logic;
                grant_i: in std_logic;
                read_access_i: in std_logic;
                write_access_i: in std_logic;
                rdy_i: in std_logic;
               bus_request_o: out std_logic;
                read_access_o: out std_logic;
               write_access_o: out std_logic;
                lock_o: out std_logic;
                rdy_o: out std_logic;
                command_s: in std_logic_vector(1 downto 0);
                last_access_s: in std_logic;
          valid_reg_addr_s: in std_logic;
               update_addr_s: out std_logic;
               update_data_s: out std_logic;
                address_select_s: out std_logic;
               data_select_s: out std_logic;
                reset_command_s: out std_logic;
                read_reg_s: out std_logic;
               write_reg_s: out std_logic
     );
  end component;
  component data_path
     generic(
               command_addr_g: std_logic_vector(address_range);
                src_addr_addr_g: std_logic_vector(address_range);
                tgt_addr_addr_g: std_logic_vector(address_range);
               transfer_len_addr_g: std_logic_vector(address_range);
          parity_addr_g: std_logic_vector(address_range);
               addr_msb_g: address_range;
               data_msb_g: data_range;
                chk_parity_g: integer);
     port(
                clk: in std_logic;
                reset_n: in std_logic;
               data_i: in std_logic_vector(data_msb_g downto 0);
               addr_i: in std_logic_vector(addr_msb_g downto 0);
               data_o: out std_logic_vector(data_msb_g downto 0);
               addr_o: out std_logic_vector(addr_msb_g downto 0);
               command_s: out std_logic_vector(1 downto 0);
               last_access_s: out std_logic;
          valid_reg_addr_s: out std_logic;
               update_addr_s: in std_logic;
               update_data_s: in std_logic;
               address_select_s: in std_logic;
               data_select_s: in std_logic;
               reset_command_s: in std_logic;
               read_reg_s: in std_logic;
               write_reg_s: in std_logic
     );
  end component;
 begin
  ctrl_i : ctrl
  generic map (
            chk_parity_g => chk_parity_g)
  port map (
             reset_n => reset_n,
             clk => clk,
             grant_i => grant_i,
             read_access_i => read_access_i,
            write access_i => write_access_i,
             rdy_i => rdy_i,
            bus_request_o => bus_request_o,
             read_access_o => read_access_o,
             write_access_o => write_access_o,
             lock_o => lock_o,
             rdy o => rdy_o,
             command_s => command_s,
             last_access_s => last_access_s,
       valid_reg_addr_s => valid_reg_addr_s,
             update_addr_s => update_addr_s,
             update_data_s => update_data_s,
             address_select_s => address_select_s,
             data_select_s => data_select_s,
             reset_command_s => reset_command_s,
             read_reg_s => read_reg_s,
             write_reg_s => write_reg_s
  );
 data_path_i : data_path
 generic map(
          addr_msb_g => addr_msb_g,
          data_msb_g => data_msb_g,
          command_addr_g => command_addr_g,
          src_addr_addr_g => src_addr_addr_g,
          tgt_addr_addr_g => tgt_addr_addr_g,
          transfer_len_addr g => transfer_len_addr_g,
     parity_addr_g => parity_addr_g,
          chk_parity_g => chk_parity_g)
 port map(
          clk => clk,
          reset n => reset_n,
          data_i => data_i,
          addr_i => addr_i,
          data_o => data_o,
          addr_o => addr_o,
          command_s => command_s,
          last_access_s => last_access_s,
     valid_reg_addr_s => valid_reg_addr_s,
          update_addr_s => update_addr_s,
          update_data_s => update_data_s,
          address_select_s => address_select_s,
          data_select_s => data_select_s,
          reset_command_s => reset_command_s,
          read_reg_s => read_reg_s,
          write_reg_s => write_reg_s
 ) ;
 end structure;
 File: dma_pack.vhd
 library ieee;
 use ieee.std_logic_1164.all;
 package dma_pack is
     constant transfer_mem: integer := 0;
     constant extra_compute: integer := 1;
     subtype address_range is integer range 31 downto 0;
     subtype data_range is integer range 31 downto 0;
     function addr_mask(addr_msb_g: natural) return std_logic_vector;
     function data_mask(data_msb_g: natural) return std_logic_vector;
 end dma_pack;
 package body dma_pack is
  function addr_mask(addr_msb_g: natural) return std_logic_vector is
     variable result : std_logic_vector(address_range);
  begin
     for i in address_range loop
          if i <= addr_msb_g then
                result(i) :='1';
          else
                result(i) := '0';
          end if;
     end loop;
     return result;
  end function;
  function data_mask(data_msb_g: natural) return std_logic_vector is
     variable result : std_logic_vector(data_range);
  begin
     for i in data_range loop
          if i <= data_msb_g then
               result(i) := '1';
          else
               result(i) := '0';
          end if;
     end loop;
     return result;
  end function;
 end;
 File: ctrl.vhd
 library ieee;
 use ieee.std_logic_1164.all;
 use work.dma_pack.all;
 entity ctrl is
 generic (
          chk_parity_g: integer := 0);
 port(
          reset_n: in std_logic;
          clk: in std_logic;
          grant_i: in std_logic;
          read_access_i: in std_logic;
          write_access_i: in std_logic;
          rdy_i: in std_logic;
          bus_request_o: out std_logic;
          read_access_o: out std_logic;
          write_access_o: out std_logic;
          lock_o: out std_logic;
          rdy_o: out std_logic;
    -- from/to data
          command_s: in std_logic_vector(1 downto 0);
          last_access_s: in std_logic;
    valid_reg_addr_s: in std_logic;
          update_addr_s: out std_logic;
          update_data_s: out std_logic;
          address_select_s: out std_logic;
         data_select_s: out std_logic;
          reset_command_s: out std_logic;
          read_reg_s: out std_logic;
         write_reg_s: out std_logic
 ) ;
 end ctrl;
 architecture rtl of ctrl is
  type state_type is (idle, read_wait, write_wait) ;
  signal state, n_state: state_type;
  signal bus_request_s, read_access_s,
                write_access_s, lock_s, rdy_s: std_logic;
 begin
  process(state, read_access_i, write_access_i, command_s,
                  last_access_s, rdy_i, grant_i)
  begin
          lock_s <= '0';
          rdy_s <= '0';
          read_access_s <= '0';
          write_access_s <= '0';
          update_addr_s <= '0';
          update_data_s <= '0';
          n_state <= state;
          address_select_s <= '0'; -- switches between src_addr('0') and
 tgt_addr ('1')
          data_select_s <= '0'; -- '0': data_reg, '1' cfg_reg;
          reset_command_s <= '0';
          bus_request_s <= '0';
     read_reg_s <= '0';
          write_reg_s <= '0';
          case state is
          when idle =>
            -- handle read/write requests. when grant: read, then goto
 read_wait
                     if read_access_i = '1' then
               if valid_reg_addr_s = '1' then
                                  rdy_s <= '1';
                                  read_reg_s <= '1';
                                  data_select_s <= '1';
                                  n_state <= idle;
               end if;
                     elsif write_access_i = '1' then
               if valid_reg_addr_s = '1' then
                                  rdy_s <= '1';
                                  write_reg_s <= '1';
                                  n_state <= idle;
               end if;
                     elsif grant_i = '1' and
                  (command_s(transfer_mem) = '1' or chk_parity_g /= 0) then
                                lock_s <= '1';
                                read_access <= '1';
                               bus_request_s <= not last_access_s;
                                n_state <= read_wait;
                     else
                                bus_request_s <= command_s(transfer_mem);
                     end if;
          when read_wait =>
          -- wait for rdy_i, then write
                     bus_request_s <= not last_access_s;
                     if rdy_i = '1' then
                               update_data_s <= '1';
                                if command_s(transfer_mem) = '0' and chk_parity_g
 /= 0 then
                                          n_state <= idle;
                                          update_addr_s <= not last_access_s;
                                          reset_command_s <= last_access_s;
                                else
                                          n_state <= write_wait;
                                          address_select_s <= '1';
                                          write_access_s <= '1';
                                          data_select_s <= '0';
                                end if;
                     else
                                lock_s <= '1';
                                read_access_s <= '1';
                     end if;
          when write_wait =>
                     if rdy_i = '1' then
                                if last_access_s = '1' then
                                          reset_command_s <= '1';
                                          bus_request_s <= '0';
                                else
                                     update_addr_s <= '1';
                                          bus_request_s <= '1';
                                end if;
                                n_state <= idle;
                     else
                                address_select_s <= '1';
                               write_access_s <= '1';
                               data_select_s <= '0';
                               bus_request_s <= not last_access_s;
                     end if;
          end case;
  end process;
  process(clk, reset_n)
  begin
     if reset_n = '0' then
                state <= idle;
                rdy_o <= '0';
                read_access_o <= '0';
               write_access_o <= '0';
               bus_request_o <= '0';
                lock_o <= '0';
     elsif (clk'event and clk = '1') then
                state <= n state;
                rdy_o <= rdy_s;
                read_access_o <= read_access_s;
               write_access_o <= write_access_s;
               bus_request_o <= bus_request_s;
                lock_o <= lock_s;
     end if;
  end process;
 end rtl;
 File: data_path.vhd
 library ieee;
 use ieee.std_logic_1164.all;
 use ieee.std_logic_unsigned.all;
 use work.dma_pack.all;
 entity data_path is
  generic(
    addr_msb_g: address_range := 15; -- address width
 - 1
    data_msb_g: data_range := 15; -- data width - 1
    command addr_g: std_logic_vector(address_range); -- addr of
 command word
    src_addr_addr_g: std_logic_vector(address_range); -- addr of start
 addr for read
    tgt_addr_addr_g: std_logic_vector(address_range); -- addr of start
 addr for write
    transfer len_addr_g: std_logic_vector(address_range); -- addr of length
    parity_addr_g: std_logic_vector(address_range);
    chk_parity_g: integer);
 port(
    clk: in std_logic;
    reset_n: in std_logic;
    data_i: in std_logic_vector(data_msb_g downto 0);
    addr_i: in std_logic_vector(addr_msb_g downto 0);
    data_o: out std_logic_vector(data_msb_g downto 0);
    addr_o: out std_logic_vector(addr_msb_g downto 0);
    -- from/to ctrl:
    command_s: out std_logic_vector(1 downto 0);
    last_access_s: out std_logic;
    valid_reg_addr_s: out std_logic;
    update_addr_s: in std_logic;
    update_data_s: in std_logic;
    address_select s: in std_logic;
    data_select_s: in std_logic;
    reset_command_s: in std_logic;
    read_reg_s: in std_logic; -- read request
    write reg s: in std_logic -- write request
 );
 end data_path;
 architecture rtl of data_path is
  signal src_addr, tgt_addr, transfer_len: std_logic_vector(data_msb_g
 downto 0);
  signal data, data_s: std_logic_vector(data_msb_g downto 0);
   signal command: std_logic vector(1 downto 0);
   signal parity_result: std_logic_vector(data_msb_g downto 0);
   signal data_select_del: std_logic;
   signal valid_reg_addr: std_logic;
 begin
   -- write command: from data_i
   process(clk, reset_n)
   begin
        if reset_n = '0' then
             command <= "00";
        elsif clk'event and clk = '1' then
             if reset_command_s = '1' then
                   command <= "00";
             elsif write_reg_s = '1' and addr_i = command_addr_g(addr_msb_g
 downto 0) then
                   command <= data_i(1 downto 0);
             end if;
        end if;
   end process;
  command_s <= command;
  process(addr_i)
  begin
     valid_reg_addr <= '0';
     if (addr_i = src_addr_addr_g(addr_msb_g downto 0)) or
          (addr_i = tgt_addr_addr_g(addr_msb_g downto 0)) or
          (addr_i = transfer_len_addr_g(addr msb_g downto 0)) or
          (addr_i = command_addr_g(addr_msb_g downto 0)) or
          (addr_i = parity_addr_g(addr_msb_g downto 0)) then
        valid_reg_addr <= '1';
     end if;
  end process;
  valid_reg_addr_s <= valid_reg_addr;
  -- update src_addr
  process(clk, reset_n)
     variable data_pesrc_addr, offset, num_bit, upper_bound: integer;
     variable offset_long: std_logic_vector(address_range);
  begin
        if reset_n = '0' then
             src_addr <= (others => '0');
        elsif clk'event and clk = '1' then
             if update_addr s ='1' then
             src_addr <= src_addr + 1;
             else
                  if write_reg_s = '1' and (addr_i = src_addr_addr_g(addr_msb_g
 downto 0)) then
                     src_addr <= data_i;
                  end if;
             end if;
        end if;
  end process;
 -- update tgt_addr
 process(clk, reset_n)
    variable data_pesrc_addr, offset, num_bit, upper_bound: integer;
    variable offset_long: std_logic_vector(address_range);
 begin
       if reset_n = '0' then
            tgt_addr <= (others => '0');
       elsif clk'event and clk = '1' then
            if update_addr_s ='1' then
                  tgt_addr <= tgt_addr + 1;
            else
                  if (write_reg_s = '1' and addr_i =
 tgt_addr_addr_g(addr_msb_g downto 0)) then
                    tgt_addr <= data_i;
                  end if;
            end if;
       end if;
 end process;
 -- select addr_o (read or write)
 process(clk, reset_n)
 begin
       if reset_n = '0' then
            addr_o <= (others => '0');
       elsif clk'event and clk = '1' then
            if address_select_s = '0' then
                  addr_o <= src_addr(addr_msb_g downto 0);
            else
                  addr_o <= tgt_addr(addr_msb_g downto 0);
            end if;
       end if;
  end process;
  -- transfer_len
  process(clk, reset_n)
    variable data_pesrc_addr, offset, num_bit, upper_bound: integer;
    variable offset_long: std_logic_vector(address_range);
  begin
       if reset_n = '0' then
             transfer_len <= (others => '0');
       elsif elk'event and clk = '1' then
             if update_addr_s ='1' then
                  transfer_len <= transfer_len - 1;
             else
                  if (write_reg_s = '1' and addr_i =
 transfer_len_addr_g(addr_msb_g downto 0)) then
                     transfer_len <= data_i;
                  end if;
             end if;
       end if;
  end process;
  last_access_s <= '1' when transfer_len(data_msb_g downto 1) = 0 else '0';
  -- transfer
  process(clk, reset_n)
  begin
       if reset_n = '0' then
            data <= (others => '0');
             data_select_del <= '0';
       elsif clk'event and clk = '1' then
            if update_data_s = '1' then
                 data <= data-i;
            end if;
            data_select_del <= data_select_s;
       end if;
 end process;
 data_o <= data_s when data_select_del = '1' else data; --OKAY
 -- read registers: (compute read data: data_s)
 process(clk, reset_n)
 begin
    if reset_n = '0' then
            data_s <= (others => '0');
    elsif clk'event and clk = '1' then
        if read_reg_s = '1' then
             if addr_i = command_addr_g(addr_msb_g downto 0) then
                  data_s(data_msb_g downto 2) <= (others => '0');
                  data_s(1 downto 0) <= command;
             elsif addr_i = src_addr_addr_g(addr_msb_g downto 0) then
                  data_s <= src_addr;
             elsif addr_i = tgt_addr_addr_g(addr_msb_g downto 0) then
                  data s <= tgt_addr;
             elsif addr i = transfer_len_addr_g(addr_msb_g downto 0) then
                  data_s <= transfer_len;
             elsif chk_parity_g /= 0 and
                     addr_i = parity_addr_g(addr_msb_g downto 0) then
                  data s <= parity_result;
             else
                  data_s <= (others => '0');
             end if;
       end if;
    end if;
  end process;
  -- no extra logic
  gen_nothing: if chk_parity_g <= 0 or chk_parity_g > 2 generate
       parity_result <= (others => '0');
  end generate;
  -- extra logic: checksum
  gen_chksum: if chk_parity_g = 1 generate
     process(clk, reset_n)
     begin
          if reset_n = '0' then
                parity_result <= (others => '0');
          elsif clk'event and clk = '1' then
                if update_data_s = '1' and command(1) = '1' then
                     parity_result <= parity_result xor data_i;
                else
                     if write_reg s = '1' and addr_i = parity_addr_g(addr_msb_g
 downto 0) then
                           parity_result <= data_i;
                    end if;
               end if;
          end if;
    end process;
  end generate;
  -- extra logic: maximum
  gen_max: if chk_parity_g = 2 generate
    process(clk, reset_n)
    begin
          if reset n = '0' then
                parity_result <= (others => '0');
          elsif clk'event and clk = '1' then
               if update_data_s = '1' and command(1) = '1' then
                     if parity_result < data_i then
                          parity_result <= data_i;
                    end if;
               else
                    if write_reg_s = '1' and addr_i = parity_addr_g(addr_msb_g
 downto 0) then
                          parity_result <= data_i;
                    end if;
               end if;
          end if;
     end process;
  end generate;
 end rtl;
```

### Appendix C. VCORE Processor

Key features of example exploited in different phases
- pipeline with controller after decode stage
- actual computations taking place
- visible register with complex mapping
- in the current version, the examination window is extended to t-1 to prove load/store properties (without it, FSM is in unreachable state initially and property fails)
original location (strongly modified from initial sources):
cve/test/shell/mv_application/tiny_testcases/vcore

### Instruction Architecture Manual

The VCORE contains a register file with 8 general purpose registers that are 16 bit wide; they are called R [0] ...R [7]. It has a separate instruction- and data memory, each holding 64KB of data.

Accordingly, the program counter is 8 bits wide. On a reset, the register file and the PC are initialized with 0.

TBD: Protocol description

### not

### Name

not — negates the source operand and stores the result in a destination register

### Synopsis

not Rd Ra

### Description

| | | | | | | | | | |
|---|---|---|---|---|---|---|---|---|---|
| 15 | 11 | 10 | 8 | 7 | 5 | 4 | 2 | 1 | 0 |
| 00_{H} | | a | | - | | d | | - | |

opcode=00_{H}
result=~R[a]
R[d]=result

### add

### Name

add - adds two source operands and stores the result in a destination register

### Synopsis

add Rd Ra Rb

### Description

| | | | | | | | | | |
|---|---|---|---|---|---|---|---|---|---|
| 15 | 11 | 10 | 8 | 7 | 5 | 4 | 2 | 1 | 0 |
| 01_{H} | | a | | b | | d | | - | |

opcode=01_{H}
resulrR[a]+R[b]
R[d]=result[15:0]

### sub

### Name

sub — subtracts two source operands from each other and stores the result in a destination register

### Synopsis

sub Rd Ra Rb

### Description

| | | | | | | | | | |
|---|---|---|---|---|---|---|---|---|---|
| 15 | 11 | 10 | 8 | 7 | 5 | 4 | 2 | 1 | 0 |
| 02_{H} | | a | | b | | d | | - | |

opcode=02_{H}
result=R[a]-R[b]
R[d]=result[15:0]

### Id

### Name

Id — loads a data word from memory; the address of the memory access is given by the sum of the source operand and an immediate constant

### Synopsis

Id Rd Ra imm

### Description

| | | | | | | | |
|---|---|---|---|---|---|---|---|
| 15 | 11 | 10 | 8 | 7 | 5 | 4 | 0 |
| 04_{H} | | d | | a | | imm | |

opcode=04_{H}
ea=(R[a]+sign_extend(imm))[15:0]
R[d]=M[ea]

### st

### Name

st — stores a source operand to the memory; the address of the memory access is given by the sum of the other source operand and an immediate constant

### Synopsis

st Ra Rb imm

### Description

| | | | | | | | |
|---|---|---|---|---|---|---|---|
| 15 | 11 | 10 | 8 | 7 | 5 | 4 | 0 |
| 06_{H} | | d | | a | | imm | |

opcode=06_{H}
ea=(R[b]+sign_extend(imm))[15:0]
M[ea]=R[a]

### beqz

### Name

beqz — jumps to relative target address given by immediate constant in case the source register is 0

### Synopsis

beqz Ra imm

### Description

| | | | | | |
|---|---|---|---|---|---|
| 15 | 11 | 10 | 8 | 7 | 0 |
| 07_{H} | | a | | imm | |

opcode=07_{H}
if R[a]==0 then PC=(PC+2*sign_extend(imm))[7:0]

### RTL

```
 File: vcore.v
 module vcore
   (
    clk,
    reset_n,
   imem_addr_o,
   imem_data_i,
   dmem_enable_o,
   dmem_write_o,
   dmem_addr_o,
   dmem_data_o,
   dmem_data_i,
   dmem_valid_i
   ) ;
 include "opcodes.v"
   input clk;
   input reset_n;
   output [15:0] imem_addr_o;
   input [15:0] imem_data_i;
   output : dmem_enable_o;
   output dmem_write_o;
   output [15:0] dmem_addr_o;
   output [15:0] dmem_data_o;
   input [15:0] dinem_data_i;
   input dmem_valid_i;
   reg [15:0] register[7:0];
   reg dec_valid;
   reg ex_write_reg;
   reg ex_read_from_mem;
   reg [2:0] ex_dest_reg;
   reg [15:0] ex_result;
   reg [15:1] ex_PC;
   reg wb_write_reg;
   reg [2:0] wb_dest_reg;
   reg [15:0] wb_result;
   reg [15:0] dec_PC;
   wire [15:0] next_PC;
   reg [15:0] instruction_word_reg;
   wire [4:0] opcode;
   wire [2:0] regA, regB, regD;
   wire [15:0] imm;
    reg ex_sub, ex_not, ex_branch;
    reg [15:0] ex_op_a, ex_op_b;
    reg [15:0] fwd_op_a, fwd_op_b;
    reg [1:0] current_mem_state, next_mem_state;
    reg [15:0] dmem_data_o;
    reg dmem_enable_o,dmem_write_o;
   wire [15:0] real_ex_result;
    wire mem_stall;
   wire ex_mispredict;
   wire [15:0] dmem_addr_o;
   parameter MEM_IDLE = 2'b00;
   parameter MEM_READ = 2'b01;
   parameter MEM_WRITE = 2'b10;
   assign opcode = instruction_word_reg[15:11];
   assign regA = instruction_word_reg[10:8];
   assign regB = instruction word_reg[7:5];
   assign regD = instruction_word_reg[4:2];
   assign imm = opcode==BEQZ?
                        ({8(instruction_word_reg[7]}},instruction_word_reg[7:0]}:
 {[11{instruction_word_reg[4]}},instruction_word_reg[4:0]};
   assign imem_addr_o = dec_valid? next_PC: dec_PC;
   assign real ex_result = ex_read_from_mem ? dmem_data_i : ex_result;
   assign mem_stall = current_mem_state!=MEM_IDLE && !dmem_valid_i;
   assign dmem_addr_o = ex_result;
    // instruction fetch
    always @ (posedge clk)
            if (!mem_stall)
              instruction_word_reg <= imem_data_i;
    assign next_PC = ex_mispredict ?
                        {ex_PC,1'b0} + ex_op_b : dec_PC + 2;
    // PC behavior
    assign ex_mispredict = ex_branch && ex_result[0];
    always @ (posedge clk or negedge reset_n)
            if (!reset_n)
              begin
                        dec_PC <= 0;
                        dec_valid <= 0;
              end
            else
              begin
                        dec_valid <= 1;
                        if (!mem_stall && dec_valid)
                                dec_PC <= next_PC;
              end
 // register update
    always @ (posedge clk or negedge reset_n)
            if (!reset_n)
              begin
                        register[0] <= 0;
                        register[1] <= 0;
                        register[2] <= 0;
                        register[3] <= 0;
                        register[4] <= 0;
                        register[5] <= 0;
                        register[6] <= 0;
                        register[7] <= 0;
               end
            else if (wb_write_reg)
               register[wb_dest_reg] <= wb_result;
    // ALU
    always @ (/*AUTOSENSE*/ex-branch or ex_not or ex_op_a or ex_op_b
                                 or ex_sub) begin
             if (ex_branch)
                     ex_result = ex_op_a_ == 0;
        else if (ex_not)
                     ex_result = ~ex_op_a;
             else if (ex_sub)
                     ex_result = ex_op_a - ex_op_b;
             else
                     ex_result = ex_op_a + ex_op_b;
    end
    // memory controller
    always @ (/*AUTOSENSE*/current_mem_state or dec_valid
                                  or dmem_valid_i or ex_mispredict or opcode)
            begin
                      next_mem_state = MEM_IDLE;
                      dmem_enable_o = 1'b0;
                      dmem_write_o = 1'b0;
                      case (current_mem_state)
                        MEM_IDLE:
                                begin
                                    if (dec_valid && ! ex_mispredict && opcode==LD)
                                            next_mem_state = MEM_READ;
                                    else if (dec_valid && ! ex_mispredict &&
 opcode==ST)
                                            next_mem_state = MEM_WRITE;
                                 end
                        MEM_READ:
                                begin
                                    dmem_enable_o = 1'b1;
                                    dmem_write_o = 1'b0;
                                     if (dmem_valid_i && dec_valid && ! ex_mispredict
 && opcode==ST)
                                            next_mem_state = MEM_WRITE;
                                     else if (!dmem_valid_i | | dec_valid && !
 ex_mispredict && opcode==LD)
                                             next_mem_state = MEM_READ;
                                 end
                         MEM_WRITE:
                                 begin
                                     dmem_enable_o = 1'b1;
                                     dmem_write_o = 1'b1;
                                     if (dmem_valid_i && dec_valid && ! ex_mispredict
 && opcode==LD)
                                             next_mem_state = MEM_READ;
                                     else if (!dmem_valid_i | | dec_valid && !
 ex_mispredict && opcode==ST)
                                             next_mem_state = MEM_WRITE;
                                 end
                    endcase
           end // always @ (...
   always @ (posedge clk or negedge reset_n)
           if (!reset_n)
              current_mem_state <= MEM_IDLE;
           else
              current_mem_state <= next_mem_state;
   // forwarding
   always @ ( /*AUTOSENSE*/ex_write_reg or ex_dest_reg or real_ex_result or
                       wb_write_reg or wb_dest_reg or regA or regB or wb_result
 or
                  register[0] or register[1] or register[2] or register[3] or
                  register[4] or register[5] or register[6] or register[7])
      begin
              fwd_op_a <= (ex_write_reg && ex_dest_reg == regA) ?
 real_ex_result :
                              (wb_write_reg && wb_dest_reg == regA) ? wb_result:
 register[regA];
              fwd_op_b <= (ex_write_reg && ex_dest_reg == regB) ?
 real_ex_result :
                              (wb_write_reg && wb_dest_reg == regB) ? wb_result:
 register[regB];
      end // always @ (...
   // pipeline
   always @ (posedge clk or negedge reset_n)
           if (!reset_n)
             begin
                       ex_write_reg <= 0;
                       wb_write_reg <= 0;
                       ex_branch <= 0;
              end
           else if (!mem_stall)
              begin
                       ex_write_reg <= 0;
                       ex_read_from_mem <= 0;
                       ex_op_a <= fwd_op_a;
                       ex_op_b <= fwd_op_b;
                       ex_sub <= 0;
                       ex_not <= 0;
                       ex branch <= 0;
                       ex_PC <= dec_PC[15:1];
                       // decode
                       if (dee_valid && ! ex_mispredict)
                               case (opcode)
                                  NOT:
                                          begin
                                              ex_write_reg <= 1;
                                              ex_dest_reg <= regD;
                                              ex_not <= 1;
                                          end
                                  ADD:
                                          begin
                                              ex_write_reg <= 1;
                                              ex_dest_reg <= regD;
                                          end
                                  SUB:
                                          begin
                                              ex_write_reg <= 1;
                                              ex_dest_reg <= regD;
                                              ex_sub <= 1;
                                          end
                                  LD:
                                          begin
                                              ex_write_reg <= 1;
                                              ex_read_from_mem <= 1;
                                              ex_dest_reg <= regA;
                                              ex_op_a <= imm;
                                          end
                                  ST:
                                          begin
                                              ex_write_reg <= 0;
                                              ex_op_a <= imm;
                                              ex_dest_reg <= regA;
                                              dmem_data_o <= fwd_op_a;
                                          end
                                  BEQZ:
                                          begin
                                              ex_branch <= 1;
                                              ex_op_b <= imm << 1;
                                          end
                               endcase // case(opcode)
                        // execute
                       wb_write_reg <= ex_write_reg;
                       wb_result <= real_ex_result;
                       wb_dest_reg <= ex_dest_reg;
              end
            else // of "if (!mem_stall)"
              wb_write_reg <= 0;
 endmodule // vcore
```

## Claims

1. A method for verifying at least one aspects of a digital circuit, the method comprising:
- providing a set of operations to be performed by the digital circuit, wherein each one of the set of operations relates to the functionality of the at least one aspect of the digital circuit, and wherein each one of the set of operations comprises at least one functional element;
- identifying a first subset of functional elements out of the functional elements of the set of operations;
- describing in a description the functional elements identified in the first subset in terms of properties, each one of the properties having an assumption component and a proof component;
- formally verifying each one of the properties;
- arranging the plurality of the functional elements identified in the first subset to be proven for the digital circuit in an arrangement with temporal relations satisfying at least said description;
- analysing completeness of the arrangement of the functional elements identified in the first subset to verify that the at least one aspects of the digital circuit are completely verified.

2. The method of claim 1, wherein at least one of the functional elements identified in the first subset describes a control of the digital circuit.

3. The method of claim 1 or 2, wherein at least one of the functional elements identified in the first subset describes a central control of the digital circuit.

4. The method of any of the preceding claims, wherein at least one of the functional elements identified in the first subset describes at least one of the group consisting of inputs, outputs, internal signals, registers and visible registers.

5. The method of any of the preceding claims, wherein at least one of the functional elements identified in the first subset describes a data path.

6. The method of any of the preceding claims, wherein the analysis of the completeness of the arrangement comprises determining whether the arrangement forms a model of the digital circuit.

7. The method of any of the preceding claims, wherein the set of operations further describes a temporal relation of at least two of the set of operations and wherein at least one of the properties describes the temporal relation of the at least two of the set of operations.

8. The method of any of the preceding claims, wherein at least one of the set of operations and at least one of the properties are shown to comply.

9. The method of any of the preceding claims, wherein at least one of the functional elements identified in the first subset describes a temporal relation of at least two functional elements of the identified first subset.

10. The method of any of the preceding claims, wherein the analysis of the completeness of the arrangement comprises determining whether the arrangement or the properties determines a unique value of each output for every input stimulus that initiates a sequence of properties.

11. The method of any of the preceding claims, further comprising determining completeness of the properties by determining if the temporal arrangement of the properties corresponds to the temporal relation of a plurality of the set of operations.

12. The method of any of the preceding claims, further comprising subsequent to analysing completeness of the arrangement:
- identifying a second subset of the functional elements out of the functional elements of the set of operations;
- modifying the properties based on the second subset of the functional elements;
- formally verifying each one of the modified properties;
- modifying the arrangement based on the second subset of the functional elements;
- analysing completeness of the modified arrangement to verify that further aspects of the digital circuit are completely verified.

13. The method of claim 12, wherein at least one of the functional elements identified in the second subset describes a control of the digital circuit.

14. The method of claim 12 or 13, wherein at least one of the functional elements identified in the second subset describes a central control of the digital circuit.

15. The method of any of claims 12 to 14, wherein at least one of the functional elements identified in the first subset describes a central control of the digital circuit.

16. The method of any of claims 12 to 15, wherein at least one of the functional elements identified in the second subset describes at least one of the group consisting of inputs, outputs, internal signals, registers and visible registers.

17. The method of any of claims 12 to 16, wherein at least one of the functional elements identified in the second subset describes a data path.

18. The method of any of claims 12 to 17, wherein the analysis of the completeness of the modified arrangement comprises determining whether the arrangement forms a model of the digital circuit.

19. The method of any of claims 12 to 18, wherein the analysis of the completeness of the modified arrangement comprises determining whether the modified arrangement or the set of operations determines a unique value of each output.

20. A method for verifying a digital circuit, the method comprising:
- providing a description of the digital circuit describing functionalities of the digital circuit;
- identifying an aspect of the digital circuit as a set of operations and their timely relation in said description(for performing a core portion of the functionalities);
- verifying the aspect according to the method of any of claims 1 to 17.

21. The method of claim 19, further comprising:
- determining a further set of operations;
- describing the further set of operations in terms of extended properties;
- formally verifying the extended properties;
- modifying the arrangement by adding the set of further operations to the arrangement with temporal relations satisfying at least said extended description;
- analysing completeness of the modified arrangement to determine whether the digital circuit is completely verified.

## Patentansprüche

1. Verfahren zur Verifikation zumindest eines Gesichtspunktes einer digitalen Schaltung, wobei das Verfahren umfasst:
- Bereitstellen eines Satzes von von der digitalen Schaltung auszuführenden Befehlen, wobei jeder des Satzes an Befehlen sich auf die Funktionalität von zumindest einem Gesichtspunkt oder Aspekt der digitalen Schaltung bezieht, und wobei jeder des Satzes an Befehlen zumindest ein funktionales Element umfasst;
- Identifizieren einer ersten Untergruppe an funktionalen Elementen unter den funktionalen Elementen des Satzes oder der Gruppe an Befehlen;
- Beschreiben, in einer Beschreibung, der funktionalen Elemente, die in der ersten Untergruppe identifiziert sind mit Eigenschaften, wobei jede der Eigenschaften einen Annahmeteil und einen Beweisteil enthält;
- formales Verifizieren von jeder der Eigenschaften;
- Anordnen der Vielzahl an funktionalen Elementen, identifiziert in der ersten Untergruppe als bewiesen für die digitale Schaltung in einer Anordnung mit zeitlichen Beziehungen, die zumindest die Beschreibung erfüllen bzw. dieser genügen;
- Analysieren der Vollständigkeit der Anordnung der funktionalen Elemente, identifiziert in der ersten Untergruppe zum Verifizieren, dass der zumindest eine Aspekt oder Gesichtspunkt der digitalen Schaltung vollständig verifiziert ist.

2. Verfahren nach Anspruch 1, bei welchem zumindest eines der funktionalen Elemente, identifiziert in der ersten Untergruppe, eine Steuerung der digitalen Schaltung beschreibt.

3. Verfahren nach Anspruch 1 oder 2, bei welchem zumindest eines der funktionalen Elemente, identifiziert in der ersten Untergruppe, eine Hauptsteuerung der digitalen Schaltung beschreibt.

4. Verfahren nach einem der vorangegangenen Ansprüche, bei welchem zumindest eines der funktionalen Elemente, identifiziert in der ersten Untergruppe, zumindest eines unter der Gruppe beschreibt, gebildet aus Eingaben bzw. Eingängen, Ausgaben bzw. Ausgängen, internen Signalen, Registern und sichtbaren Registern.

5. Verfahren nach einem der vorangegangen Ansprüchen, bei welchem zumindest eines der funktionalen Elemente, identifiziert in der ersten Untergruppe, einen Datenpfad beschreibt.

6. Verfahren nach einem der vorangegangenen Ansprüche, bei welchem die Analyse der Vollständigkeit bzw. die Vollständigkeitsanalyse der Anordnung das Bestimmen umfasst, ob die Anordnung ein Modell der digitalen Schaltung bildet.

7. Verfahren nach einem der vorangegangenen Ansprüche, bei welchem der Satz an Befehlen ferner eine temporale oder zeitliche Beziehung von zumindest zweien des Satzes an Befehlen beschreibt, und wobei zumindest eine der Eigenschaften die zeitliche oder temporale Beziehung beschreibt der zumindest zweien des Satzes an Befehlen.

8. Verfahren nach einem der vorangegangenen Ansprüche, bei welchem zumindest einer des Satzes an Befehlen und zumindest eine der Eigenschaften nachgewiesen sind bzw. nachweislich genügen.

9. Verfahren nach einem der vorangegangenen Ansprüche, bei welchem zumindest eines der funktionalen Elemente, identifiziert in der ersten Untergruppe, eine zeitliche oder temporale Beziehung beschreibt von zumindest zwei funktionalen Elementen der identifizierten ersten Untergruppe bzw. des identifizierten ersten Untersatzes.

10. Verfahren nach einem der vorangegangenen Ansprüche, bei welchem die Analyse der Vollständigkeit bzw. die Vollständigkeits- oder Completeness-Analyse das Bestimmen umfasst, ob die Anordnung oder die Eigenschaft einen einzigartigen Wert von jedem Ausgang bzw. von jeder Ausgabe für jede Eingabestimulierung bzw. für jeden Eingangsstimulus, eine Sequenz von Eigenschaften initiierend, definiert.

11. Verfahren nach einem der vorangegangenen Ansprüche, ferner umfassend das Bestimmen der Vollständigkeit der Eigenschaften durch Bestimmen, ob die zeitliche oder temporale Anordnung der Eigenschaften der temporalen oder zeitlichen Beziehung einer Vielzahl der Sätze oder Gruppen an Beziehungen entspricht.

12. Verfahren nach einem der vorangegangenen Ansprüche, ferner umfassend, nachfolgend zu der Vollständigkeitsanalyse der Anordnung:
- Identifizieren einer zweiten Untergruppe an funktionalen Elementen unter den funktionalen Elementen des Satzes an Befehlen;
- Modifizieren der Eigenschaften, basierend auf der zweiten Untergruppe an funktionalen Elementen;
- Formales Verifizieren jeder der modifizierten Eigenschaften;
- Modifizieren der Anordnung, basierend auf der zweiten Untergruppe an funktionalen Elementen;
- Analysieren der Vollständigkeit oder Vollständigkeitsanalyse der modifizierten Anordnung zum Verifizieren, dass weitere Gesichtspunkte oder Aspekte der digitalen Schaltung vollständig verifiziert sind.

13. Verfahren nach Anspruch 12, bei welchem zumindest eines der funktionellen Elemente, identifiziert in der zweiten Untergruppe, eine Steuerung der digitalen Schaltung beschreibt.

14. Verfahren nach Anspruch 12 oder 13, bei welchem zumindest eines der funktionalen Elemente, identifiziert in der zweiten Untergruppe, eine zentrale oder Hauptsteuerung der digitalen Schaltung beschreibt.

15. Verfahren nach einem der Ansprüche 12 bis 14, bei welchem zumindest eines der funktionalen Elemente, identifiziert in der ersten Untergruppe, eine zentrale oder Hauptsteuerung der digitalen Schaltung beschreibt.

16. Verfahren nach einem der Ansprüche 12 bis 15, bei welchem zumindest eines der funktionalen Elemente, identifiziert in der zweiten Untergruppe, zumindest eines beschreibt unter der Gruppe, gebildet aus Eingaben oder Eingängen, Ausgaben oder Ausgängen, internen Signalen, Registern und sichtbaren Registern.

17. Verfahren nach einem der Ansprüche 12 bis 16, bei welchem zumindest eines der funktionalen Elemente, identifiziert in der zweiten Untergruppe, einen Datenpfad beschreibt.

18. Verfahren nach einem der Ansprüche 12 bis 17, bei welchem die Analyse der Vollständigkeit oder die Vollständigkeitsanalyse der modifizierten Anordnung das Bestimmen umfasst, ob die Anordnung ein Modell der digitalen Schaltung bildet.

19. Verfahren nach einem der Ansprüche 12 bis 18, bei welchem die Vollständigkeitsanalyse der modifizierten Anordnung die Bestimmung umfasst, ob die modifizierte Anordnung oder der Satz an Befehlen einen einzigartigen Wert für jede Ausgabe bzw. für jeden Ausgang bestimmt.

20. Verfahren zum Verifizieren einer digitalen Schaltung, wobei das Verfahren umfasst:
- Bereitstellen einer Beschreibung der digitalen Schaltung, die die Funktionalitäten der digitalen Schaltung beschreibt;
- Identifizieren eines Aspektes oder Gesichtspunkts der digitalen Schaltung als einen Satz von Befehlen und deren zeitliche Beziehung in der Beschreibung (zum Durchführen eines Kernabschnittes der Funktionalitäten);
- Verifizieren des Aspektes oder Gesichtspunktes gemäß dem Verfahren nach einem der Ansprüche 1 bis 17.

21. Verfahren nach Anspruch 19, ferner umfassend:
- Bestimmen eines weiteren Satzes an Befehlen;
- Beschreiben des weiteren Satzes an Befehlen angesichts erweiterter Eigenschaften;
- Formales Verifizieren der erweiterten Eigenschaften;
- Modifizieren der Anordnung durch zusätzliches Bereitstellen oder Hinzufügen des Satzes von weiteren Eigenschaften bezüglich der Anordnung mit zeitlichen oder temporalen Beziehungen, die zumindest der erweiterten Beschreibung genügen;
- Analysieren der Vollständigkeit oder Vollständigkeitsanalyse der modifizierten Anordnung, um zu bestimmen, ob die digitale Schaltung vollständig verifiziert ist.

## Revendications

1. Procédé de vérification d'au moins un aspect d'un circuit numérique, le procédé comprenant :
la fourniture d'un ensemble d'opérations qui doivent être réalisées par le circuit numérique, chacune de l'ensemble d'opérations ayant trait à la fonctionnalité dudit au moins un aspect du circuit numérique, et chacune de l'ensemble d'opérations comprenant au moins un élément fonctionnel ;
l'identification d'un premier sous-ensemble d'éléments fonctionnels parmi les éléments fonctionnels de l'ensemble d'opérations ;
la description, dans une description, des éléments fonctionnels identifiés dans le premier sous-ensemble en terme de propriétés, chacune des propriétés ayant une composante de presomption et une composante de justification ;
la vérification formelle de chacune des propriétés ;
l'agencement de la pluralité d'éléments fonctionnels identifiés dans le premier sous-ensemble en tant que prouvé ou justifié pour le circuit numérique en un agencement avec des relations temporelles satisfaisant au moins ladite description ;
l'analyse de l'exhaustivité de l'agencement des éléments fonctionnels identifiés dans le premier sous-ensemble, pour vérifier que ledit au moins un aspect du circuit numérique a été complètement vérifié.

2. Procédé selon la revendication 1, dans lequel au moins un des éléments fonctionnels identifié dans le premier sous-ensemble décrit une commande du circuit numérique.

3. Procédé selon la revendication 1 ou 2, dans lequel au moins un des éléments fonctionnels identifiés dans le premier sous-ensemble décrit une commande centrale du circuit numérique.

4. Procédé selon l'une quelconque des revendications précédentes, dans lequel au moins un des éléments fonctionnels identifiés dans le premiers sous-ensemble décrit au moins un élément du groupe constitué par les entrées, les sorties, les signaux internes, les registres, et les registres visibles.

5. Procédé selon l'une quelconque des revendications précédentes, dans lequel au moins un des éléments fonctionnels identifiés dans le premier sous-ensemble décrit un chemin de données.

6. Procédé selon l'une quelconque des revendications précédentes, dans lequel l'analyse de l'exhaustivité de l'agencement comprend l'étape consistant à déterminer si l'agencement forme un modèle du circuit numérique.

7. Procédé selon l'une quelconque des revendications précédentes, dans lequel l'ensemble d'opérations décrit, en outre, une relation temporelle d'au moins deux opérations de l'ensemble d'opérations, et dans lequel au moins une des propriétés décrit la relation temporelle desdites au moins deux opérations de l'ensemble d'opérations.

8. Procédé selon l'une quelconque des revendications précédentes, dans lequel au moins une de l'ensemble d'opérations et au moins une des propriétés sont montrées comme étant satisfaites.

9. Procédé selon l'une quelconque des revendications précédentes, dans lequel au moins un des éléments fonctionnels identifiés dans le premier sous-ensemble décrit une relation temporelle d'au moins deux éléments fonctionnels du premier sous-ensemble identifié.

10. Procédé selon l'une quelconque des revendications précédentes, dans lequel l'analyse de l'exhaustivité de l'agencement comprend l'étape consistant à déterminer si l'agencement ou les propriétés déterminent une valeur unique de chaque sortie pour chaque stimulus d'entrée qui initie une séquence de propriétés.

11. Procédé selon l'une quelconque des revendications précédentes, comprenant, en outre, la détermination de l'exhaustivité des propriétés, en déterminant si l'agencement temporel des propriétés correspond à la relation temporelle d'une pluralité de l'ensemble d'opérations.

12. Procédé selon l'une quelconque des revendications précédentes, comprenant, en outre, après l'analyse de l'exhaustivité de l'agencement :
l'identification d'un deuxième sous-ensemble d'éléments fonctionnels parmi les éléments fonctionnels de l'ensemble d'opérations ;
la modification des propriétés sur la base du deuxième sous-ensemble d'éléments fonctionnels ;
la vérification formelle de chacune des propriétés modifiées ;
la modification de l'agencement sur la base du deuxième sous-ensemble des éléments fonctionnels ;
l'analyse de l'exhaustivité de l'agencement modifié, pour vérifier que d'autres aspects du circuit numérique sont complètement vérifiés.

13. Procédé selon la revendication 12, dans lequel au moins un des éléments fonctionnels identifiés dans le deuxième sous-ensemble décrit une commande du circuit numérique.

14. Procédé selon la revendication 12 ou 13, dans lequel au moins un des éléments fonctionnels identifiés dans le deuxième sous-ensemble décrit une commande centrale du circuit numérique.

15. Procédé selon l'une quelconque des revendications 12 à 14, dans lequel au moins un des éléments fonctionnels identifiés dans le premier sous-ensemble décrit une commande centrale du circuit numérique.

16. Procédé selon l'une quelconque des revendications 12 à 15, dans lequel au moins un des éléments fonctionnels identifiés dans le deuxième sous-ensemble décrit au moins un élément du groupe constitué par les entrées, les sorties, les signaux internes, les registres, et les registres visibles.

17. Procédé selon l'une quelconque des revendications 12 à 16, dans lequel au moins un des éléments fonctionnels identifiés dans le deuxième sous-ensemble décrit un chemin de données.

18. Procédé selon l'une quelconque des revendications 12 à 16, dans lequel l'analyse de l'exhaustivité de l'agencement modifié comprend l'étape consistant à déterminer si l'agencement forme un modèle du circuit numérique.

19. Procédé selon l'une quelconque des revendications 12 à 18, dans lequel l'analyse de l'exhaustivité de l'agencement modifié comprend l'étape consistant à déterminer si l'agencement modifié ou l'ensemble d'opérations détermine une valeur unique de chaque sortie.

20. Procédé de vérification d'un circuit numérique, le procédé comprenant :
la fourniture d'une description du circuit numérique décrivant des fonctionnalités du circuit numérique ;
l'identification d'un aspect du circuit numérique en tant qu'ensemble d'opérations et
leur relation de temps dans ladite description (pour réaliser une partie noyau des fonctionnalités) ;
la vérification de l'aspect selon le procédé de l'une quelconque des revendications 1 à 17.

21. Procédé selon la revendication 19, comprenant, en outre :
la détermination d'un ensemble additionnel d'opérations ;
la description de l'ensemble additionnel d'opérations en terme de propriétés étendues ;
la vérification formelle des propriétés étendues ;
la modification de l'agencement, par l'ajout de l'ensemble d'opérations additionnelles à l'agencement, avec des relations temporelles satisfaisant au moins ladite description étendue ;
l'analyse de l'exhaustivité de l'agencement modifié, pour déterminer si le circuit numérique est complètement vérifié.
